# EUROPEAN PATENT APPLICATION

(11) **EP 4 831 698 A1**
(43) Date of publication of application: **28.10.2026**
(21) Application number: 26173027.9
(22) Date of filing: 17.04.2026
(51) Int. Cl.: G02B 1/14, C08L 33/00, C08L 63/00, G03F 7/00, G03F 7/038, H10K 59/80

(54) **COMPOSITION, PROTECTIVE LAYER AND DISPLAY DEVICE**

(30) Priority: 23.04.2025 KR 20250053227; 03.04.2026 KR 20260060988
(71) Applicant: Duk San Neolux Co., Ltd., Chungcheongnam-do 31027 (KR)
(72) Inventor: KIM, Kyung Soo, 31027 Chungcheongnam-do (KR); HAM, Young Jun, 31027 Chungcheongnam-do (KR); BAE, Jun, 31027 Chungcheongnam-do (KR); KWON, Ju Cheol, 31027 Chungcheongnam-do (KR); SON, Hyo Jung, 31027 Chungcheongnam-do (KR); KIM, Do Eon, 31027 Chungcheongnam-do (KR)
(74) Representative: Bryn Aarflot AS

(57) **Abstract**

Embodiments of the present disclosure may provide a composition comprising a colorant, a first monomer comprising an acrylate group, a second monomer comprising an oxygen-containing cyclic group, and a third monomer comprising an oxygen-containing cyclic group. Accordingly, embodiments of the present disclosure may provide a composition capable of preventing physical damage and defects of a display device and securing long-term stability and reliability by improving adhesive strength and strengthening durability against external impact and scratches, and a protective layer and a display device comprising the same.

## Description

### CROSS-REFERENCE TO RELATED APPLICATIONS

This application claims the benefit of priority to Republic of Korea Patent Application No. 10-2025-0053227, filed on April 23, 2025, and Republic of Korea Patent Application No. 10-2026-0060988, filed on April 3, 2026, which are hereby incorporated by reference for all purposes as if fully set forth herein.

### TECHNICAL FIELD

Embodiments of the present disclosure relate to a composition, a protective layer, and a display device.

### RELATED ART

A display device incorporates various advanced technologies providing high resolution and precise color expression, and has evolved into various forms such as an organic light emitting display (OLED) and a liquid crystal display (LCD). Such a display device is susceptible to damage by external environmental factors, so the need for a protective layer is increasingly recognized. Physical factors such as dust, moisture, and scratches may cause performance degradation of the display device, so a protective layer for preventing this may be required.

A protective layer of a display device may serve to prevent damage that may occur during a manufacturing process of the display device, maintain structural stability, and provide durability against external force.

### SUMMARY

Embodiments of the present disclosure may provide a composition capable of preventing damage and defects that may occur during manufacturing and use of a display device and effectively protecting the display device from external factors.

Embodiments of the present disclosure may provide a composition having improved durability and reliability and capable of maintaining stable characteristics even under high-temperature conditions.

Embodiments of the present disclosure may provide a protective layer and a display device comprising a composition capable of effectively protecting the display device from physical damage and external factors that may occur during manufacturing and use processes of the display device.

Embodiments of the present disclosure may provide a protective layer comprising a composition having high adhesive strength and high hardness, having high bonding strength with a display panel, and having durability against external impact and scratches.

Objects of embodiments of the present disclosure are not limited to the problems mentioned above, and other objects not mentioned will be clearly understood by those skilled in the art from the following description.

A composition according to embodiments of the present disclosure may comprise a colorant, a first monomer comprising an acrylate group, a second monomer comprising an oxygen-containing cyclic group, and a third monomer comprising an oxygen-containing cyclic group.

The first monomer comprising an acrylate group may be a compound represented by Formula 1 below.

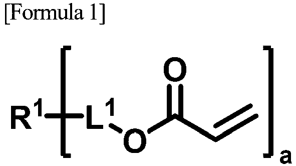

The second monomer comprising an oxygen-containing cyclic group may be a compound represented by Formula 2 below. The second monomer may comprise an epoxy group.

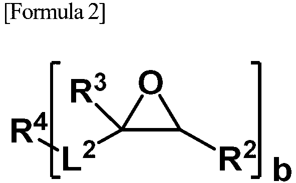

The third monomer comprising an oxygen-containing cyclic group may be a compound represented by Formula 3 below. The third monomer may comprise an oxetane group.

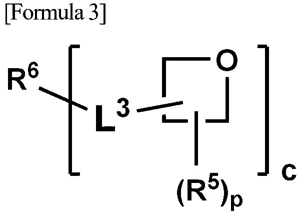

According to embodiments of the present disclosure, a protective layer may comprise a composition comprising a colorant, a first monomer, a second monomer, and a third monomer.

According to embodiments of the present disclosure, a display device may comprise a substrate on which a pixel array layer is disposed, and a protective layer disposed under the substrate.

According to embodiments of the present disclosure, a composition capable of preventing damage and defects that may occur during manufacturing and use of a display device and effectively protecting the display device from external factors may be provided.

According to embodiments of the present disclosure, a composition having improved durability and reliability and capable of maintaining stable characteristics even under high-temperature conditions, may be provided.

According to embodiments of the present disclosure, a protective layer and a display device comprising a composition capable of effectively protecting the display device from physical damage and external factors that may occur during manufacturing and use processes of the display device may be provided.

According to embodiments of the present disclosure, a protective layer comprising a composition having high adhesive strength and high hardness, having high bonding strength with a display panel and having durability against external impact and scratches, may be provided.

According to embodiments of the present disclosure, an eco-friendly display device capable of low-power driving by improving performance and lifespan of the display device may be provided.

According to embodiments of the present disclosure, an eco-friendly protective layer composition suitable for manufacturing a large-area display device and capable of optimizing a process by reducing energy consumption and improving production efficiency may be provided.

Effects of the embodiments of the present disclosure are not limited to the effects described above, and other effects not mentioned will be clearly understood by those skilled in the art from the description below.

### BRIEF DESCRIPTION OF THE DRAWINGS

The present disclosure will be more fully understood from the detailed description provided below and the accompanying drawings, and the detailed description and the accompanying drawings are provided for explanation only and do not limit the scope of the present disclosure.
FIG. 1 is an exemplary cross-sectional view schematically illustrating a display device according to embodiments of the present disclosure.
FIG. 2 is an exemplary cross-sectional view illustrating an enlarged cross-section of region A shown in FIG. 1.
FIGS. 3A and 3B are exemplary views illustrating optical paths in a display device according to embodiments of the present disclosure and a display device according to a comparative example.
FIGS. 4A to 4D are exemplary process diagrams schematically illustrating manufacturing steps of a display device according to embodiments of the present disclosure.

### DETAILED DESCRIPTION

Hereinafter, various embodiments of the present disclosure will be described in detail with reference to the accompanying drawings.

In the following description of the present disclosure, a detailed description of known functions and configurations incorporated herein will be omitted in the case in which the subject matter of the present disclosure may be rendered unclear thereby. It will be understood that the terms "comprise", "have", "consist of", and any variations thereof used herein are intended to cover non-exclusive inclusions unless explicitly stated to the contrary. Descriptions of elements in the singular form used herein are intended to include descriptions of elements in the plural form, unless explicitly stated to the contrary.

In addition, terms, such as first, second, A, B, (a), or (b), may be used herein when describing elements of the present disclosure. Each of these terms is not used to define an essence, order, or sequence of a corresponding element but used merely to distinguish the corresponding element from other elements.

It will be understood that when an element is referred to as being "connected", "coupled", or "joined" to another element, not only can it be "directly connected, coupled, or joined" to the other element, but it can also be "indirectly connected, coupled, or joined" to the other element via an "intervening" element. Here, the intervening element may be included in one or more of the two elements "connected", "coupled", or "joined" to each other.

In addition, it will be understood that when an element, such as a layer, a film, a region, or a plate, is referred to as being "above" or "on" another element, not only can it be "directly" above or on the other element, but it can also be "indirectly" above or on the other element or layer via an "intervening" element. In contrast, when an element is referred to as being "directly" above or on another element, it will be understood that no intervening element is interposed.

When time-relative terms, such as "after", "subsequent to", "next", "before", and the like, are used to describe elements, operating or manufacturing methods, and the like, these terms may be used to describe non-consecutive or non-sequential processes or operations unless the term "directly" or "immediately" is used in conjunction.

In addition, when any numerical values for elements or corresponding information are mentioned, it should be considered that numerical values for elements or corresponding information include a tolerance or error range that may be caused by various factors (e.g., process factors, internal or external impact, noise, etc.) even when a relevant description is not specified.

The terms used in the present disclosure and the appended claims are as follows, unless otherwise specified, within the scope not departing from the spirit of the present disclosure.

The terms "halo" or "halogen" as used in the present disclosure comprise fluorine (F), chlorine (Cl), bromine (Br), and iodine (I), unless otherwise specified.

The terms "alkyl" or "alkyl group" as used in the present disclosure, unless otherwise specified, refer to a radical of a saturated aliphatic functional group having 1 to 60 carbons connected by a single bond, comprising a straight-chain alkyl group, a branched-chain alkyl group, a cycloalkyl (alicyclic) group, an alkyl-substituted cycloalkyl group, and a cycloalkylsubstituted alkyl group.

The terms "haloalkyl group" or "halogenalkyl group" as used in the present disclosure, unless otherwise specified, refer to an alkyl group substituted with a halogen.

The terms "alkenyl" or "alkynyl" as used in the present disclosure, unless otherwise specified, each have a double bond or a triple bond, comprise a straight-chain or branched-chain group, and may have 2 to 60 carbon atoms, but are not limited thereto.

The term "cycloalkyl" as used in the present disclosure, unless otherwise specified, refers to an alkyl forming a ring having 3 to 60 carbon atoms, but is not limited thereto.

The terms "alkoxy group" or "alkyloxy group" as used in the present disclosure refer to an alkyl group bonded to an oxygen radical, and unless otherwise specified, have 1 to 60 carbon atoms, but are not limited thereto.

The terms "alkenoxyl group," "alkenoxy group," "alkenyloxyl group," or "alkenyloxy group" as used in the present disclosure refer to an alkenyl group attached to an oxygen radical, and unless otherwise specified, have 2 to 60 carbon atoms, but are not limited thereto.

The terms "aryl group" and "arylene group" as used herein each comprise 6 to 60 carbon atoms, unless otherwise specified, but are not limited thereto. In the present disclosure, an aryl group or an arylene group comprises a monocyclic type, a ring assembly, a fused polycyclic compound, and the like. For example, an aryl group may comprise a phenyl group, a monovalent functional group of biphenyl, a monovalent functional group of naphthalene, a fluorenyl group, and a substituted fluorenyl group, and an arylene group may comprise a fluorenylene group and a substituted fluorenylene group.

The term "ring assemblies" as used herein refers to a structure in which two or more ring systems (monocyclic or fused ring systems) are directly connected to each other via a single bond or a double bond, and the number of such direct connections between the rings is one less than the total number of ring systems present in the compound. A ring assembly may comprise identical or different ring systems directly connected to each other via a single bond or a double bond.

In the present disclosure, since an aryl group comprises a ring assembly, the aryl group comprises biphenyl and terphenyl, in which a benzene ring, which is a single aromatic ring, is connected by a single bond. Further, the aryl group also comprises a compound in which an aromatic monocyclic ring and a fused aromatic ring system are connected by a single bond. For example, the aryl group also comprises a compound in which fluorene, which is a fused aromatic ring system, and a benzene ring, which is an aromatic monocyclic ring, are connected by a single bond.

The term "fused polycyclic system" as used herein refers to a fused ring form sharing at least two atoms, and comprises a form in which two or more hydrocarbon ring systems are fused and a form in which at least one heterocyclic system comprising at least one heteroatom is fused. Such a fused polycyclic system may be an aromatic ring, a heteroaromatic ring, an aliphatic ring, or a combination of these rings. For example, in the case of an aryl group, it may be a naphthalenyl group, a phenanthrenyl group, a fluorenyl group, or the like, but is not limited thereto.

The term "spiro compound" as used herein comprises a 'spiro union', wherein a spiro union refers to a connection formed by two rings sharing only one atom. In this case, the atom shared by the two rings is referred to as a 'spiro atom', and depending on the number of spiro atoms present in a compound, these are referred to as 'monospiro-', 'dispiro-', and 'trispiro-' compounds, respectively.

The terms "fluorenyl group", "fluorenylene group", and "fluorenyltriyl group" as used herein each refer to a monovalent, divalent, or trivalent functional group in which R¹, R², R³, and R⁴ are all hydrogen in the following structure, unless otherwise specified. A "substituted fluorenyl group", a "substituted fluorenylene group", or a "substituted fluorenyltriyl group" refers to a case where at least one of the substituents R¹, R², R³, and R⁴ is a substituent other than hydrogen, and also comprises a case where R¹ and R² are bonded to each other to form a spiro compound together with the carbon atom to which they are bonded. In the present disclosure, the fluorenyl group, the fluorenylene group, and the fluorenyltriyl group may all be referred to as a fluorene group, regardless of their valency, such as monovalent, divalent, or trivalent.

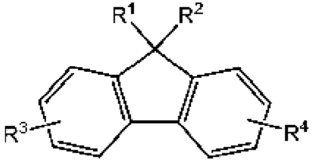

Further, R¹, R², R³, and R⁴ may each independently be an alkyl group comprising 1 to 20 carbon atoms, an alkenyl group comprising 1 to 20 carbon atoms, an aryl group comprising 6 to 30 carbon atoms, or a heterocyclic group comprising 2 to 30 carbon atoms. For example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, the substituted fluorenyl group and the fluorenylene group may each be a monovalent functional group or a divalent functional group of 9,9-dimethylfluorene, 9,9-diphenylfluorene, and 9,9'-spirobi[9H-fluorene].

The term "heterocyclic group" as used herein comprises not only aromatic rings such as a "heteroaryl group" or a "heteroarylene group" but also non-aromatic rings, and unless otherwise specified, each refers to a ring comprising 2 to 60 carbon atoms and at least one heteroatom, but is not limited thereto. The term "heteroatom" as used herein represents oxygen (O), nitrogen (N), sulfur (S), silicon (Si), or phosphorus (P), unless otherwise specified, and a heterocyclic group refers to a monocyclic type, a ring assembly, a fused polycyclic system, a spiro compound, and the like, comprising a heteroatom.

For example, a "heterocyclic group" may also comprise a compound comprising a heteroatomic group such as SO₂, P=O, or the like, instead of a carbon atom forming a ring, as in the following compound.

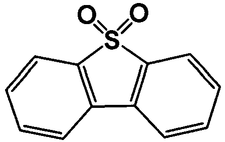

The terms "ring" and "ring group" as used herein each comprise a monocyclic ring and a polycyclic ring, and comprise a hydrocarbon ring as well as a heterocyclic ring comprising at least one heteroatom, and comprise an aromatic ring and a non-aromatic ring.

The term "polycyclic ring" as used herein comprises ring assemblies such as biphenyl, terphenyl, and the like, fused polycyclic systems, and spiro compounds, and comprises not only aromatic but also non-aromatic rings, and comprises a hydrocarbon ring as well as a heterocyclic ring comprising at least one heteroatom.

The term "aliphatic ring group" as used herein refers to a cyclic hydrocarbon excluding an aromatic hydrocarbon, and comprises a monocyclic type, a ring assembly, a fused polycyclic system, a spiro compound, and the like, and unless otherwise specified, refers to a ring comprising 3 to 60 carbon atoms, but is not limited thereto. For example, even in a case where benzene, which is an aromatic ring, and cyclohexane, which is a non-aromatic ring, are fused, it corresponds to an aliphatic ring.

Further, when prefixes are named consecutively, it means that substituents are listed in the order in which they are first described. For example, an arylalkoxy group refers to an alkoxy group substituted with an aryl group, an alkoxycarbonyl group refers to a carbonyl group substituted with an alkoxy group, and an arylcarbonylalkenyl group refers to an alkenyl group substituted with an arylcarbonyl group, wherein the arylcarbonyl group is a carbonyl group substituted with an aryl group.

In the term "substituted or unsubstituted" as used in the present disclosure, "substituted" means being substituted with one or more substituents selected from the group consisting of deuterium, a halogen group, a hydroxy group (-OH), a nitrile group (-CN), a nitro group (-NO₂), a carbonyl group (-C(=O)-), an ether group (-O-), an ester group (-C(=O)O-), a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group comprising at least one heteroatom selected from the group consisting of oxygen (O), nitrogen (N), sulfur (S), silicon (Si), and phosphorus (P), but is not limited to these substituents.

The term "substituted" used in the present disclosure may comprise a case of being continuously substituted with one or more substituents selected from the above-described substituents. For example, a substituted substituent may be further substituted with one or more substituents selected from the above-described substituents, and may comprise a case where the further substituted substituent is further substituted with one or more substituents selected from the above-described substituents.

In the present disclosure, a 'functional group name' corresponding to an aryl group, an arylene group, a heterocyclic group, and the like, exemplified by each symbol and its substituent, may be described as 'a functional group name reflecting valency' or may be described as 'a parent compound name'. For example, in the case of 'phenanthrene', which is a type of aryl group, a monovalent 'group' may be referred to as 'phenanthryl (group)', and a divalent group may be referred to as 'phenanthrylene (group)' or the like, distinguishing the valency of the group, but it may also be referred to as 'phenanthrene (group)', which is the parent compound name, regardless of the valency.

Similarly, in the case of pyrimidine, it may be described as 'pyrimidine' regardless of valency, or as pyrimidinyl (group) in the case of a monovalent group, or as pyrimidinylene (group) or the like, as the 'name of the group' corresponding to its valency, in the case of a divalent group. Therefore, when the type of a substituent is described by a parent compound name in the present disclosure, it may refer to an n-valent 'group' formed by the detachment of a hydrogen atom bonded to a carbon atom and/or a heteroatom of the parent compound.

Further, in the present disclosure, in describing a compound name or a substituent name, numbers or letters indicating positions may be omitted. For example, pyrido[4,3-d]pyrimidine may be described as pyridopyrimidine, benzofuro[2,3-d]pyrimidine as benzofuropyrimidine, and 9,9-dimethyl-9H-fluorene as dimethylfluorene, and the like. Accordingly, both benzo[g]quinoxaline and benzo[f]quinoxaline may be described as benzoquinoxaline.

Further, unless explicitly specified otherwise, a chemical formula used in the present disclosure is applied identically to a substituent definition by an index definition of the following chemical formula.

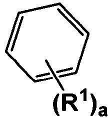

Herein, when 'a' is an integer of 0, it means that a substituent R¹ is absent, that is, when 'a' is 0, it means that all carbon atoms forming a benzene ring are bonded to hydrogen atoms, and in this case, the indication of hydrogen atoms bonded to the carbon atoms may be omitted when describing a chemical formula or a compound. Further, when 'a' is an integer of 1, one substituent R¹ is bonded to any one of the carbon atoms forming the benzene ring, and when 'a' is an integer of 2 or 3, it may be bonded, for example, as shown below, and when 'a' is an integer of 4 to 6, it is bonded to the carbon atoms of the benzene ring in a similar manner, and when 'a' is an integer of 2 or more, the R¹ groups may be the same or different from each other.

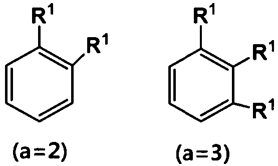

Unless otherwise specified in the present disclosure, forming a ring means that adjacent groups are bonded to each other to form a single ring or multiple fused rings, and the single ring and the formed multiple fused rings comprise a hydrocarbon ring as well as a heterocyclic ring comprising at least one heteroatom, and may comprise an aromatic ring and a non-aromatic ring.

Further, unless otherwise specified in the present disclosure, when indicating a fused ring, the number in 'N-fused ring' indicates the number of rings being fused. For example, a form in which three rings are fused to each other, such as anthracene, phenanthrene, or benzoquinazoline, may be denoted as a 3-fused ring.

Meanwhile, the term "bridged bicyclic compound" as used in the present disclosure, unless otherwise specified, refers to a compound in which two rings share three or more atoms to form a ring. In this case, the shared atoms may comprise a carbon atom or a heteroatom.

In the present disclosure, a display device may be implemented in various forms, and specifically, may comprise an organic light-emitting diode (OLED) display, a liquid crystal display (LCD), an electronic ink display, a micro-LED display, and a quantum dot (QD) display. Further, such a display device may be provided in various forms, such as a curved display, a flexible display, a foldable display, and a rollable display, in addition to a flat display. Furthermore, special purpose displays such as a small display for wearable devices, a head-up display (HUD) for vehicles, a head-mounted display (HMD) for augmented reality (AR) and virtual reality (VR), and a transparent display may also be included.

Further, the display device in the present disclosure may refer to a panel comprising the display devices described above, or may comprise a panel and a circuit. Herein, for example, it may comprise personal electronic devices such as a smartphone, a tablet, a laptop, and a desktop computer, and large display devices such as a television, a monitor, and digital signage may also be included. Further, vehicular display devices such as a head-up display (HUD) and an instrument panel display for automobiles, wearable devices (e.g., a smartwatch), head-mounted displays (HMDs) for virtual reality (VR) and augmented reality (AR) devices, and special purpose display devices such as medical monitors and industrial control panels may also be included.

Hereinafter, embodiments of the present disclosure will be described in detail. However, these are presented as examples, and the present disclosure is not limited thereby, but is defined only by the scope of the claims described later.

A composition according to embodiments of the present disclosure may be applied to a protective layer of a display device. For example, the protective layer may be provided below a substrate included in a display panel.

It is preferred that the protective layer maintain desired optical performance without degrading the optical performance of the display device, and satisfy various physical properties such as adhesion and hardness. Particularly, a material capable of maintaining stable properties even in a high-temperature environment is required.

A composition used for a protective layer of a display device may be designed to satisfy these requirements.

A composition according to embodiments of the present disclosure may comprise a colorant, a monomer comprising an acrylate group, and a monomer comprising an oxygen-containing cyclic group.

A composition according to embodiments of the present disclosure may comprise a colorant, a first monomer comprising an acrylate group, a second monomer comprising an oxygen-containing cyclic group, and a third monomer comprising an oxygen-containing cyclic group.

The second monomer may comprise an epoxy group, and the third monomer may comprise an oxetane group.

Hereinafter, each element will be described in detail.

### 1. Composition

A composition according to embodiments of the present disclosure may comprise a colorant, a first monomer comprising an acrylate group, a second monomer comprising an oxygen-containing cyclic group, and a third monomer comprising an oxygen-containing cyclic group.

A composition according to embodiments of the present disclosure may be included in a protective layer of a display device.

For example, the protective layer may be provided under a substrate included in a display panel. As another example, the protective layer may be included in the display panel.

The protective layer effectively protects the display panel and the display device from external impact, scratches, and environmental factors, and may contribute to increasing durability and reliability of the panel by simultaneously improving adhesive strength and hardness.

Compositions according to embodiments of the present disclosure may comprise the components described below.

### (1) Colorant

In embodiments of the present disclosure, the composition may comprise a colorant.

A black pigment may be used as the colorant.

Examples of the black pigment include lactam black, aniline black, perylene black, titanium black, carbon black, and the like.

The black pigment may also be used together with a color corrector such as an anthraquinone-based pigment, a perylene-based pigment, a phthalocyanine-based pigment, an azobased pigment, or the like.

In addition, the colorant in the composition according to embodiments may further comprise a dye. For example, the dye may comprise a phthalocyanine-based compound.

The pigment and the dye may be used alone or in a mixture of two or more, but are not limited thereto.

A dispersant may be used together to disperse the pigment in the composition. For example, the pigment may be surface-treated with the dispersant in advance, or the dispersant may be added together with the pigment during preparation of the composition.

As the dispersant, a non-ionic dispersant, an anionic dispersant, a cationic dispersant, or the like may be used. Specific examples of the dispersant include polyalkylene glycol and esters thereof, polyoxyalkylene, polyhydric alcohol ester alkylene oxide adducts, alcohol alkylene oxide adducts, sulfonic acid esters, sulfonates, carboxylic acid esters, carboxylates, alkylamide alkylene oxide adducts, alkylamines, and the like, and these may be used alone or in a mixture of two or more.

Examples of commercially available products of the dispersant include DISPERBYK-101, DISPERBYK-130, DISPERBYK-140, DISPERBYK-160, DISPERBYK-161, DISPERBYK-162, DISPERBYK-163, DISPERBYK-164, DISPERBYK-165, DISPERBYK166, DISPERBYK-170, DISPERBYK-171, DISPERBYK-182, DISPERBYK-2000, and DISPERBYK-2001 from BYK; EFKA-47, EFKA-47EA, EFKA-48, EFKA-49, EFKA-100, EFKA-400, and EFKA-450 from EFKA Chemical; Solsperse 5000, Solsperse 12000, Solsperse 13240, Solsperse 13940, Solsperse 17000, Solsperse 20000, Solsperse 24000GR, Solsperse 27000, and Solsperse 28000 from Zeneca; or PB711 and PB821 from Ajinomoto.

The dispersant may be included in an amount of 0.1 wt% to 15 wt% based on the total weight of the composition. When the dispersant is included within this range, stability, developability, and patternability of the composition may be improved during manufacture of a protective layer due to improved dispersibility.

The pigment may be pre-treated using a water-soluble inorganic salt and a wetting agent. When the pigment is pre-treated and used, the average particle diameter of the pigment may be refined.

The pre-treatment may be performed through a step of kneading the pigment with the water-soluble inorganic salt and the wetting agent, and a step of filtering and washing the pigment obtained in the kneading step with water.

The kneading may be performed at a temperature of 40 °C to 100 °C, and the filtering and washing with water may be performed by washing the inorganic salt with water or the like and then filtering.

Examples of the water-soluble inorganic salt include sodium chloride, potassium chloride, and the like, but are not limited thereto.

The wetting agent may serve as a medium in which the pigment and the water-soluble inorganic salt are uniformly mixed so that the pigment can be easily pulverized. Examples of the wetting agent include alkylene glycol monoalkyl ethers such as ethylene glycol monoethyl ether, propylene glycol monomethyl ether, and diethylene glycol monomethyl ether; alcohols such as ethanol, isopropanol, butanol, hexanol, cyclohexanol, ethylene glycol, diethylene glycol, polyethylene glycol, and glycerin polyethylene glycol; and the like, and these may be used alone or in a mixture of two or more.

The pigment that has undergone the kneading step may have an average particle diameter of 20 nm to 110 nm. When the average particle diameter of the pigment is within this range, a fine pattern can be effectively formed while heat resistance and light resistance are improved.

The pigment may be included in an amount of 1 to 40 wt%, more specifically 2 to 30 wt%, or 3 to 20 wt%, or 5 to 15 wt%, or 7 to 12 wt%, or 7 to 10 wt% based on the total weight of the composition. When the pigment is included within this range, color gamut may be improved, and curability and adhesion of a pattern may be improved.

### (2) First monomer

In embodiments of the present disclosure, the composition may comprise a first monomer comprising an acrylate group.

The first monomer may be a compound represented by Formula 1 below.

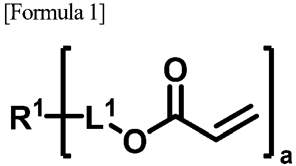

Variables described in Formula 1 may be defined as follows.

a may be an integer from 1 to 4.

R¹ may be selected from the group consisting of hydrogen; deuterium; a C₁-C₃₀ alkyl group; a C₂-C₃₀ alkenyl group; a C₂-C₃₀ alkynyl group; a C₃-C₃₀ cycloalkyl group; a C₁-C₃₀ ether group; a C₁-C₃₀ ketone group; a C₁-C₃₀ ester group; a C₁-C₃₀ alkoxy group; a C₆-C₃₀ aryl group; a C₂-C₃₀ heterocyclic group comprising at least one heteroatom selected from the group consisting of oxygen (O), nitrogen (N), sulfur (S), silicon (Si), and phosphorus (P); a C₆-C₃₀ aryloxy group; a hydroxy group; and combinations thereof.

L¹ may be selected from the group consisting of a single bond; a C₁-C₃₀ alkylene group; a C₂-C₃₀ alkenylene group; a C₂-C₃₀ alkynylene group; a C₃-C₃₀ cycloalkylene group; a C₁-C₃₀ ether group; a C₁-C₃₀ ketone group; a C₁-C₃₀ ester group; a C₁-C₃₀ alkoxylene group; a C₆-C₃₀ arylene group; a C₂-C₃₀ heterocyclic group comprising at least one heteroatom selected from the group consisting of O, N, S, Si, and P; a C₆-C₃₀ aryloxy group; and combinations thereof.

In R¹ and L¹, the alkyl group, the alkenyl group, the alkynyl group, the cycloalkyl group, the ether group, the ketone group, the ester group, the alkoxy group, the aryl group, the heterocyclic group, and the aryloxy group may each independently be further substituted with one or more substituents selected from the group consisting of deuterium, a halogen group, a hydroxy group, a nitrile group, a nitro group, a carbonyl group, an ether group, an ester group, a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group comprising at least one heteroatom selected from the group consisting of O, N, S, Si, and P.

The compound represented by Formula 1 may be one or more of the following compounds.

The first monomer may be at least one of compounds represented by Formulas P-1-1 to P-1-36 below.

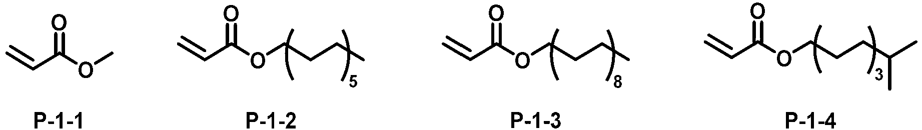

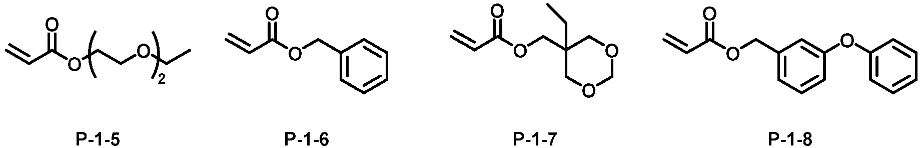

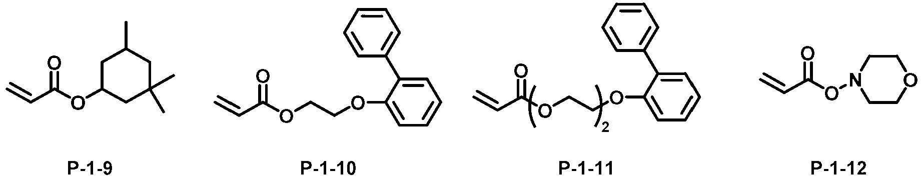

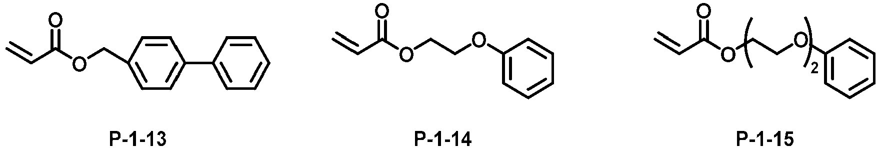

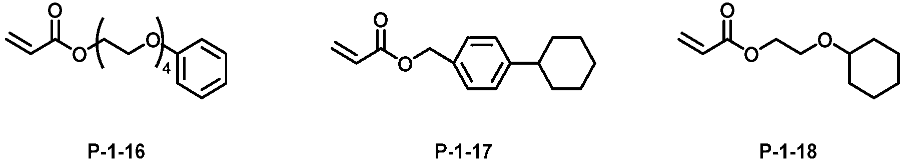

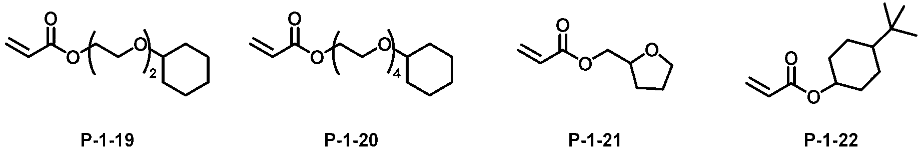

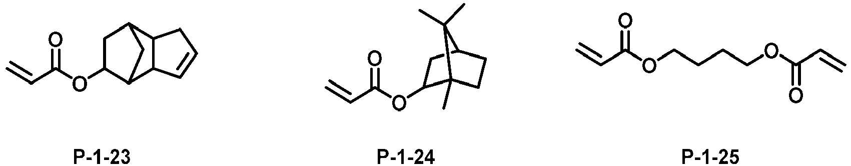

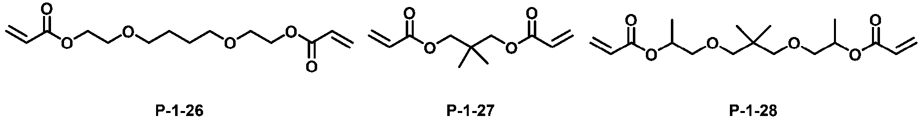

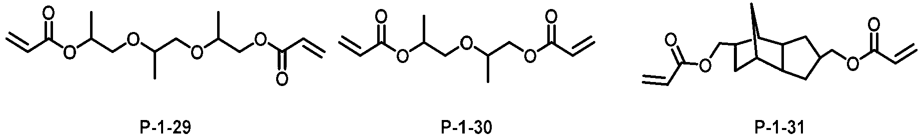

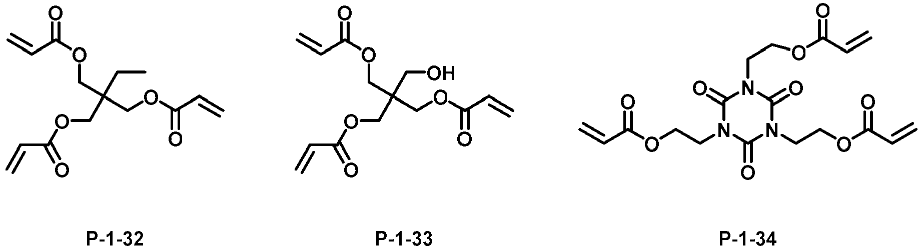

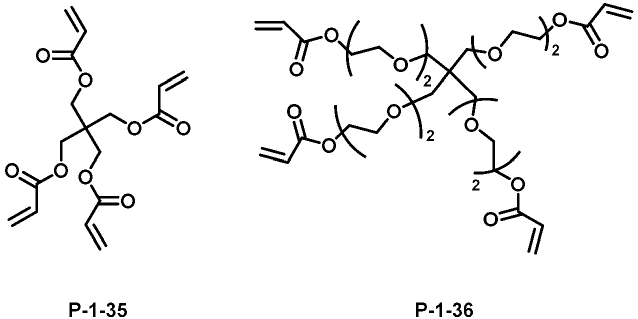

The first monomer may be included in an amount of 1 to 40 wt%, or 1 to 30 wt%, or 1 to 25 wt%, or 5 to 25 wt%, or 5 to 24.5 wt%, or 23 to 24 wt%, or 24 to 25 wt%, or 25 to 26 wt%, or 26 to 27 wt% based on the total weight of the composition.

When the composition includes the first monomer described above, the performance of a protective layer comprising the same may be improved.

For example, the composition comprising the first monomer described above may provide high bonding strength between a display panel and the protective layer.

For example, the composition comprising the first monomer may have increased flexibility due to the characteristics of the acrylate group and thus may be applied to a flexible display device.

For example, the composition comprising the first monomer may allow the protective layer to perform an effective protective function without affecting the image quality of the display device, owing to the optical transparency of the acrylate polymer.

In addition, the composition comprising the first monomer may maintain stable performance even in a high-temperature and high-humidity environment due to the heat resistance and moisture resistance of the acrylate polymer, thereby improving the lifespan and reliability of the display device.

### (3) Second monomer

In embodiments of the present disclosure, the composition may comprise a second monomer comprising an oxygen-containing cyclic group. The second monomer may comprise an epoxy group.

The second monomer may be a compound represented by Formula 2 below.

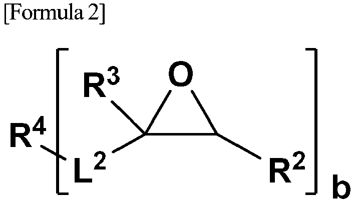

Variables described in Formula 2 may be defined as follows.

b may be an integer from 1 to 4.

R² and R³ may each independently be selected from the group consisting of hydrogen; deuterium; a C₁-C₃₀ carbonyl group; a C₁-C₃₀ ether group; a C₁-C₃₀ ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₁-C₃₀ alkylamine group; a C₆-C₃₀ aryl group; a C₂-C₃₀ heterocyclic group comprising at least one heteroatom selected from the group consisting of oxygen (O), nitrogen (N), sulfur (S), silicon (Si), and phosphorus (P); a C₆-C₃₀ aryloxy group; a C₆-C₃₀ arylamine group; a hydroxy group; and combinations thereof.

R⁴ may be selected from the group consisting of hydrogen; deuterium; a C₁-C₃₀ carbonyl group; a C₁-C₃₀ ether group; a C₁-C₃₀ ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₁-C₃₀ alkylamine group; a C₆-C₃₀ aryl group; a C₂-C₃₀ heterocyclic group comprising at least one heteroatom selected from the group consisting of O, N, S, Si, and P; a C₆-C₃₀ aryloxy group; a C₆-C₃₀ arylamine group; a hydroxy group; and combinations thereof.

L² may be selected from the group consisting of a single bond; a C₁-C₃₀ carbonyl group; a C₁-C₃₀ ether group; a C₁-C₃₀ ester group; a C₁-C₃₀ alkylene group; a C₂-C₃₀ alkenylene group; a C₂-C₃₀ alkynylene group; a C₃-C₃₀ cycloalkylene group; a C₃-C₃₀ cycloalkenylene group; a C₁-C₃₀ alkoxylene group; a C₁-C₃₀ alkylamine group; a C₆-C₃₀ arylene group; a C₂-C₃₀ heterocyclic group comprising at least one heteroatom selected from the group consisting of O, N, S, Si, and P; a C₆-C₃₀ aryloxy group; a C₆-C₃₀ arylamine group; and combinations thereof.

Atoms constituting R² and L² may be bonded to each other to form a ring.

In R² to R⁴ and L², the alkyl group, alkenyl group, alkynyl group, cycloalkyl group, alkoxy group, alkylamine group, aryl group, heterocyclic group, aryloxy group, arylamine group, alkylene group, alkenylene group, alkynylene group, cycloalkylene group, cycloalkenylene group, alkoxylene group, and arylene group may each independently be further substituted with one or more substituents selected from the group consisting of deuterium, a halogen group, a hydroxy group, a nitrile group, a nitro group, a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group, and the substituted substituent may be further substituted with one or more substituents selected from the substituents. For example, these substituted substituents may be further substituted with one or more substituents selected from the substituents, and the further substituted substituent may be further substituted with one or more substituents selected from the substituents.

The compound represented by Formula 2 may be at least one of the following compounds.

The second monomer may be at least one of compounds represented by P-2-1 to P-2-140 below.

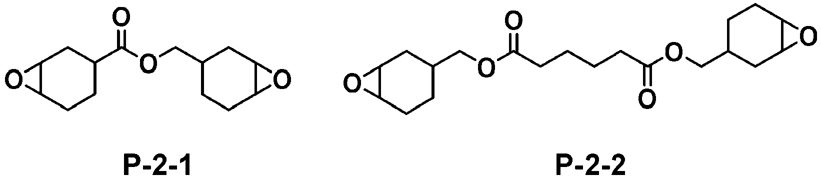

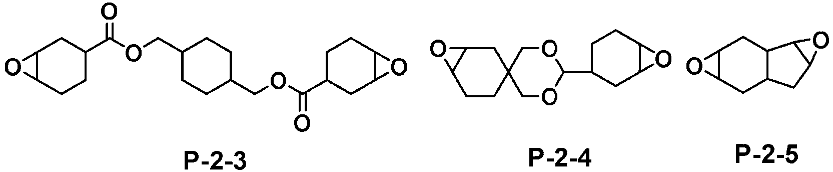

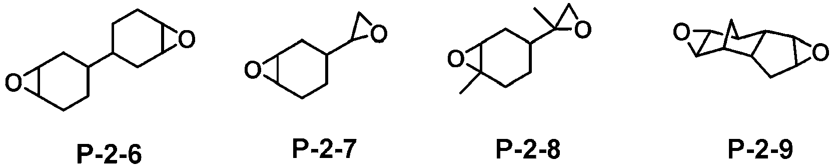

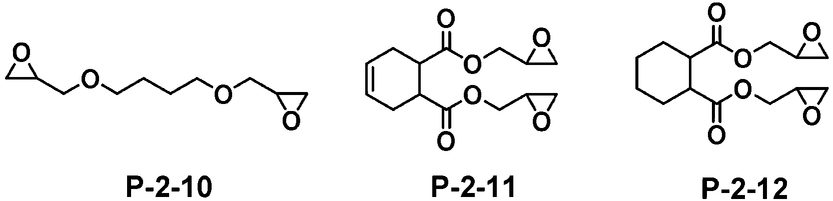

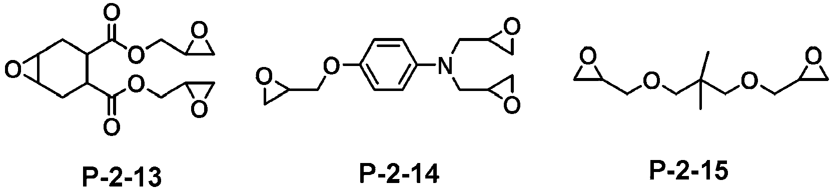

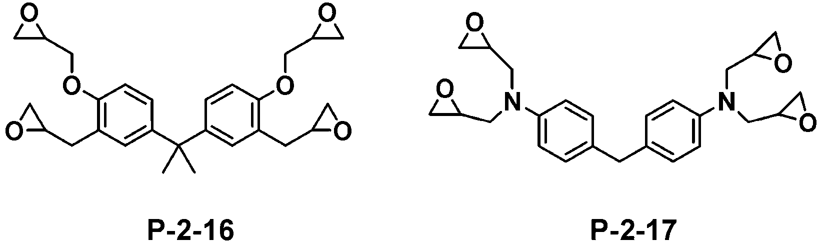

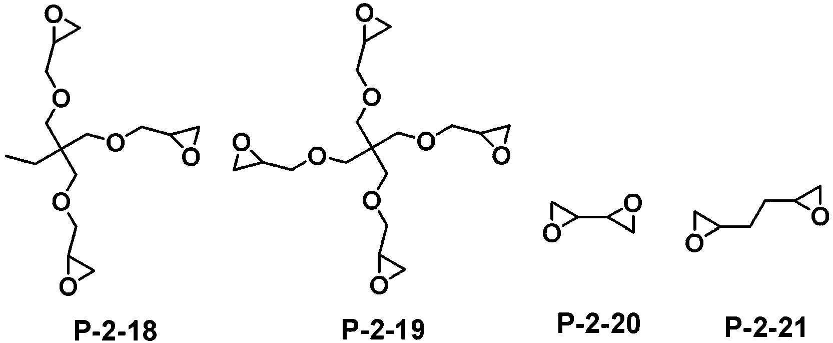

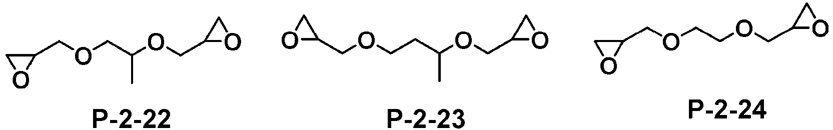

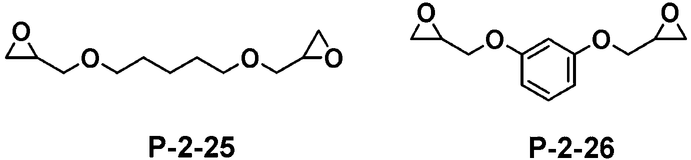

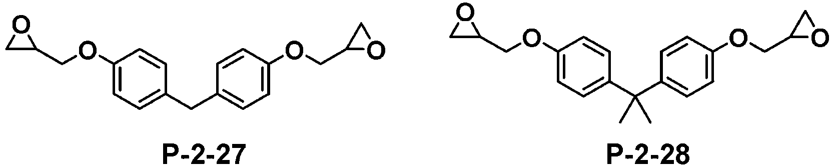

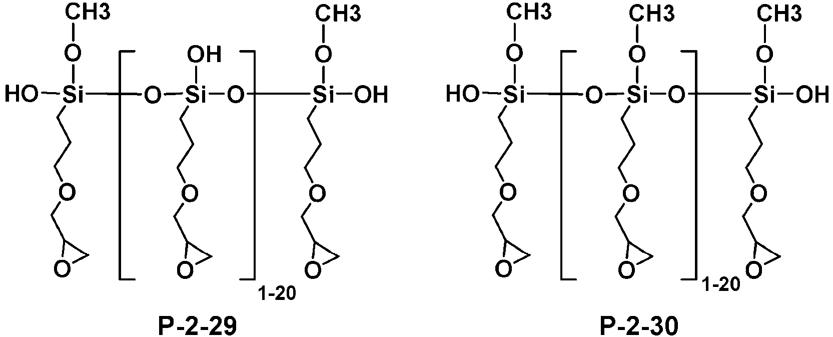

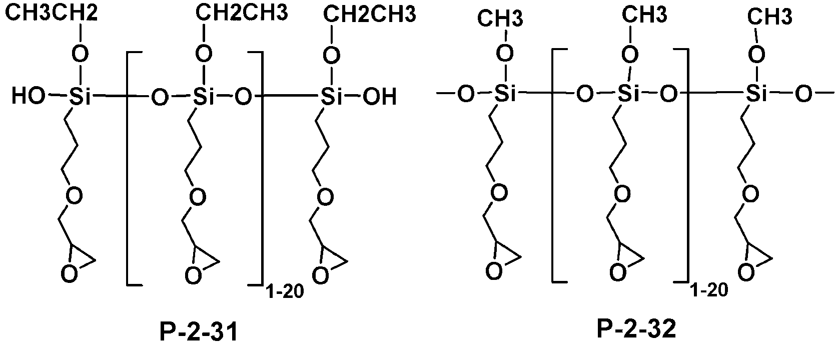

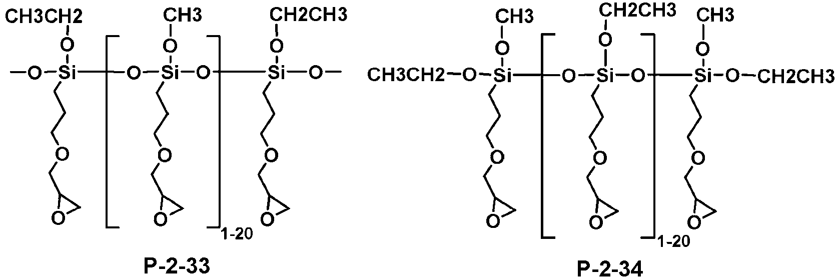

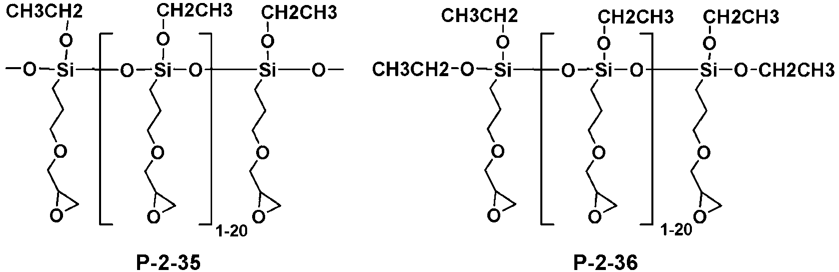

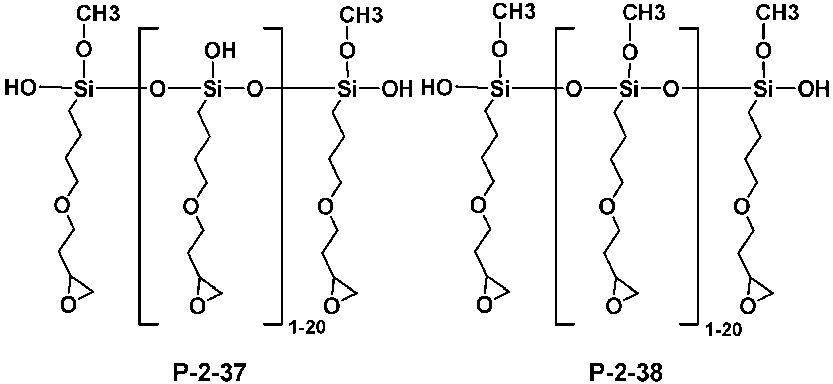

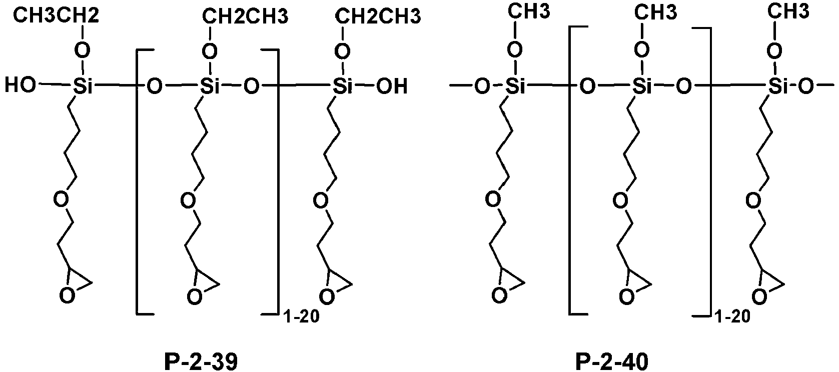

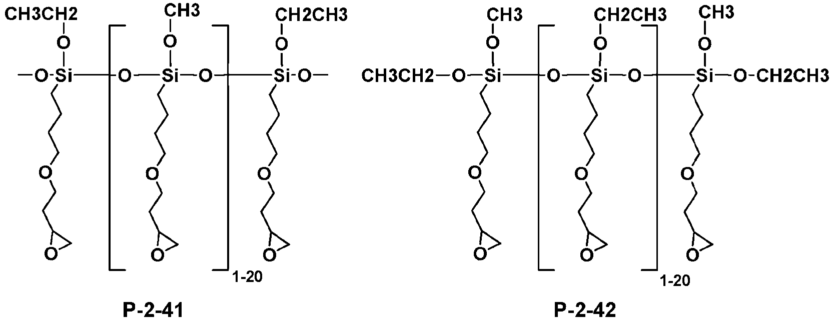

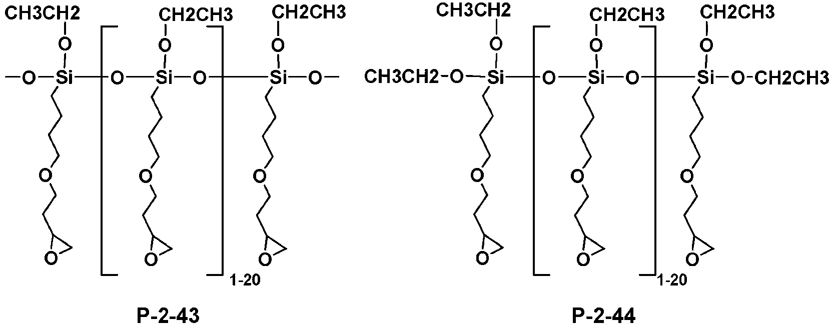

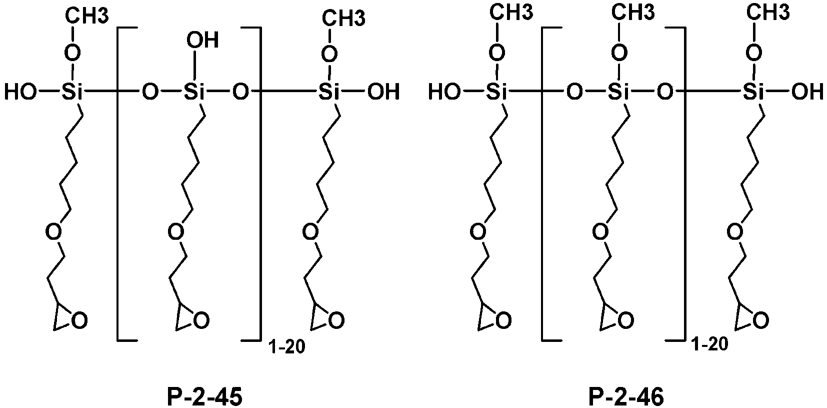

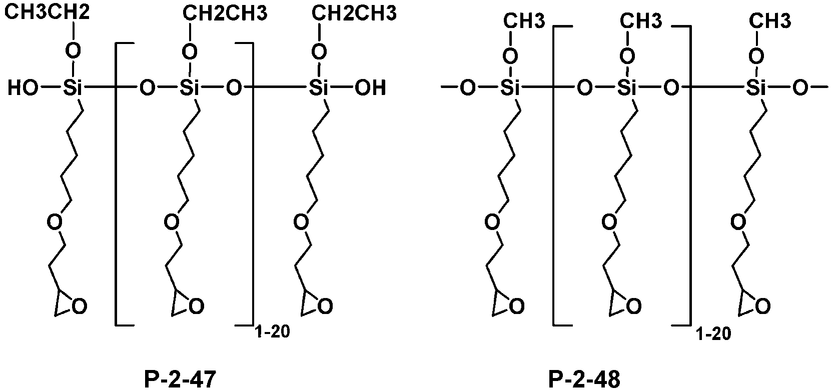

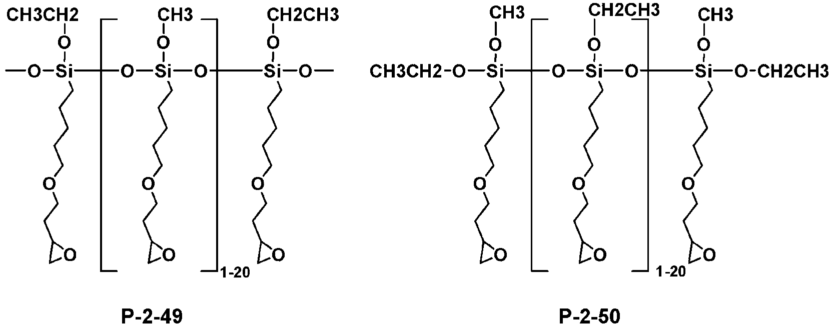

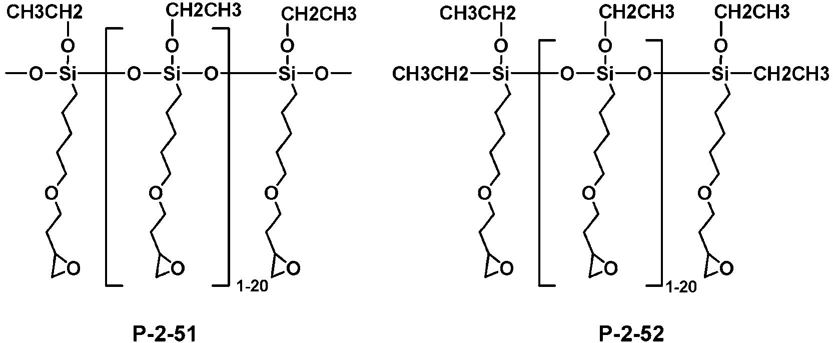

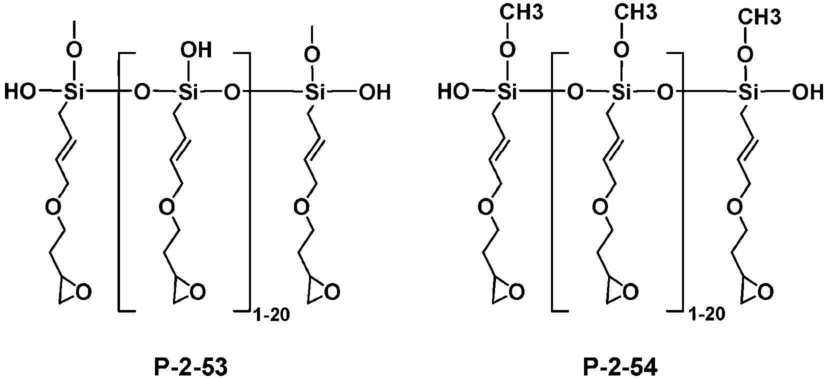

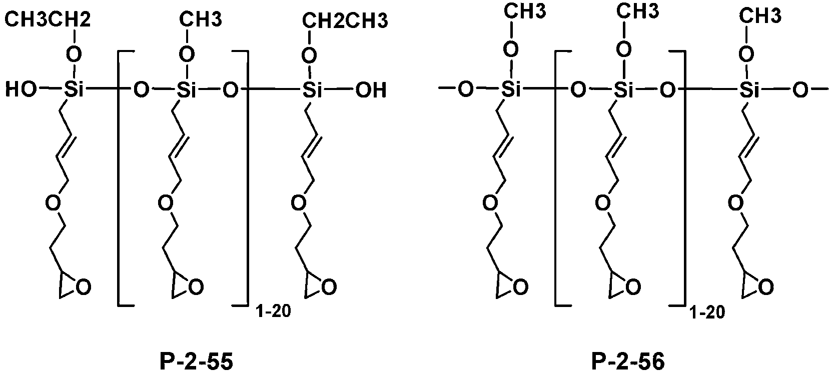

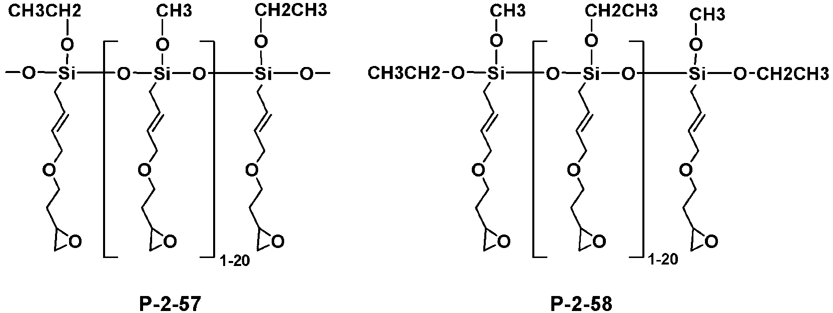

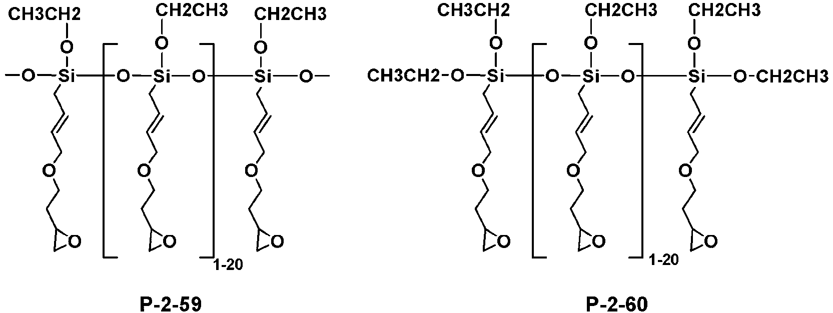

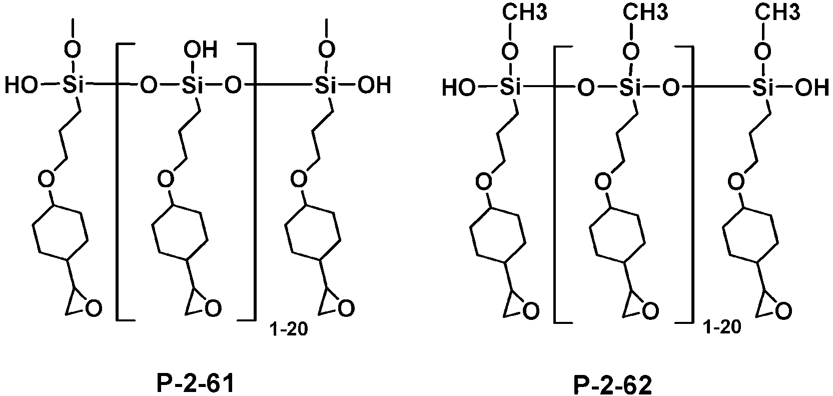

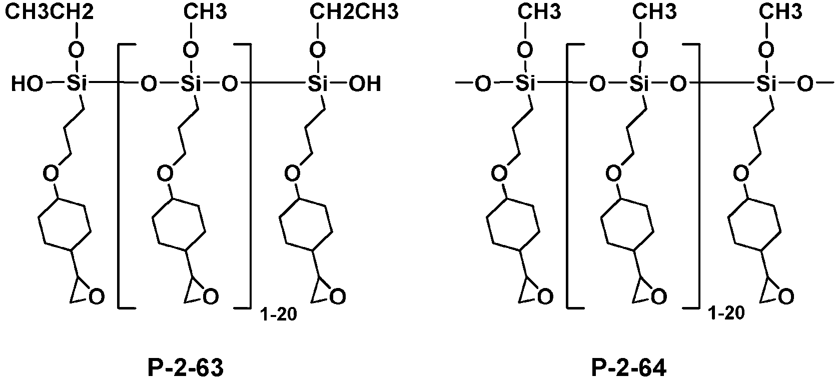

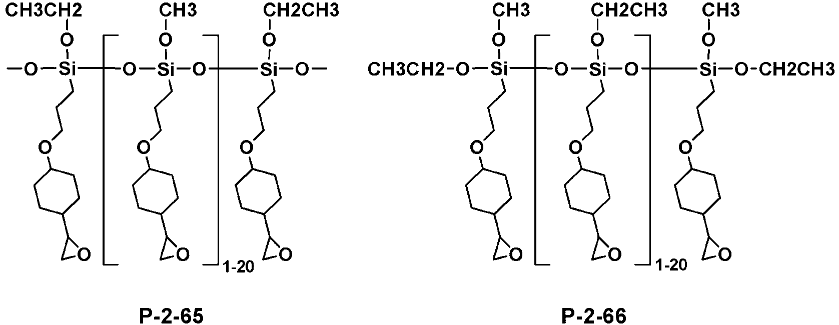

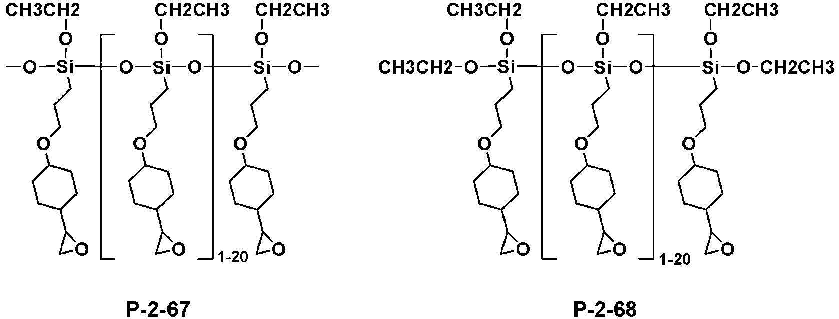

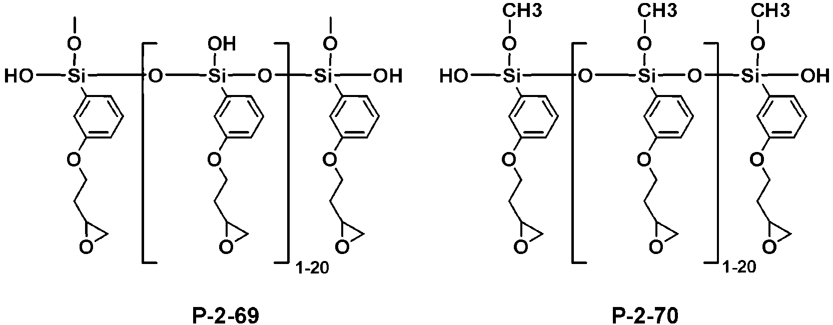

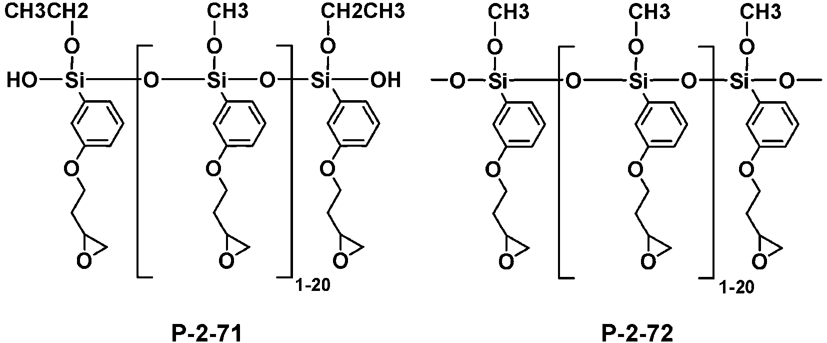

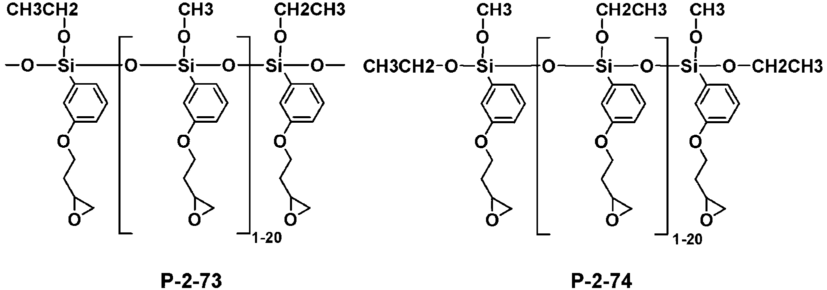

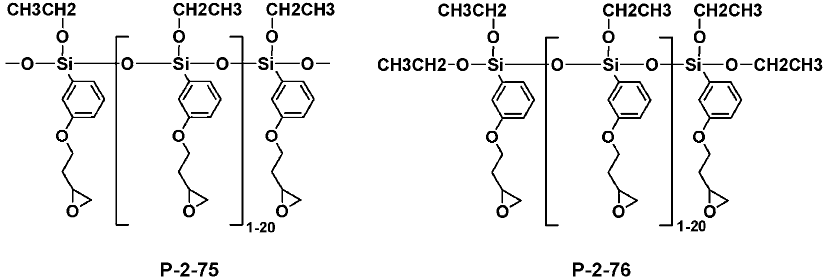

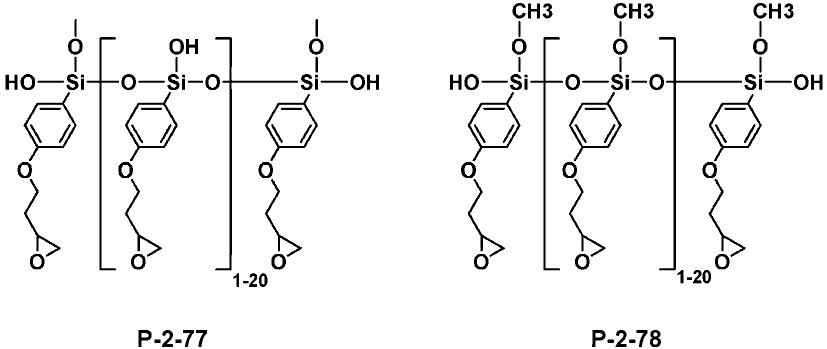

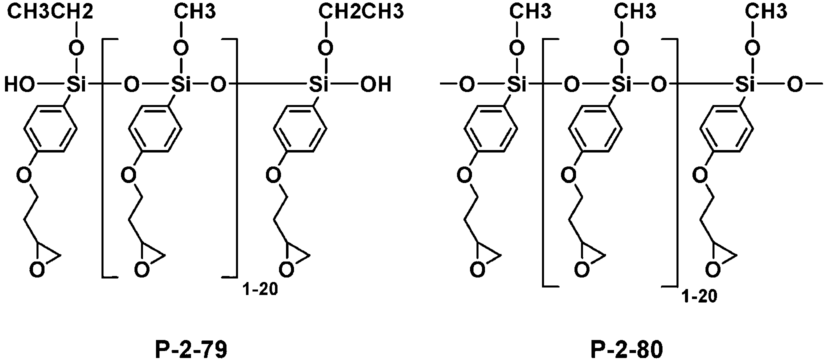

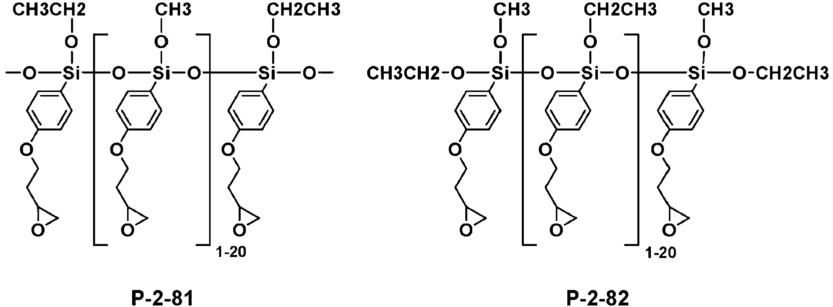

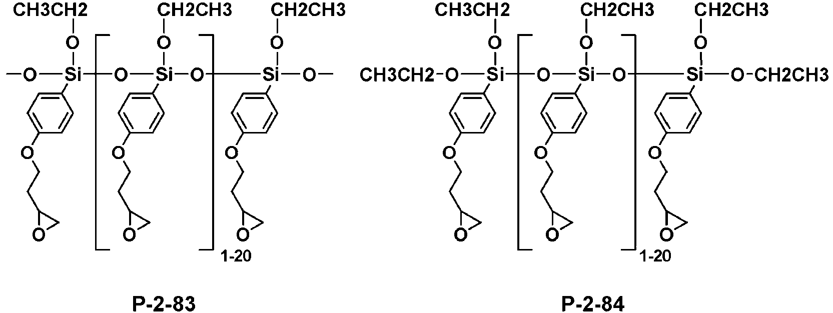

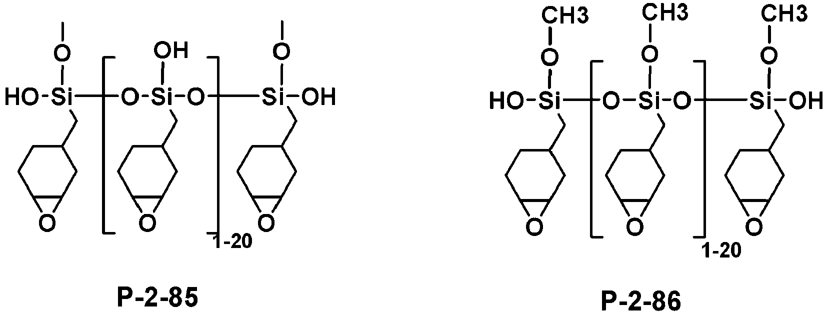

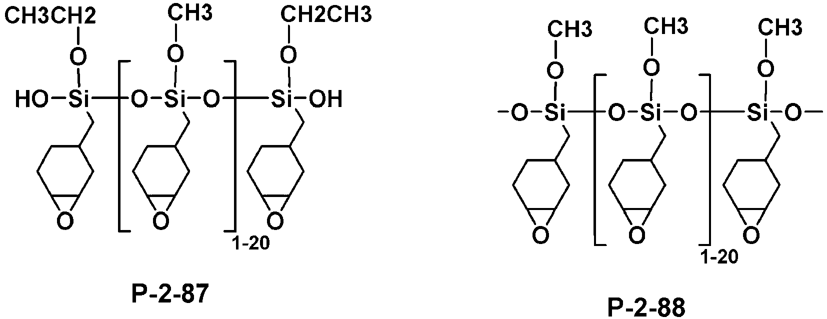

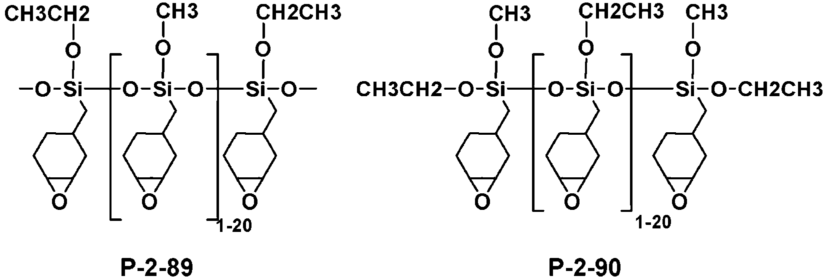

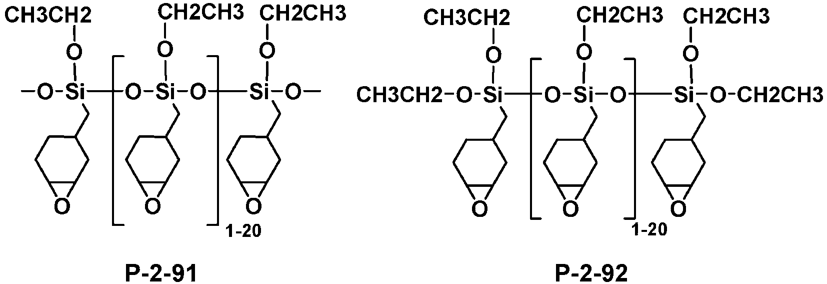

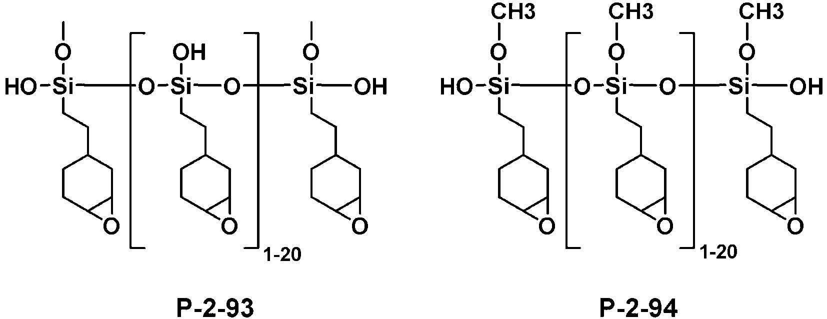

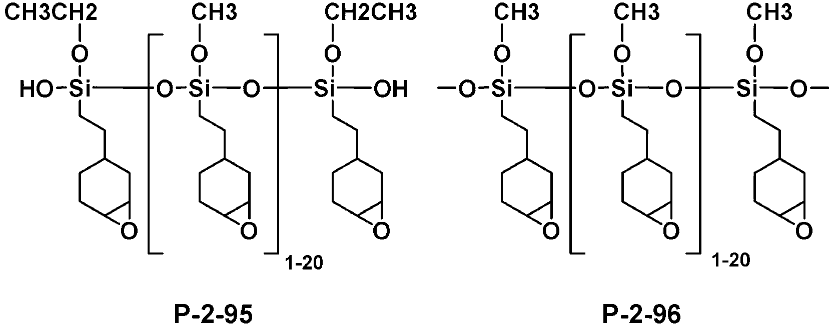

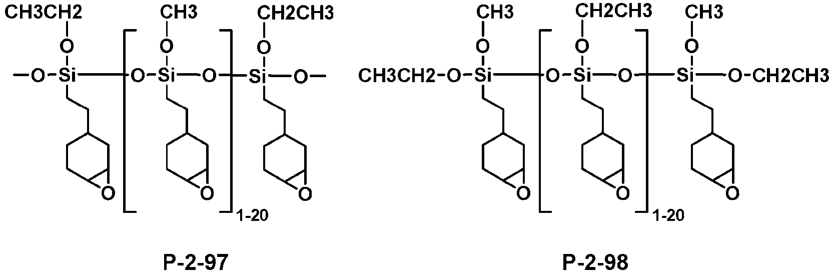

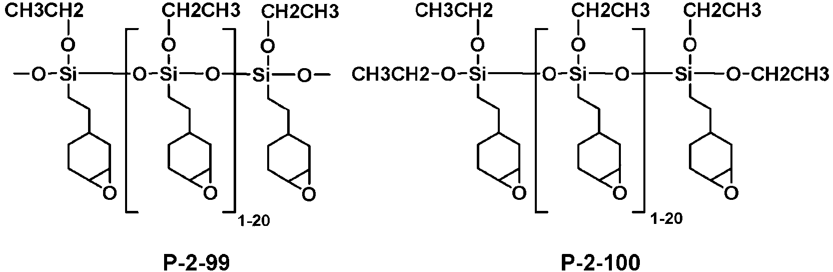

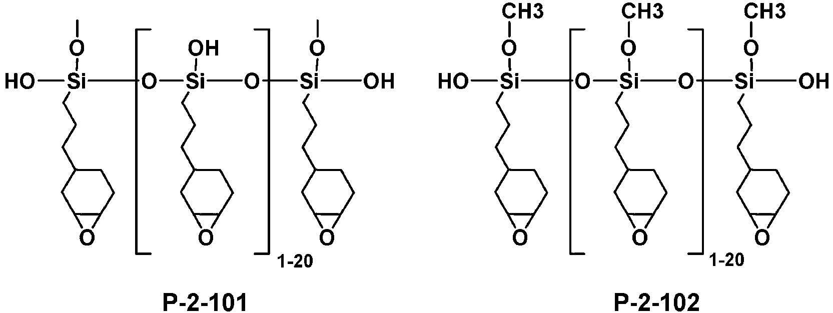

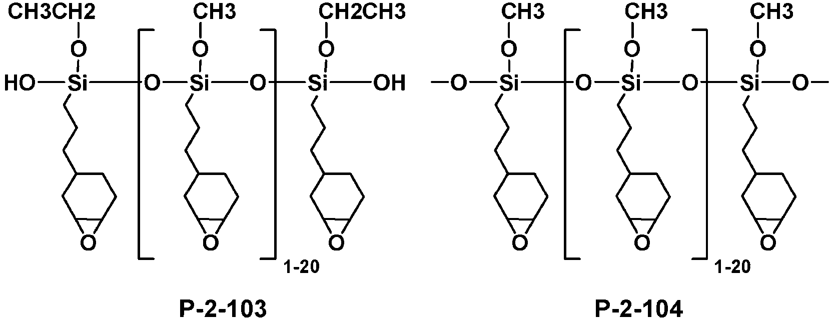

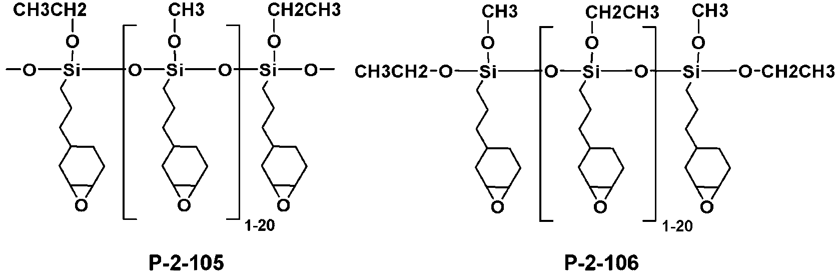

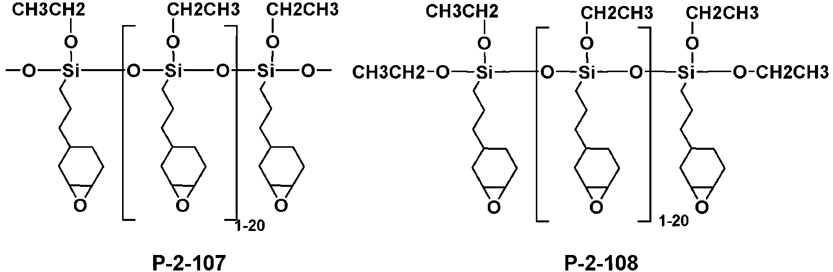

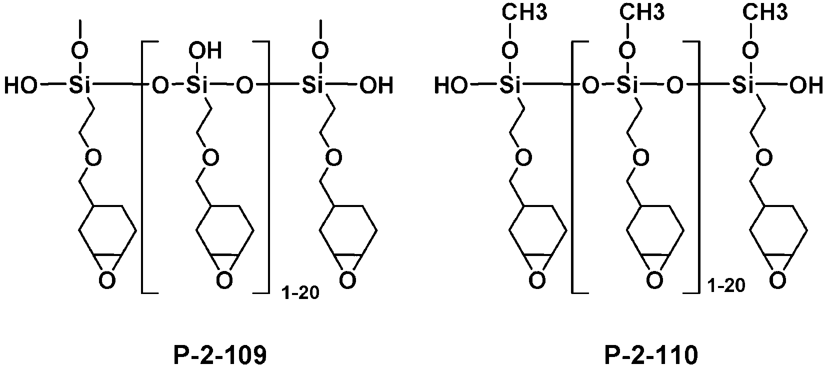

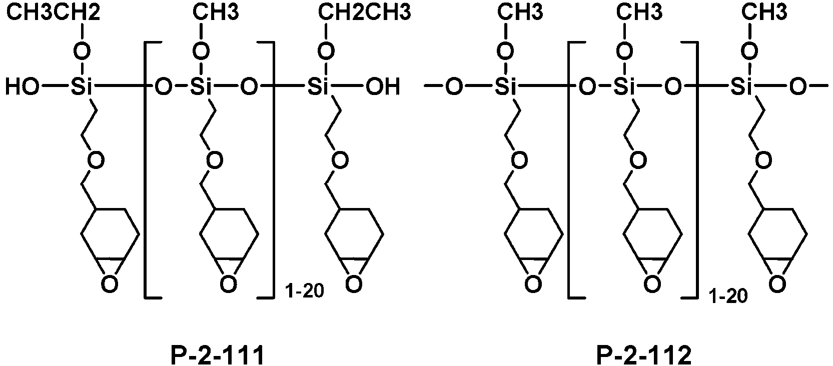

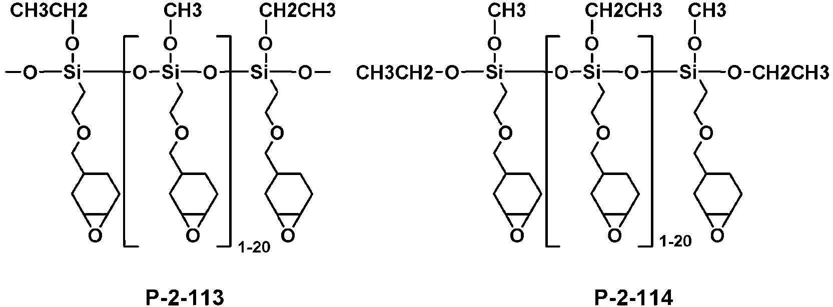

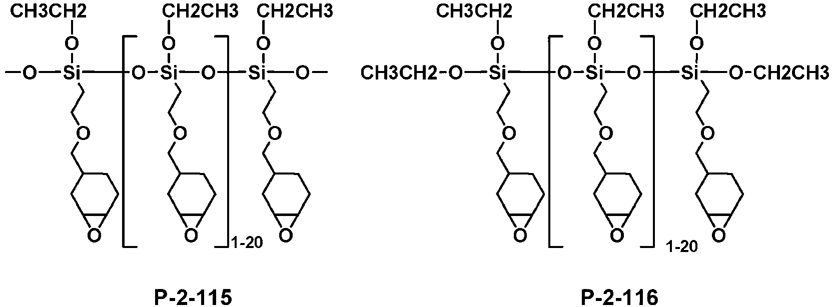

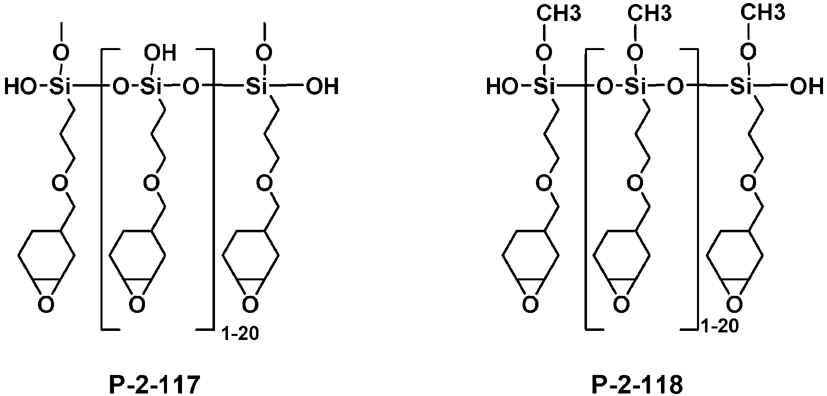

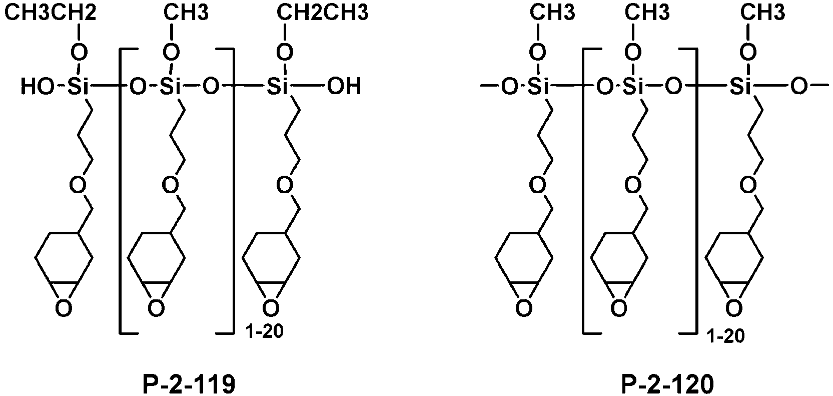

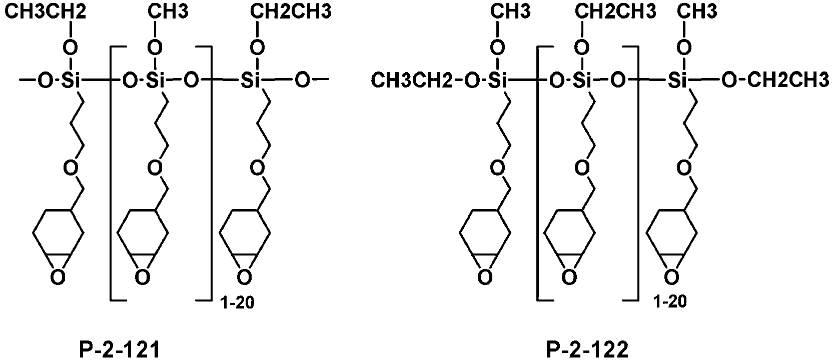

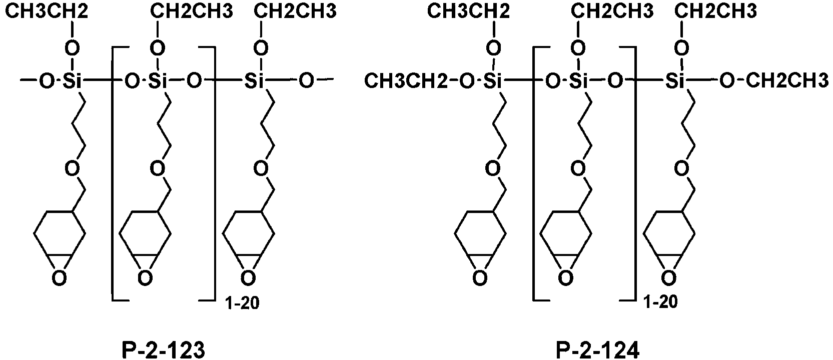

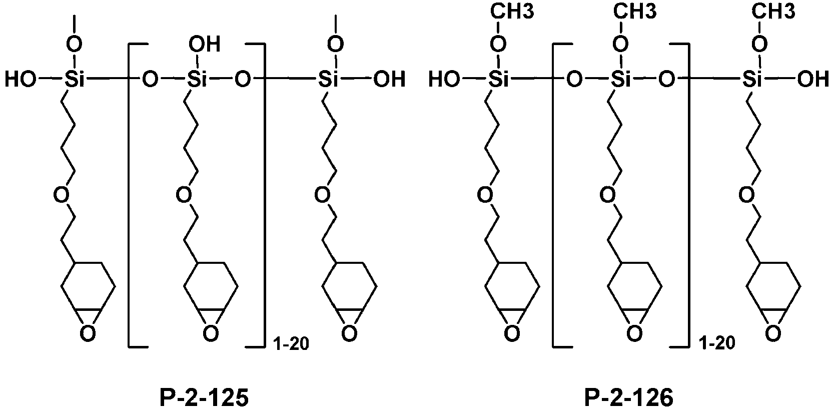

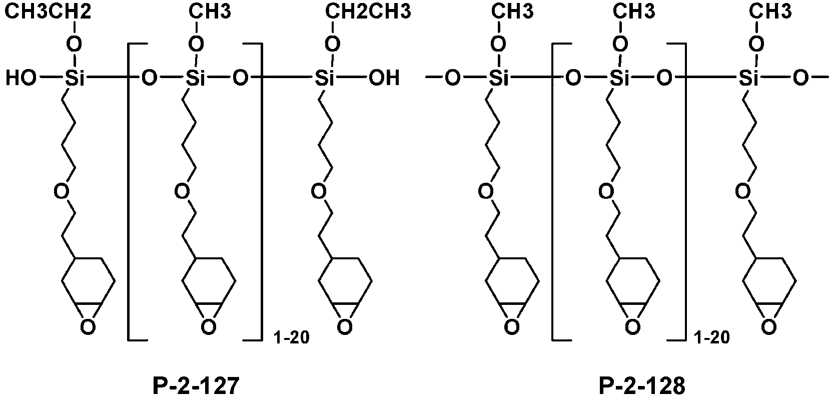

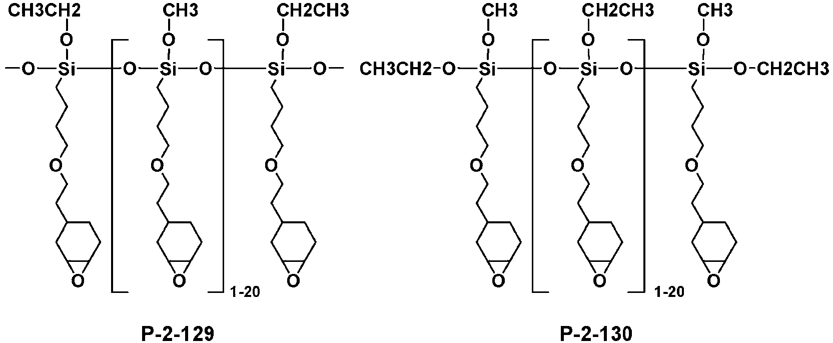

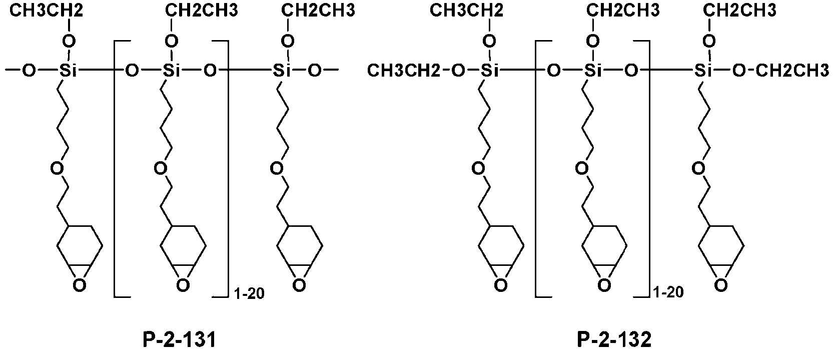

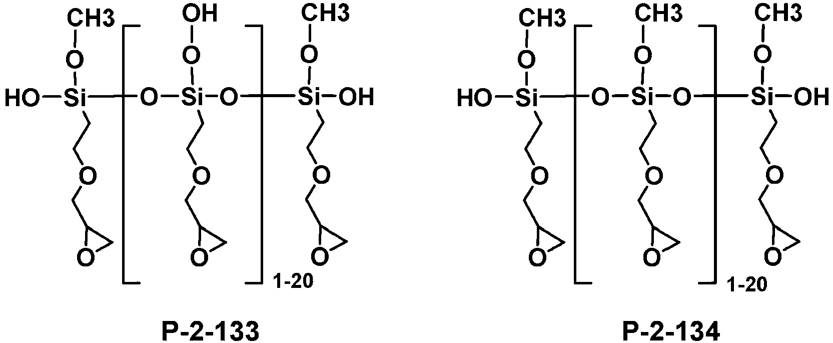

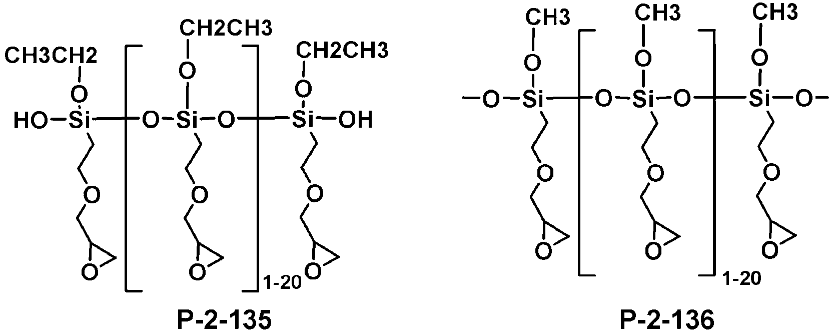

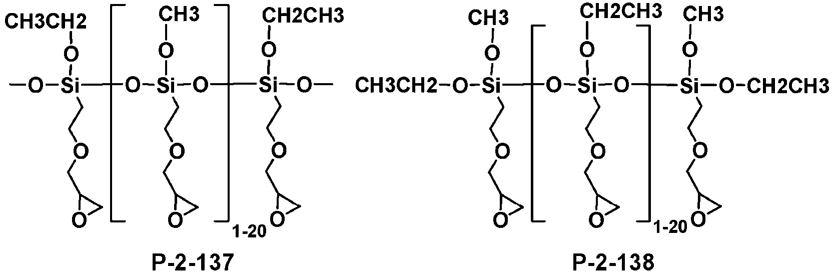

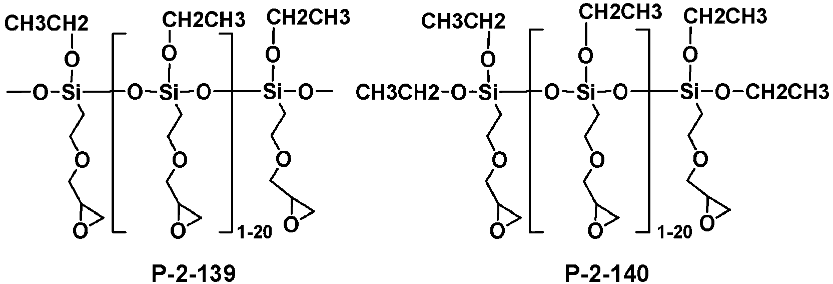

The second monomer may be included in an amount of 1 to 40 wt%, or 1 to 30 wt%, or 1 to 25 wt%, or 5 to 25 wt% based on the total weight of the composition.

When a protective layer is formed from a composition comprising the second monomer comprising an oxygen-containing cyclic group, characteristics of oxygen-containing cyclic structure may significantly improve physical and chemical performance of the protective layer during a curing process.

For example, a ring structure comprising oxygen may form a high-density three-dimensional network during curing to reinforce mechanical strength of the protective layer and exhibit high hardness, thereby providing resistance to external impact, scratches, and abrasion.

Accordingly, sensitive electronic components such as a display panel may be effectively protected from external stimuli.

### (4) Third monomer

In embodiments of the present disclosure, a composition may comprise a third monomer comprising an oxygen-containing cyclic group. The third monomer may comprise an oxetane group.

The third monomer may be a compound represented by the following Formula 3.

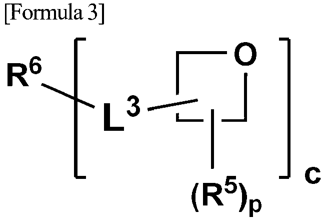

Variables described in Formula 3 may be defined as follows.

c may be an integer from 1 to 4.

p may be an integer from 0 to 5.

R⁵ and R⁶ may each independently be selected from the group consisting of hydrogen; deuterium; a nitrile group; a C₁-C₃₀ carbonyl group; a C₁-C₃₀ ether group; a C₁-C₃₀ ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₆-C₃₀ aryl group; a C₂-C₃₀ heterocyclic group comprising at least one heteroatom selected from the group consisting of oxygen (O), nitrogen (N), sulfur (S), silicon (Si), and phosphorus (P); a C₆-C₃₀ aryloxy group; a C₁-C₃₀ alkylamine group; a C₁-C₃₀ arylamine group; a hydroxyl group; a C₁-C₃₀ acrylate group; -N(R')(R"); and combinations thereof.

When p is 2 or more, each R⁵ may be the same as or different from the others.

When p is 0, L³ in Formula 3 may be connected to the cyclic group by a double bond.

L³ may be selected from the group consisting of a single bond; a C₁-C₃₀ carbonyl group; a C₁-C₃₀ ether group; a C₁-C₃₀ ester group; a C₁-C₃₀ alkylene group; a C₂-C₃₀ alkenylene group; a C₂-C₃₀ alkynylene group; a C₃-C₃₀ cycloalkylene group; a C₃-C₃₀ cycloalkenylene group; a C₁-C₃₀ alkoxylene group; a C₁-C₃₀ amine group; a C₆-C₃₀ arylene group; a C₂-C₃₀ heterocyclic group comprising at least one heteroatom selected from O, N, S, Si, and P; a C₆-C₃₀ aryloxy group; a C₆-C₃₀ arylamine group; and combinations thereof.

R' and R" may each independently be selected from the group consisting of hydrogen; deuterium; a hydroxyl group; an acrylate group; a carbonyl group; an ether group; an ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₁-C₃₀ alkylamine group; a C₆-C₃₀ aryl group; a C₂-C₃₀ heterocyclic group comprising at least one heteroatom selected from O, N, S, Si, and P; a C₆-C₃₀ aryloxy group; a C₆-C₃₀ arylamine group; and combinations thereof.

In R⁵, R⁶, R', R", and L³, the alkyl group, the alkenyl group, the alkynyl group, the cycloalkyl group, the alkoxy group, the alkylamine group, the aryl group, the heterocyclic group, the aryloxy group, the arylamine group, the alkylene group, the alkenylene group, the alkynylene group, the cycloalkylene group, the cycloalkenylene group, the alkoxylene group, and the arylene group may each independently be substituted with one or more substituents selected from the group consisting of deuterium, a halogen group, a hydroxyl group, a nitrile group, a nitro group, a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, -N(R')(R") (wherein R' and R" may be defined as described above), a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group, and the substituted substituent may be further substituted with one or more substituents selected from the substituents described above. For example, these substituted substituents may be further substituted with one or more substituents selected from the substituents described above, and the further substituted substituent may be additionally substituted with one or more substituents selected from the substituents described above.

The Formula 3 may be represented by any one of the following Formula 3-1 and Formula 3-2.

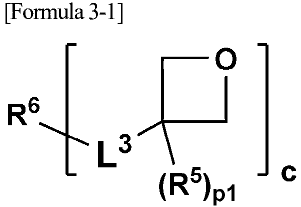

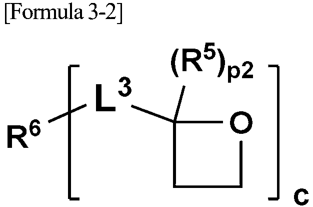

Variables described in Formula 3-1 and Formula 3-2 may be defined as follows.

c, R⁵, R⁶, and L³ in Formula 3-1 and Formula 3-2 may be defined the same as defined in Formula 3.

p1 and p2 may each independently be 0 or 1.

When p1 is 0, L³ in Formula 3-1 may be connected to the cyclic group by a double bond.

When p2 is 0, L³ in Formula 3-2 may be connected to the cyclic group by a double bond.

The compound represented by Formula 3 may be at least one of the following compounds.

The third monomer may be at least one of compounds represented by Formulas P-3-1 to P-3-68 below.

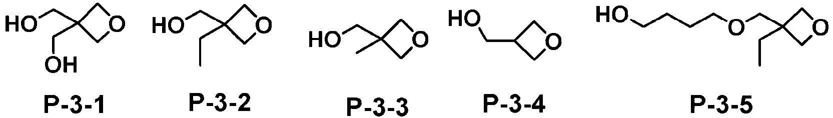

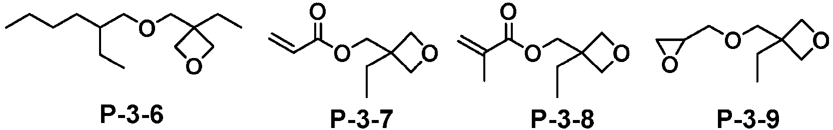

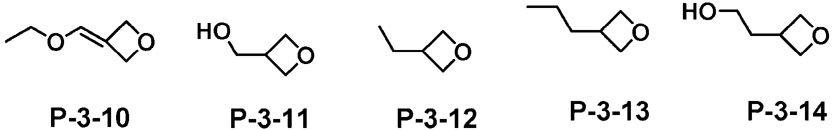

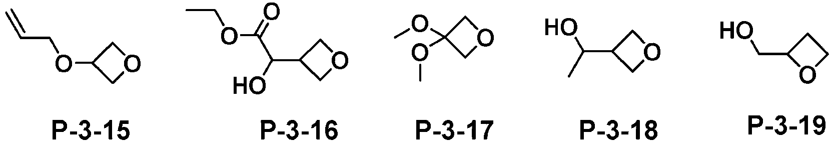

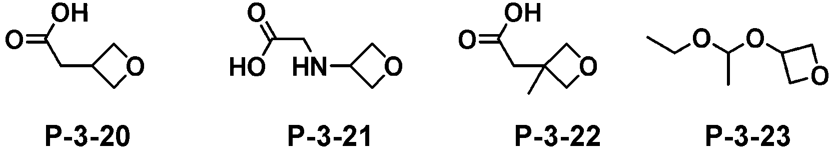

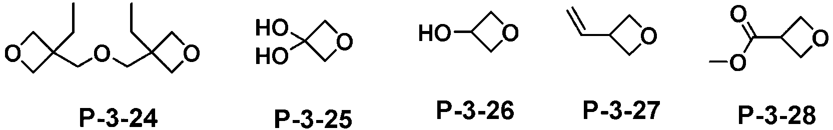

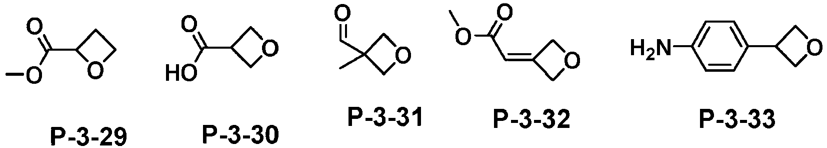

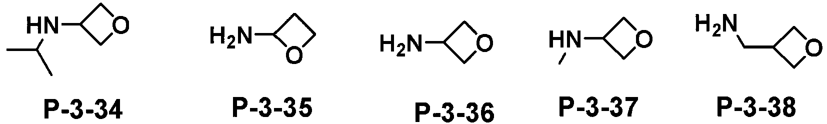

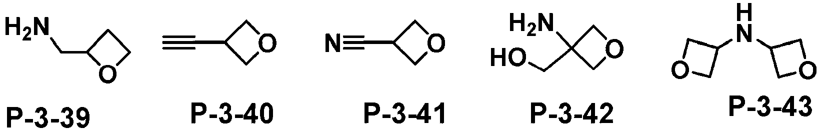

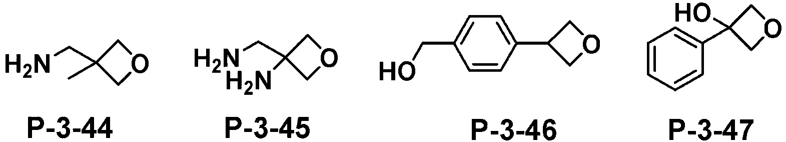

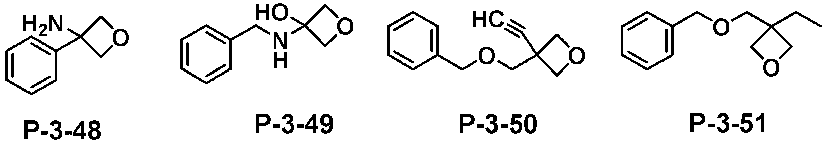

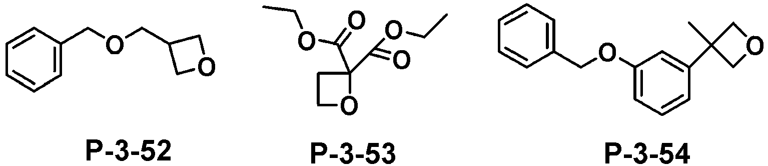

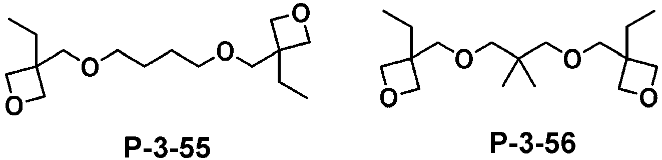

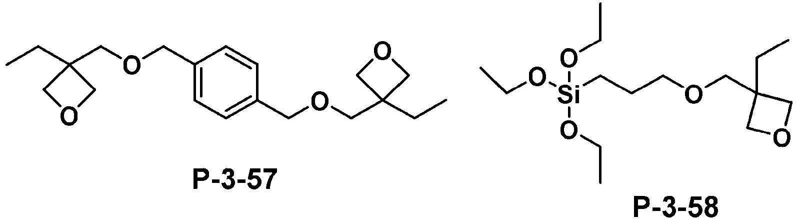

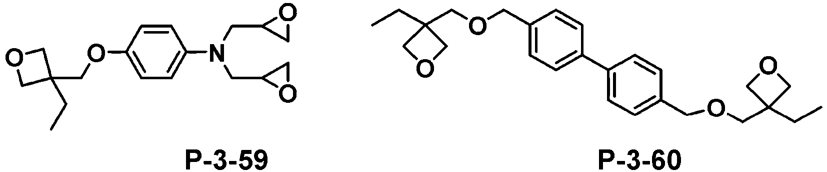

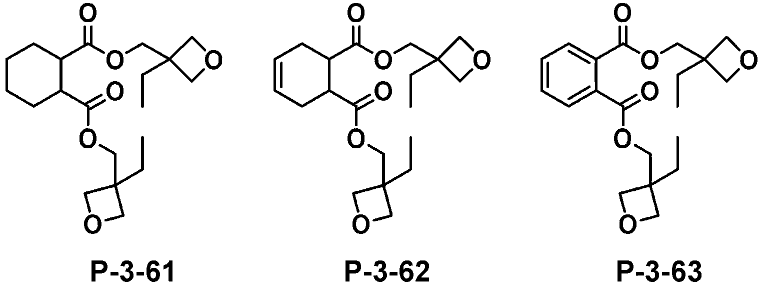

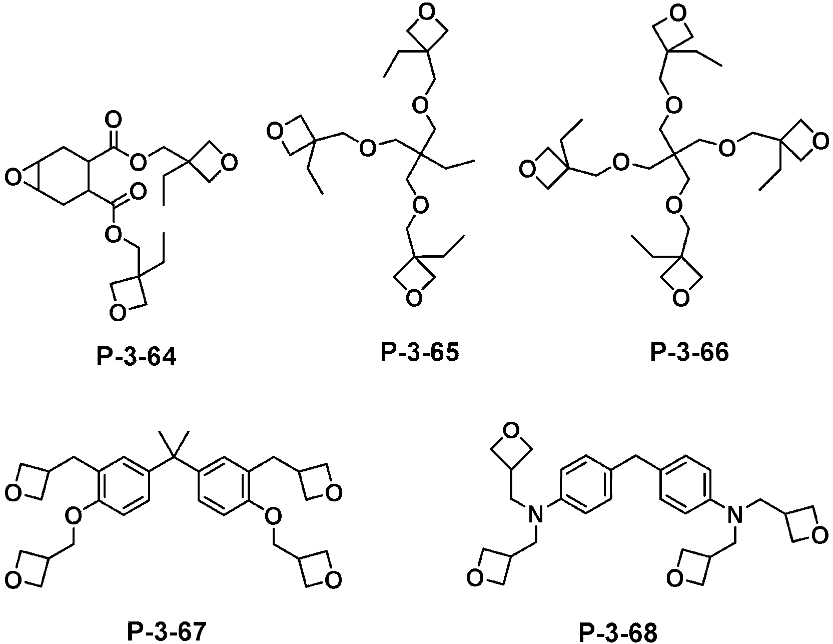

The third monomer may be included in an amount of 1 to 40 wt%, 1 to 30 wt%, 1 to 25 wt%, or 5 to 25 wt% based on the total weight of the composition.

When a protective layer is formed from a composition comprising a monomer comprising an oxygen-containing cyclic group, characteristics of oxygen-containing cyclic structure may significantly improve physical and chemical performance of the protective layer during a curing process.

For example, a ring structure comprising oxygen may form a high-density three-dimensional network during curing to strengthen mechanical strength of the protective layer and may provide resistance to external impact, scratches, and abrasion by exhibiting high hardness.

Through this, sensitive electronic components such as a display panel may be effectively protected from external stimuli.

### (5) Initiator

In embodiments of the present disclosure, the composition may comprise an initiator.

The initiator is a photoinitiator used during UV curing and may initiate a polymerization reaction of a monomer or an oligomer by absorbing UV or visible light.

A photopolymerization initiator is an initiator generally used in a composition, and representative examples thereof include a radical initiator and a cationic initiator.

In the case of the radical initiator, an acetophenone-based compound, a benzophenone-based compound, a thioxanthone-based compound, a benzoin-based compound, a triazine-based compound, an oxime-based compound, a phosphine oxide-based compound, or a mixture thereof may be used. For example, the radical initiator may initiate a radical reaction of an acrylate monomer.

Examples of the acetophenone-based compound include 2,2'-diethoxyacetophenone, 2,2'-dibutoxyacetophenone, 2-hydroxy-2-methylpropiophenone, p-t-butyltrichloroacetophenone, p-t-butyldichloroacetophenone, 4-chloroacetophenone, 2,2'-dichloro-4-phenoxyacetophenone, 2-methyl-1-(4-(methylthio)phenyl)-2-morpholinopropan-1-one, 2-benzyl-2-dimethylamino-1-(4-morpholinophenyl)-butan-1-one, and the like.

Examples of the benzophenone-based compound include benzophenone, benzoylbenzoic acid, methyl benzoylbenzoate, 4-phenylbenzophenone, hydroxybenzophenone, acrylated benzophenone, 4,4'-bis(dimethylamino)benzophenone, 4,4'-bis(diethylamino)benzophenone, 4,4'-dimethylaminobenzophenone, 4,4'-dichlorobenzophenone, 3,3'-dimethyl-2-methoxybenzophenone, and the like.

Examples of the thioxanthone-based compound include thioxanthone, 2-chlorothioxanthone, 2-methylthioxanthone, isopropyl thioxanthone, 2,4-diethyl thioxanthone, and 2,4-diisopropyl thioxanthone.

Examples of the benzoin-based compound include benzoin, benzoin methyl ether, benzoin ethyl ether, benzoin isopropyl ether, benzoin isobutyl ether, and benzyldimethylketal.

Examples of the triazine-based compound include 2,4,6-trichloro-s-triazine, 2-phenyl 4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl 4,6-bis(trichloromethyl)-s-triazine, bis(trichloromethyl)-6-styryl-s-triazine, 2-(naphth-1-yl)-4,6-bis(trichloromethyl)-s-triazine, 2-(4-methoxynaphth-1-yl)-4,6-bis(trichloromethyl)-s-triazine, 2-4-trichloromethyl(piperonyl)-6-triazine, and 2-4-trichloromethyl(4'-methoxystyryl)-6-triazine.

Examples of the oxime-based compound include 2-(o-benzoyloxime)-1-[4-(phenylthio)phenyl]-1,2-octanedione, 1-(o-acetyloxime)-1-[9-ethyl-6-(2-methylbenzoyl)-9H-carbazole-3-yl]ethanone, and (E)-1(((3-cyclopentyl-1-(9-ethyl-6-(2-methylbenzoyl)-9H-carbazole-3-yl)propylidene)amino)oxy)ethan-1-one (PBG-304, Trony Co.).

Examples of the phosphine oxide-based compound include diphenyl(2,4,6-trimethylbenzoyl)phosphine oxide (TPO), ethyl phenyl(2,4,6-trimethylbenzoyl)phosphinate (TPO-L), and methyl acrylphosphine oxide.

In addition to the compounds described above, a photoinitiator may use carbazole-based compounds, diketone compounds, sulfonium borate-based compounds, diazo-based compounds, imidazole-based compounds, and biimidazole-based compounds.

Among the photoinitiators, peroxide-based compounds and azobis-based compounds may be used as a radical polymerization initiator.

Examples of the peroxide-based compound include ketone peroxides such as methyl ethyl ketone peroxide, methyl isobutyl ketone peroxide, cyclohexanone peroxide, methyl cyclohexanone peroxide, and acetylacetone peroxide; diacyl peroxides such as isobutyryl peroxide, 2,4-dichlorobenzoyl peroxide, o-methylbenzoyl peroxide, and bis-3,5,5-trimethylhexanoyl peroxide; hydroperoxides such as 2,4,4-trimethylpentyl-2-hydroperoxide, diisopropylbenzene hydroperoxide, cumene hydroperoxide, and t-butyl hydroperoxide; dialkyl peroxides such as dicumyl peroxide, 2,5-dimethyl-2,5-di(t-butylperoxy)hexane, 1,3-bis(t-butyloxyisopropyl)benzene, and t-butyl peroxyvaleric acid n-butyl ester; alkyl peresters such as 2,4,4-trimethylpentyl peroxyphenoxyacetate, α-cumyl peroxyneodecanoate, t-butyl peroxybenzoate, and di-t-butyl peroxytriethyladipate; and percarbonates such as di-3-methoxybutyl peroxydicarbonate, di-2-ethylhexyl peroxydicarbonate, bis-4-t-butylcyclohexyl peroxydicarbonate, diisopropyl peroxydicarbonate, acetylcyclohexylsulfonyl peroxide, and t-butyl peroxyallylcarbonate.

Examples of the azobis-based compound include 1,1'-azobiscyclohexane-1-carbonitrile, 2,2'-azobis(2,4-dimethylvaleronitrile), 2,2'-azobis(methyl isobutyrate), 2,2'-azobis(4-methoxy-2,4-dimethylvaleronitrile), α,α'-azobis(isobutylnitrile), and 4,4'-azobis(4-cyanovaleric acid).

In the case of a cationic initiator, it functions to generate a cation by irradiation with UV or visible light to initiate polymerization, and in particular, it may be used to initiate a cationic reaction during polymerization of monomers such as epoxy monomers and vinyl ether. For example, an onium salt initiator and a non-onium salt initiator may be used during monomer polymerization.

Examples of the onium salt initiator include diaryliodonium salt, triarylsulfonium salt, ferrocenium salt, sulfonium hexafluoroantimonate, and sulfonium hexafluorophosphate.

Examples of the non-onium salt initiator include trifluoromethanesulfonate, tetraphenylborate, iron phenylsulfone, and N-hydroxynaphthalimide triflate (NIT).

A radical initiator and a cationic initiator may be classified into primary initiators and secondary initiators according to their roles.

In the case of the primary initiator, it may directly absorb light to generate a radical or a cation, thereby inducing an initiation reaction by itself. Specific examples comprise acetophenone-based initiators and triazine-based initiators.

For example, in the case of an acetophenone-based initiator, examples comprise, but are not limited to, acetophenone, 2-hydroxy-2-methylpropiophenone, 1-hydroxycyclohexyl phenyl ketone, and 2,2-dimethoxyacetophenone.

For example, in the case of a triazine-based initiator, examples comprise, but are not limited to, 2,4,6-triphenyloxadiazolyl-1,3,5-triazine, hexamethoxymethyltriazine, bis(4-dimethylaminophenyl)-1,3,5-triazine, and 2,4,6-triphenyl-1,3,5-triazine.

A secondary initiator may induce uniform curing of a coated surface by increasing sensitivity of a primary initiator or playing an auxiliary role to facilitate activation at longer wavelengths. For example, the secondary initiator includes anthracene-based, thioxanthone-based, and coumarin-based photosensitizers.

Examples of the anthracene-based photosensitizer include 9,10-diphenylanthracene, 1-chloro-9,10-bis(phenylethynyl)anthracene, and 2-ethylanthracene, but are not limited thereto.

Examples of the thioxanthone-based initiator include isopropyl thioxanthone, 2-chlorothioxanthone, and 2,4-diethylthioxanthone, but are not limited thereto.

Examples of the coumarin-based photosensitizer include coumarin 6, 4-methyl-7-diethylaminocoumarin, and 3-phenylcoumarin.

The photoinitiator may be used together with a photosensitizer that causes a chemical reaction by absorbing light to enter an excited state and then transferring the energy. Examples of the photosensitizer include tetraethylene glycol bis-3-mercaptopropionate, pentaerythritol tetrakis-3-mercaptopropionate, and dipentaerythritol tetrakis-3-mercaptopropionate.

The photoinitiator may be included in an amount of 1 to 40 wt%, or 1 to 30 wt%, or 1 to 25 wt%, or 5 to 40 wt%, or 5 to 30 wt%, or 5 to 25 wt% based on the total weight of the composition. When the photoinitiator is included within the above-described range, crosslinking of the monomer sufficiently occurs in a process of forming the protective layer, and thus high reliability for a protective effect may be obtained.

### (6) Other Additives

In embodiments of the present disclosure, the composition may comprise other additives.

For example, in preparing the composition of the present disclosure, an acrylate-based additive, an adhesion promoter, a leveling agent, and an antistatic agent may further be included.

A composition comprising the acrylate-based additive and/or the adhesion promoter may improve adhesion to the substrate when forming the protective layer.

The leveling agent may improve surface smoothness. For example, the leveling agent serves to allow the composition to spread uniformly on the substrate, and may prevent ink from excessively spreading or shrinking through surface tension control.

In addition, it may serve to improve flowability and workability of the ink in an inkjet printer head.

The leveling agent may comprise a silicone-based compound.

The molecular weight of the silicone-based compound may be 5,000 g/mol to 15,000 g/mol.

The molecular weight of the silicone-based compound may be 5,000 g/mol to 10,000 g/mol.

The viscosity of the silicone-based compound may be 100,000 mm²/s to 500,000 mm²/s.

The viscosity of the silicone-based compound may be 10 mm²/s to 40 mm²/s when a mixture of 50 wt% of the silicone-based compound and 50 wt% of propylene glycol methyl ether acetate is measured at 20°C.

The viscosity of the mixture comprising the silicone-based compound may be 10 mm²/s to 30 mm²/s.

The silicone-based compound may comprise a substituent selected from the group consisting of a C₁-C₄₀ alkyl group; a C₁-C₄₀ alkenyl group; a C₁-C₄₀ alkynyl group; a C₁-C₄₀ alkoxy group; a C₆-C₄₀ aryloxy group; a C₁-C₄₀ alkoxycarbonyl group; a carbonyl group; an ether group; an ester group; a carboxyl group; and combinations thereof.

An antistatic agent may serve to suppress the generation of static electricity by controlling the surface resistance of the protective layer according to embodiments of the present disclosure, and to prevent dust adhesion and maintain electrical stability.

For example, the antistatic agent includes a polymeric antistatic agent, an ionic antistatic agent, a semi-conductive filler, an inorganic antistatic agent, an organometallic complex antistatic agent, and the like.

Examples of the polymeric antistatic agent include polyethylene glycol, polyoxyethylene, polyvinylpyrrolidone, polyethyleneimide, and the like, but are not limited thereto.

The ionic antistatic agent is classified into cationic and anionic ionic antistatic agents. Examples of the cationic antistatic agent include a quaternary ammonium salt, an imidazolinium salt, a pyridinium salt, and the like, and examples of the anionic antistatic agent include a sulfonate salt, a carboxylate salt, and the like, but are not limited thereto.

Examples of the semi-conductive filler include carbon black, carbon nanotubes, silver nanowires, and the like, but are not limited thereto.

Examples of the inorganic antistatic agent include indium tin oxide, zinc oxide, titanium oxide, silicon oxide, and the like, but are not limited thereto.

Examples of the organometallic complex antistatic agent include a conductive polymer mixture (PEDOT:PSS), a silver nanoparticle composite, a copper oxide nanocomposite, a graphene-metal composite, and the like, but are not limited thereto.

Other additives may be included in an amount of 1 to 10 wt% based on the total weight of the composition.

According to embodiments of the present disclosure, a composition comprising the colorant, the first monomer, the second monomer, and the third monomer described above may be provided.

According to embodiments of the present disclosure, a protective layer comprising the composition described above may be provided.

According to embodiments of the present disclosure, a display device comprising the composition described above may be provided.

Hereinafter, various embodiments of the present disclosure will be described in detail with reference to the accompanying drawings.

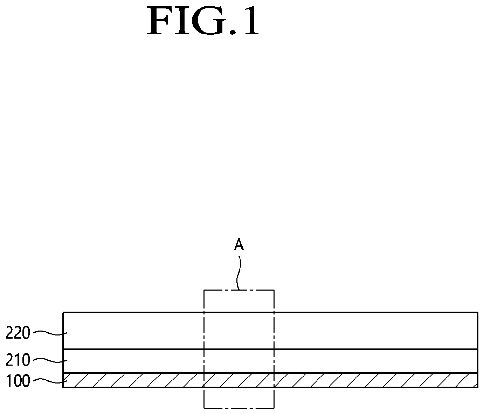

FIG. 1 is an exemplary cross-sectional view schematically illustrating a display device according to embodiments of the present disclosure.

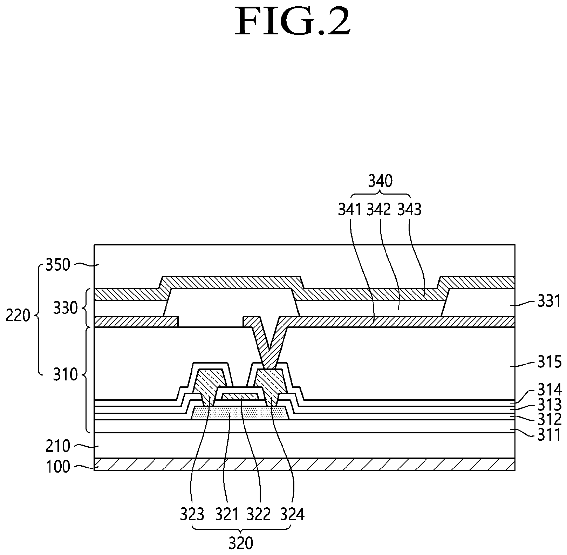

FIG. 2 is an exemplary cross-sectional view illustrating an enlarged cross-section of region A shown in FIG. 1.

Referring to FIGS. 1 and 2, the display device may comprise a protective layer 100, a substrate 210, and a pixel array layer 220. The display device may be a display element, a display panel, or an electronic device. The pixel array layer 220 may comprise a pixel circuit layer 310, a pixel element layer 330, and an encapsulation layer 350.

The protective layer 100 may be disposed under the substrate 210. The protective layer 100 may be disposed on the other surface of the substrate 210 opposite to one surface of the substrate 210 on which the pixel array layer 220 is disposed. The protective layer 100 may comprise a composition comprising the colorant, the first monomer, the second monomer, and the third monomer.

By including the colorant, the protective layer 100 may minimize reflection of internal light from the bottom of the display panel, thereby preventing color interference and electrode oxidation. The protective layer 100, which comprises a composition containing the first monomer, the second monomer, and the third monomer, may effectively protect sensitive electronic components such as the display panel from external stimuli by providing improved resistance to external impact, scratches, and abrasion.

The substrate 210 may be disposed on the protective layer 100. The substrate 210 may be disposed to directly contact the protective layer 100. The substrate 210 is for supporting various components of the display device and may comprise a light emitting area and a non-light emitting area surrounding the light emitting area. The substrate 210 may be formed of an insulating material such as a glass substrate or a plastic substrate.

The pixel circuit layer 310 may be disposed on the substrate 210. The pixel circuit layer 310 may comprise various insulating layers 311, 312, 313, 314, and 315 and a thin film transistor 320.

The buffer layer 311 may be disposed on the substrate 210. The buffer layer 311 may be a single layer or multiple layers. The buffer layer 311 may serve to delay diffusion of moisture and/or oxygen penetrating into the substrate 210.

The thin film transistor 320 may be disposed on the buffer layer 311. The thin film transistor 320 may comprise an active layer 321, a gate electrode 322, a source electrode 323, and a drain electrode 324.

The active layer 321 may be disposed on the buffer layer 311. The active layer 321 may be composed of a silicon semiconductor, an oxide semiconductor, or an organic semiconductor.

The gate insulating layer 312 may be disposed on a portion of a top surface and a side surface of the active layer 321. The gate insulating layer 312 may also be disposed on the buffer layer 311. The gate insulating layer 312 may be formed of an inorganic insulating material.

The gate electrode 322 may be disposed on the gate insulating layer 312. The gate electrode 322 may comprise various conductive materials. For example, the gate electrode 322 may comprise a metal or an alloy, or may comprise a transparent conductive material. The gate electrode 322 may have a single-layer or multi-layer structure.

A region where the active layer 321 overlaps the gate electrode 322 may be a channel region of the thin film transistor 320, and a region where the active layer 321 does not overlap the gate electrode 322 may be a conductive region.

An interlayer insulating layer 313 may be disposed on the gate electrode 322. The interlayer insulating layer 313 may also be disposed on the gate insulating layer 312. The interlayer insulating layer 313 may be formed of an inorganic insulating material.

A source electrode 323 and a drain electrode 324 may be disposed on the interlayer insulating layer 313. The source electrode 323 and the drain electrode 324 may be electrically and physically connected to the conductive region of the active layer 321.

The source electrode 323 and the drain electrode 324 may be electrically and physically connected to the conductive region of the active layer 321, respectively, through contact holes penetrating the gate insulating layer 312 and the interlayer insulating layer 313.

Although FIG. 2 illustrates that the drain electrode 324 is connected to an anode electrode 341 of a light emitting element 340, the source electrode 323 may be connected to the anode electrode 341.

The source electrode 323 and the drain electrode 324 may each comprise various conductive materials. For example, the source electrode 323 and the drain electrode 324 may comprise a metal or an alloy, or may comprise a transparent conductive material. The source electrode 323 and the drain electrode 324 may have a single-layer or multi-layer structure.

A passivation layer 314 for insulating the thin film transistor 320 may be disposed on the source electrode 323 and the drain electrode 324. The passivation layer 314 may also be disposed on the interlayer insulating layer 313. The passivation layer 314 may be formed of an inorganic insulating material.

A planarization layer 315 may be disposed on the passivation layer 314. The planarization layer 315 may be formed of an organic insulating material. The planarization layer 315 may have a single-layer or multi-layer structure.

A pixel element layer 330 may be disposed on the planarization layer 315. The pixel element layer 330 may comprise the light emitting element 340 and a pixel define layer 331. The light emitting element 340 may comprise the anode electrode 341, a light emitting layer 342, and a cathode electrode 343.

The anode electrode 341 may be disposed on the planarization layer 315.

The anode electrode 341 may be electrically and physically connected to the drain electrode 324 of the thin film transistor 320 through a contact hole penetrating the planarization layer 315 and the passivation layer 314.

The pixel define layer 331 may be formed at boundaries of sub-pixel regions. The pixel define layer 331 may be formed on the planarization layer 315 to cover an edge of the anode electrode 341 in order to partition the sub-pixel regions. The pixel define layer 331 may be formed of an organic insulating material. The pixel define layer 331 may comprise a black material. When the pixel define layer 331 comprises a black material, both internal light and external light may be blocked.

The light emitting layer 342 may be formed on the anode electrode 341 and the pixel define layer 331. The light emitting layer 342 may cover the pixel define layer 331 and the anode electrode 341 not covered by the pixel define layer 331.

The light emitting layer 342 may emit any one of red light, green light, blue light, and white light. The light emitting layer 342 may be, for example, a white light emitting layer that emits white light. The light emitting layer 342 may be formed in a tandem structure in which two or more stacks are stacked.

The anode electrode 341 may be a reflective electrode comprising a metal material having a low work function and high reflection efficiency. The anode electrode 341 may comprise a reflective electrode and a transparent electrode disposed on the reflective electrode.

The cathode electrode 343 may be formed on the light emitting layer 342. The cathode electrode 343 may be a transmissive electrode. In addition, the cathode electrode 343 may be a semi-transmissive electrode. The cathode electrode 343 may be formed of a thin metal film having semi-transmissivity of light.

Although not shown, a capping layer may be disposed on the cathode electrode 343.

An encapsulation layer 350 may be disposed on the pixel element layer 330.

The encapsulation layer 350 may be disposed on the cathode electrode 343. The encapsulation layer may be a single layer or a multi-layer structure. The encapsulation layer 350 may be formed by alternately stacking a plurality of inorganic films and organic films.

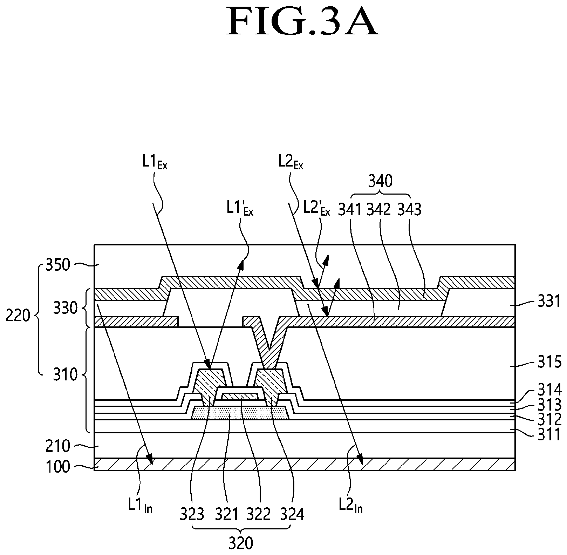

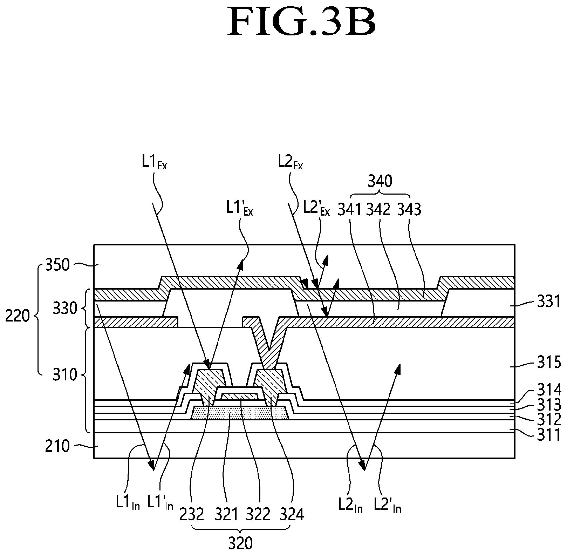

FIGS. 3A and 3B are exemplary views illustrating optical paths in a display device according to embodiments of the present disclosure and a display device according to a comparative example. FIG. 3A illustrates light paths of external light and internal light in a display device according to embodiments of the present disclosure, and FIG. 3B illustrates light paths of external light and internal light in a display device according to a comparative example.

Referring to FIG. 3A, a portion of first external light L1_{EX} incident on a pixel define layer 331 may be reflected by a metal layer comprising a thin film transistor 320 and emitted to the outside as emitted light L1'_{EX}. Further, a portion of second external light L2_{EX} incident on the light emitting layer 342 may be reflected by the anode electrode 341 and the cathode electrode 343 and emitted to the outside as emitted light L2'_{EX}.

In the case of a top emission type, internal light emitted from the light emitting layer 342 may be reflected by the anode electrode 341 and emitted toward a front direction of the display device, which is opposite to a direction of the substrate 210. Meanwhile, some internal light L1_{IN}, L2_{IN} may be directed toward the substrate 210. In this case, the first internal light L1_{IN} and the second internal light L2_{IN} may be shielded or absorbed by a protective layer 100 disposed below the substrate 210. The internal light rays L1_{IN} and L2_{IN} incident on the protective layer 100 may be absorbed thereby, or if reflected, may be scattered away from the light emitting layer 342, thereby helping to prevent color interference and oxidation of the electrode.

In contrast, referring to FIG. 3B, some internal light L1_{IN}, L2_{IN} emitted from the light emitting layer 342 and propagating toward the substrate 210 may be reflected from a lower portion of the substrate 210 and propagate to the light emitting layer 342. Such reflected light L1'_{IN}, L2'_{IN} may propagate to the light emitting layer 342 and interfere with light emitted from the light emitting layer 342, which may cause a color interference phenomenon. Further, there may be a problem in which oxidation of electrodes occurs due to light incident from the lower portion of the substrate 210.

According to embodiments of the present disclosure, the protective layer may have high adhesion and light shielding performance by comprising the first monomer, the second monomer, and the third monomer. Accordingly, color interference due to internal light and external light and oxidation of electrodes may be prevented, thereby improving reliability of the display device.

Further, the protective layer may prevent degradation of display performance by improving durability and reliability of the display device through enhanced adhesion.

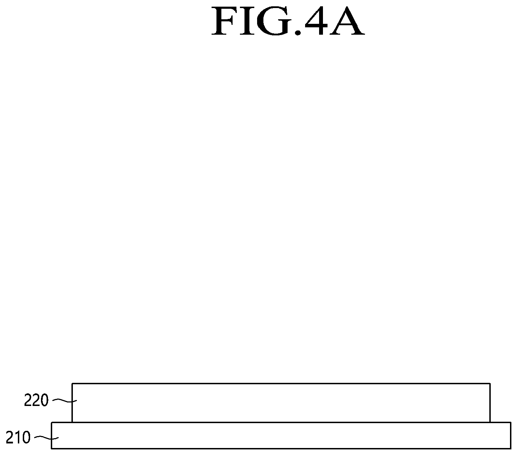

FIGS. 4A to 4D are exemplary process diagrams schematically illustrating manufacturing steps of a display device according to embodiments of the present disclosure.

A protective layer according to embodiments of the present disclosure may be formed by processing a protective layer composition, which is an ultraviolet (UV) curable ink composition, by an inkjet printing method. A method of forming the protective layer according to embodiments of the present disclosure may comprise a step of preparing a display panel or a substrate, a step of coating an ink composition comprising the protective layer composition, and a step of curing the coating layer.

Referring to FIG. 4A, first, a step of preparing a substrate 210 may be included. The substrate 210 may be surface-treated so that an ink composition may be easily coated thereon. Coating performance may be improved by surface-treating the substrate 210 according to surface energy of the substrate 210. For example, the substrate 210 may be surface-treated by cleaning, UV ozone, plasma, or the like. Meanwhile, the substrate 210 may be prepared in a display panel state in which a pixel array layer 220 is formed on one surface of the substrate 210.

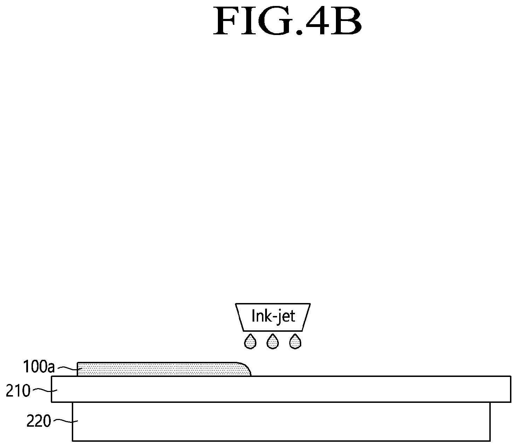

Referring to FIG. 4B, a coating layer 100a may be formed by coating an ink composition on the substrate 210. The coating layer 100a may be formed on the other surface of the substrate 210 on which the pixel array layer 220 is not disposed.

The coating layer 100a may be formed using an inkjet printing method. An ink composition comprising the protective layer composition may be prepared and supplied to an inkjet printer head, and the ink composition may be discharged such that a thickness of the coating layer is 1 to 100 µm. In this case, for stable discharge of the ink composition from the inkjet printer head, the ink composition may have a low viscosity of about 35 cP.

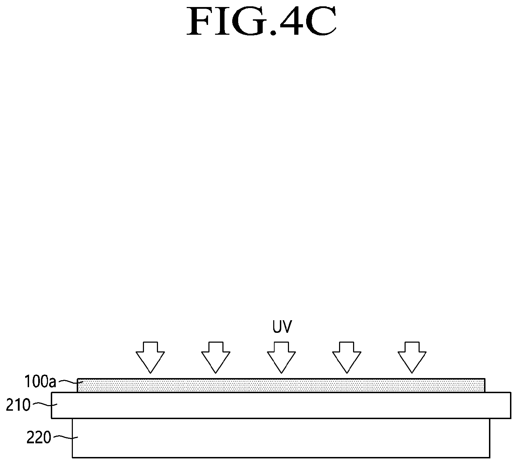

Referring to FIG. 4C, the coating layer 100a may be exposed to ultraviolet (UV) light to proceed with a curing process, thereby forming a protective layer. The UV light may be irradiated using a UV-LED light lamp. Considering spreadability of the ink composition, the UV curing process may be performed immediately after coating the ink composition.

For example, the UV curing process may be performed under conditions where a distance between the UV-LED light lamp and the coating layer is about 10 cm, an integrated light amount is about 3 J/cm², and a wavelength range is 250 to 400 nm.

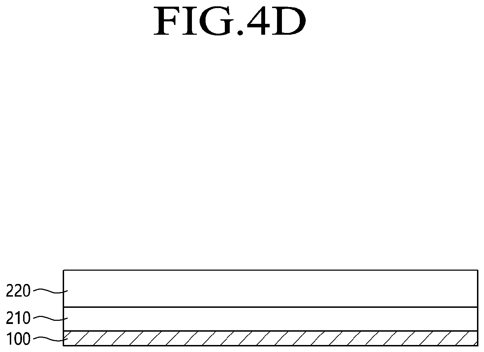

Referring to FIG. 4D, the substrate 210 having the protective layer 100 formed on the lower portion thereof may be cut into cell units. The substrate 210 may be cut into a plurality of cell units. The cutting process may be performed using a wheel or a laser.

Hereinafter, synthesis examples of compounds represented by the above formulas according to the present disclosure and examples using the same will be described in detail, but the present disclosure is not limited to the following synthesis examples and examples.

### [Synthesis Examples]

A compound represented by Formula 2 according to the present disclosure may be synthesized through reactions such as Reaction Schemes 1 to 14 below, but the compound represented by Formula 2 according to the present disclosure is not limited to being synthesized through such reaction schemes.

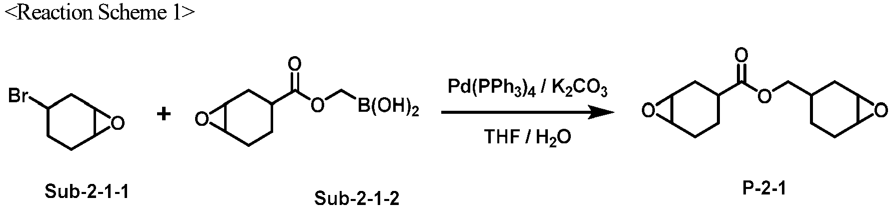

Sub-2-1-1 (3.78 g, 21.5 mmol) was dissolved in Tetrahydrofuran (THF) in a round-bottom flask, and then Sub-2-1-2 (4.41 g, 21 mmol), Pd(PPh₃)₄ (0.69 g, 0.6 mmol), K₂CO₃ (8.29 g, 60 mmol), and water were added thereto, followed by stirring at 80 °C. After the reaction was completed, the mixture was extracted with CH₂Cl₂ and water, and the organic layer was dried over MgSO₄ and concentrated. The resulting compound was purified by a silica gel column and recrystallized to obtain 3.65 g of the product.

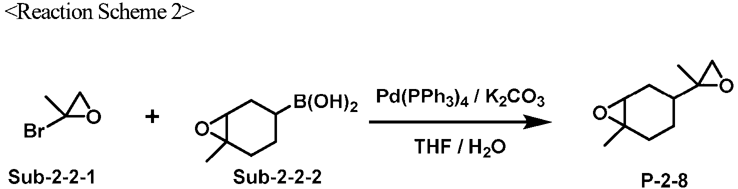

Sub-2-2-1 (2.72 g, 20 mmol) was dissolved in THF in a round-bottom flask, and then Sub-2-2-2 (3.12 g, 20 mmol), Pd(PPh₃)₄ (0.69 g, 0.6 mmol), K₂CO₃ (8.29 g, 60 mmol), and water were added thereto, followed by stirring at 80 °C. After the reaction was completed, the mixture was extracted with CH₂Cl₂ and water, and the organic layer was dried over MgSO₄ and concentrated. The resulting compound was purified by a silica gel column and recrystallized to obtain 2.65 g of the product.

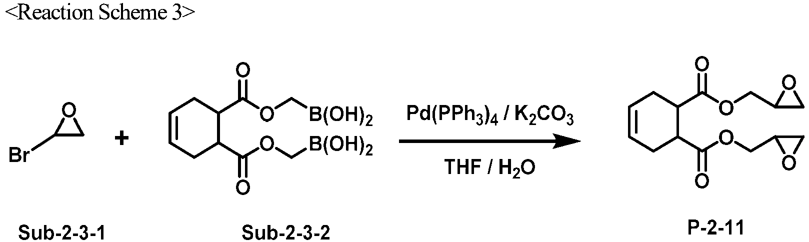

Sub-2-3-1 (5.36 g, 44 mmol) was dissolved in THF in a round-bottom flask, and then Sub-2-3-2 (5.72 g, 20 mmol), Pd(PPh₃)₄ (0.69 g, 0.6 mmol), K₂CO₃ (8.29 g, 60 mmol), and water were added thereto, followed by stirring at 80 °C. After the reaction was completed, the mixture was extracted with CH₂Cl₂ and water, and the organic layer was dried over MgSO₄ and concentrated. The resulting compound was purified by a silica gel column and recrystallized to obtain 4.51 g of the product.

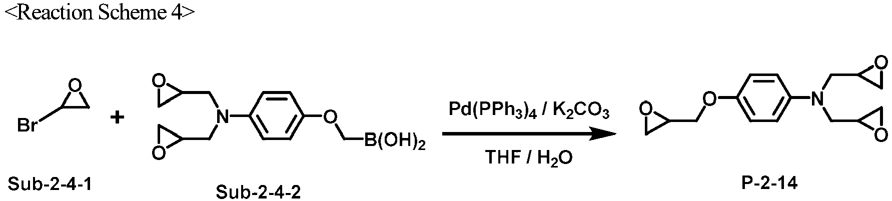

Sub-2-4-1 (2.56 g, 21 mmol) was dissolved in THF in a round-bottom flask, and then Sub-2-4-2 (5.63 g, 20.2 mmol), Pd(PPh₃)₄ (0.69 g, 0.6 mmol), K₂CO₃ (8.29 g, 60 mmol), and water were added thereto, followed by stirring at 80 °C. After the reaction was completed, the mixture was extracted with CH₂Cl₂ and water, and the organic layer was dried over MgSO₄ and concentrated. The resulting compound was purified by a silica gel column and recrystallized to obtain 4.43 g of the product.

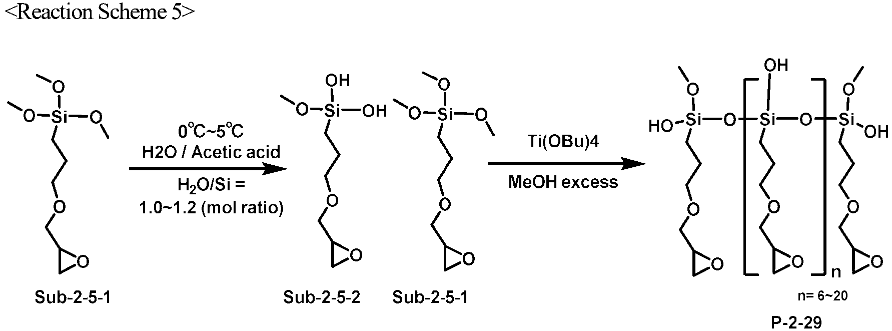

Sub-2-5-1 was dissolved in distilled water, acetic acid was added dropwise thereto, and the mixture was stirred while maintaining a low temperature of 0 to 5 °C and then distilled under reduced pressure at 30 °C or lower to obtain intermediate product Sub-2-5-2. The molar ratio of distilled water to Si was maintained at 1.0 to 1.2. Thereafter, Ti(OBu)₄ and MeOH were added to the intermediate product Sub-2-5-2 and Sub-2-5-1 to obtain the product.

The degree of polymerization (n) of the product may be controlled by adjusting the molar ratio of water to Si or by adding a catalyst.

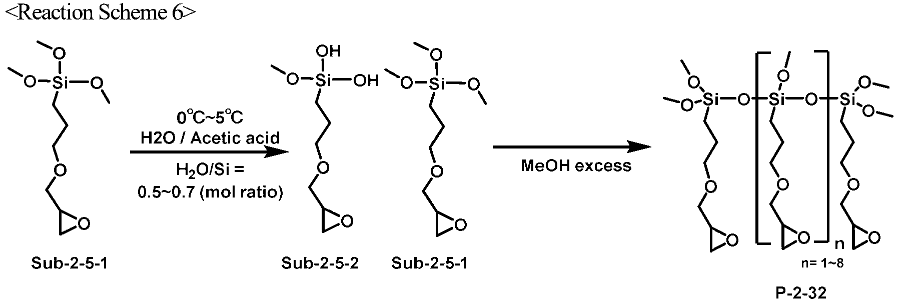

Sub-2-5-1 was dissolved in distilled water, acetic acid was added dropwise thereto, and the mixture was stirred while maintaining a low temperature of 0 to 5 °C and then distilled under reduced pressure at 30 °C or lower to obtain intermediate product Sub-2-5-2. The molar ratio of distilled water to Si was maintained at 0.5 to 0.7. Thereafter, MeOH was added to the intermediate product Sub-2-5-2 and Sub-2-5-1 to obtain the product.

The degree of polymerization (n) of the product may be controlled by adjusting the molar ratio of water to Si or by adding a catalyst.

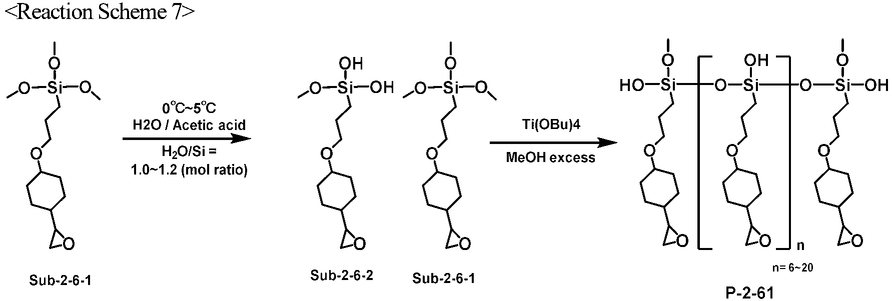

Sub-2-6-1 was dissolved in distilled water, acetic acid was added dropwise thereto, and the mixture was stirred while maintaining a low temperature of 0 to 5 °C and then distilled under reduced pressure at 30 °C or lower to obtain intermediate product Sub-2-6-2. The molar ratio of distilled water to Si was maintained at 1.0 to 1.2. Thereafter, Ti(OBu)₄ and MeOH were added to the intermediate product Sub-2-6-2 and Sub-2-6-1 to obtain the product.

The degree of polymerization (n) of the product may be controlled by adjusting the molar ratio of water to Si or by adding a catalyst.

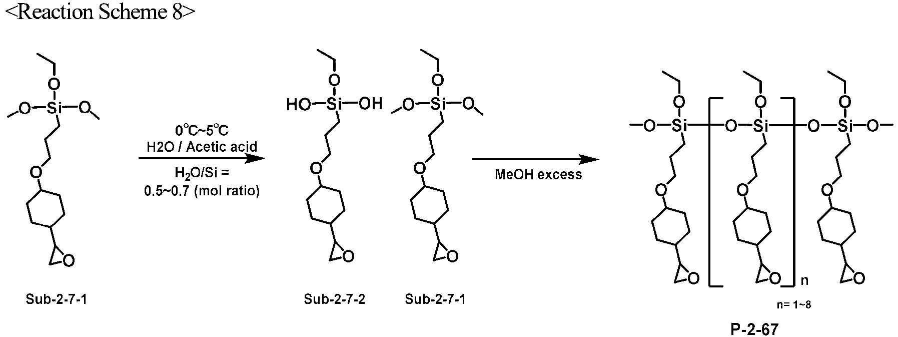

After dissolving Sub-2-7-1 in distilled water, acetic acid was added dropwise, and the mixture was stirred while maintaining a low temperature of 0 to 5 °C, followed by distillation under reduced pressure at 30 °C or lower to obtain intermediate product Sub-2-7-2. The molar ratio of distilled water to Si was maintained at 0.5 to 0.7. Thereafter, MeOH was added to Sub-2-7-2 and Sub-2-7-1 to obtain a product.

The degree of polymerization (n) of the product may be controlled by adjusting the molar ratio of water to Si or by adding a catalyst.

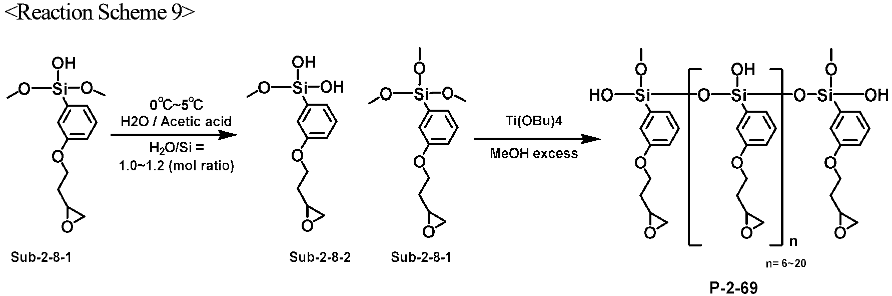

After dissolving Sub-2-8-1 in distilled water, acetic acid was added dropwise, and the mixture was stirred while maintaining a low temperature of 0 to 5 °C, followed by distillation under reduced pressure at 30 °C or lower to obtain intermediate product Sub-2-8-2. The molar ratio of distilled water to Si was maintained at 1.0 to 1.2. Thereafter, Ti(OBu)₄ and MeOH were added to Sub-2-8-2 and Sub-2-8-1 to obtain a product.

The degree of polymerization (n) of the product may be controlled by adjusting the molar ratio of water to Si or by adding a catalyst.

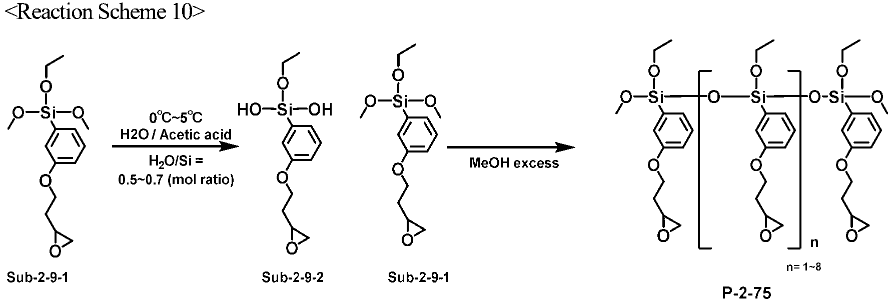

After dissolving Sub-2-9-1 in distilled water, acetic acid was added dropwise, and the mixture was stirred while maintaining a low temperature of 0 to 5 °C, followed by distillation under reduced pressure at 30 °C or lower to obtain intermediate product Sub-2-9-2. The molar ratio of distilled water to Si was maintained at 0.5 to 0.7. Thereafter, MeOH was added to Sub-2-9-2 and Sub-2-9-1 to obtain a product.

The degree of polymerization (n) of the product may be controlled by adjusting the molar ratio of water to Si or by adding a catalyst.

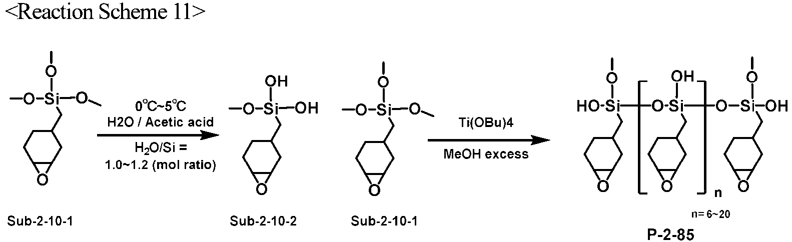

After dissolving Sub-2-10-1 in distilled water, acetic acid was added dropwise, and the mixture was stirred while maintaining a low temperature of 0 to 5 °C, followed by distillation under reduced pressure at 30 °C or lower to obtain intermediate product Sub-2-10-2. The molar ratio of distilled water to Si was maintained at 1.0 to 1.2. Thereafter, Ti(OBu)₄ and MeOH were added to Sub-2-10-2 and Sub-2-10-1 to obtain a product.

The degree of polymerization (n) of the product may be controlled by adjusting the molar ratio of water to Si or by adding a catalyst.

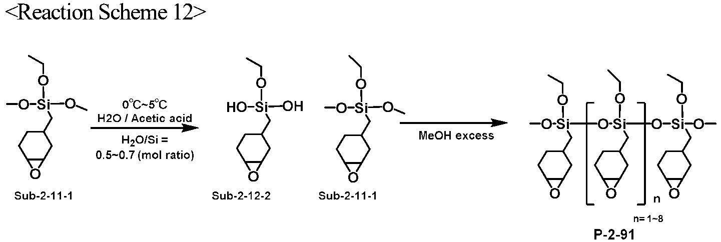

After dissolving Sub-2-11-1 in distilled water, acetic acid was added dropwise, and the mixture was stirred while maintaining a low temperature of 0 to 5 °C, followed by distillation under reduced pressure at 30 °C or lower to obtain intermediate product Sub-2-11-2. The molar ratio of distilled water to Si was maintained at 0.5 to 0.7. Thereafter, MeOH was added to Sub-2-11-2 and Sub-2-11-1 to obtain a product.

The degree of polymerization (n) of the product may be controlled by adjusting the molar ratio of water to Si or by adding a catalyst.

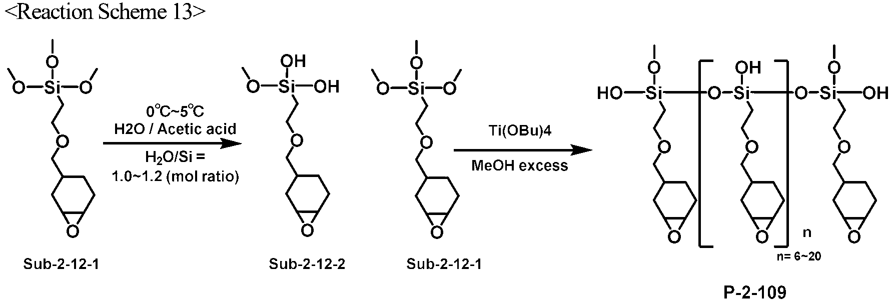

After dissolving Sub-2-12-1 in distilled water, acetic acid was added dropwise, and a low temperature of 0-5 °C was maintained, followed by stirring and vacuum distillation at 30 °C or less to obtain an intermediate product Sub-2-12-2. The molar ratio of the distilled water to Si was maintained at 1.0-1.2. Thereafter, Ti(OBu)₄ and MeOH were added to the Sub-2-12-2 and the Sub-2-12-1 to obtain a product.

The degree of polymerization (n) of the product may be controlled by adjusting the molar ratio of water to Si or by adding a catalyst.

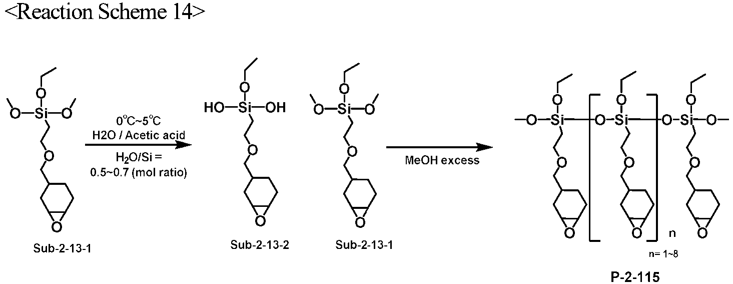

After dissolving Sub-2-13-1 in distilled water, acetic acid was added dropwise, and a low temperature of 0-5 °C was maintained, followed by stirring and vacuum distillation at 30 °C or less to obtain an intermediate product Sub-2-13-2. The molar ratio of the distilled water to Si was maintained at 0.5-0.7. Thereafter, MeOH was added to the Sub-2-13-2 and the Sub-2-13-1 to obtain a product.

The degree of polymerization (n) of the product may be controlled by adjusting the molar ratio of water to Si or by adding a catalyst.

A compound represented by Formula 3 according to the present disclosure may be synthesized through reactions such as Reaction Schemes 15 to 20, but a compound represented by Formula 3 according to the present disclosure is not limited to being synthesized through such reaction schemes.

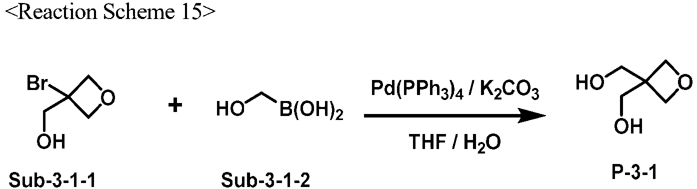

After dissolving Sub-3-1-1 (3.32 g, 20 mmol) in THF in a round-bottom flask, Sub-3-1-2 (1.52 g, 20 mmol), Pd(PPh₃)₄ (0.69 g, 0.6 mmol), K₂CO₃ (8.29 g, 60 mmol), and water were added, and the mixture was stirred at 80 °C. When the reaction was completed, the mixture was extracted with CH₂Cl₂ and water, and then an organic layer was dried with MgSO₄ and concentrated, and then a resulting compound was subjected to a silica gel column and recrystallization to obtain 1.95 g of a product.

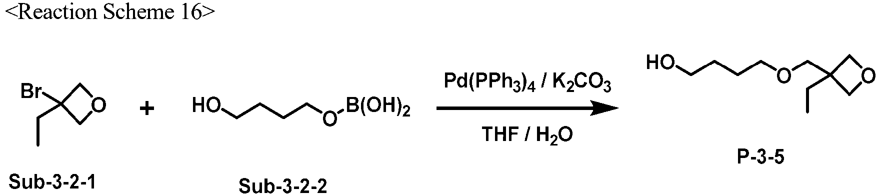

After dissolving Sub-3-2-1 (3.44 g, 21 mmol) in THF in a round-bottom flask, Sub-3-2-2 (2.71 g, 20.2 mmol), Pd(PPh₃)₄ (0.69 g, 0.6 mmol), K₂CO₃ (8.29 g, 60 mmol), and water were added, and the mixture was stirred at 80 °C. When the reaction was completed, the mixture was extracted with CH₂Cl₂ and water, and then an organic layer was dried with MgSO₄ and concentrated, and then a resulting compound was subjected to a silica gel column and recrystallization to obtain 2.91 g of a product.

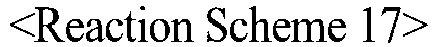

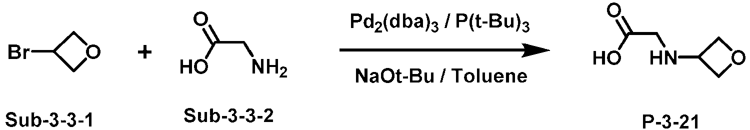

After dissolving Sub-3-3-1 (3.4 g, 25 mmol) in toluene in a round-bottom flask, Sub-3-3-2 (3.75 g, 50 mmol), Pd₂(dba)₃ (0.7 g, 0.8 mmol), 50% P(t-Bu)₃ (1ml, 2 mmol), and NaOt-Bu (7.34 g, 76.3 mmol) were added, and the mixture was stirred at 40 °C. When the reaction was completed, the mixture was extracted with CH₂Cl₂ and water, and then an organic layer was dried with MgSO₄ and concentrated, and then a resulting compound was subjected to a silica gel column and recrystallization to obtain 2.23 g of a product.

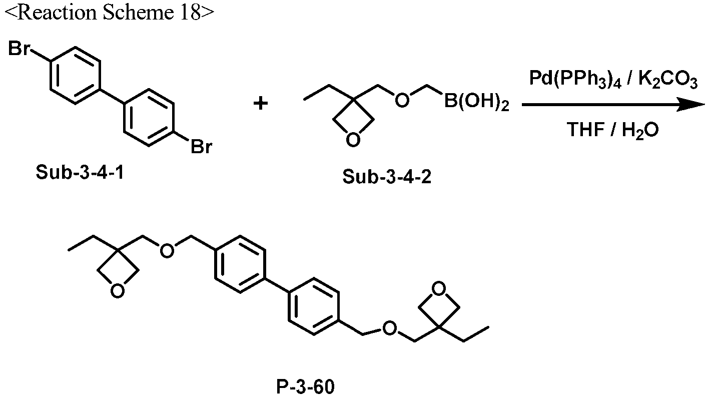

After dissolving Sub-3-4-1 (6.2 g, 20 mmol) in THF in a round-bottom flask, Sub-3-4-2 (7.65 g, 44 mmol), Pd(PPh₃)₄ (0.69 g, 0.6 mmol), K₂CO₃ (8.28 g, 59.9 mmol), and water were added, and the mixture was stirred at 80 °C. When the reaction was completed, the mixture was extracted with CH₂Cl₂ and water, and then an organic layer was dried with MgSO₄ and concentrated, and then a resulting compound was subjected to a silica gel column and recrystallization to obtain 6.15 g of a product.

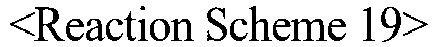

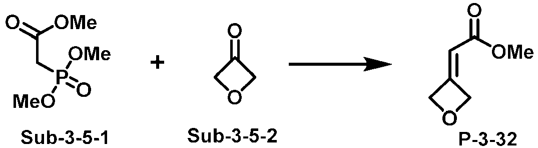

After introducing 25 mL of THF and 725 mg of NaH into a reactor purged with N₂ gas, the mixture was cooled to 0 °C. Sub-3-5-1 (5 g, 27.47 mmol) was diluted in 10 mL of THF, added dropwise while maintaining 0 °C, and stirred for 1 hour to form an enolate. Sub-3-5-2 (1.98 g, 27.5 mmol) was dissolved in THF and slowly added to the enolate solution, then the temperature was raised to 20-25 °C and stirred for 1 hour, then NH₄Cl was added at 0 °C to remove NaH, and the mixture was purified with ethyl acetate and vacuum distilled to obtain 2.94 g of a product.

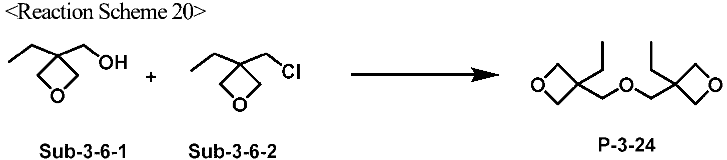

Sub-3-6-1 (3.13 g, 27 mmol) was dissolved in toluene in a round-bottom flask, and then the temperature was raised to 100 °C. Sub-3-6-2 (3.98 g, 29.7 mmol) and a 30 wt% NaOH aqueous solution (3.24 mL) were simultaneously added dropwise, and the mixture was maintained at that temperature for 3 hours. After the reaction was completed, the mixture was washed with water, toluene was recovered under reduced pressure, and then distillation was performed to obtain 4.34 g of a product.

### [Examples]

### 1. Preparation of Black Colorant

15 g of Carbon Black W-7016 (BASF), 8.5 g of Disperbyk 163 (BYK), and 6.5 g of SR-3613 (SMS) were dispersed together with 70 g of propylene glycol methyl ether acetate for 10 hours using a paint shaker (Asada) with 100 g of zirconia beads (Toray) having a diameter of 0.5 mm to obtain a dispersion.

### 2. Preparation of Composition

Compositions were prepared with the contents (wt%) as shown in Table 1 below.

**[Table 1]**

| | P-1 | P-2 | P-3 | P-4 | P-5 | P-6 | P-7 | P-8 | P-9 | P-10 |
|---|---|---|---|---|---|---|---|---|---|---|
| Black colorant | 10 | 10 | 10 | 10 | 10 | 10 | 10 | 10 | 10 | 10 |
| P-1-6 | 23.7 | 23.7 | 23.7 | 23.7 | 23.7 | 23.7 | 23.7 | 23.7 | 23.7 | 23.7 |
| P-2-19 | 22.78 | | | | | | | | | |
| P-2-18 | | 22.78 | | | | | | | | |
| P-2-10 | | | 22.78 | | | | | | | |
| P-2-16 | | | | 22.78 | | | | | | |
| P-2-29 | | | | | 22.78 | | | | | |
| P-2-30 | | | | | | 22.78 | | | | |
| P-2-31 | | | | | | | 22.78 | | | |
| P-2-32 | | | | | | | | 22.78 | | |
| P-2-33 | | | | | | | | | 22.78 | |
| P-2-34 | | | | | | | | | | 22.78 |
| P-3-2 | 22.02 | 22.02 | | | | | | | | |
| P-3-6 | | | 22.02 | 22.02 | | | | | | |
| P-3-7 | | | | | 22.02 | 22.02 | | | | |
| P-3-24 | | | | | | | 22.02 | 22.02 | 22.02 | |
| P-3-37 | | | | | | | | | | 22.02 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-11 | P-12 | P-13 | P-14 | P-15 | P-16 | P-17 | P-18 | P-19 | P-20 |
|---|---|---|---|---|---|---|---|---|---|---|
| Black colorant | 10 | 10 | 10 | 10 | 10 | 10 | 10 | 10 | 10 | 10 |
| P-1-6 | 23.7 | 23.7 | 23.7 | 23.7 | 23.7 | 23.7 | 23.7 | 23.7 | 23.7 | 23.7 |
| P-2-35 | 22.78 | | | | | | | | | |
| P-2-37 | | 22.78 | | | | | | | | |
| P-2-39 | | | 22.78 | | | | | | | |
| P-2-43 | | | | 22.78 | | | | | | |
| P-2-48 | | | | | 22.78 | | | | | |
| P-2-52 | | | | | | 22.78 | | | | |
| P-2-58 | | | | | | | 22.78 | | | |
| P-2-63 | | | | | | | | 22.78 | | |
| P-2-69 | | | | | | | | | 22.78 | |
| P-2-75 | | | | | | | | | | 22.78 |
| P-3-37 | 22.02 | 22.02 | | | | | | | | |
| P-3-44 | | | 22.02 | 22.02 | | | | | | |
| P-3-58 | | | | | 22.02 | 22.02 | 22.02 | | | |
| P-3-59 | | | | | | | | 22.02 | 22.02 | 22.02 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-21 | P-22 | P-23 | P-24 | P-25 | P-26 | P-27 | P-28 | P-29 | P-30 |
|---|---|---|---|---|---|---|---|---|---|---|
| Black colorant | 10 | 10 | 10 | 10 | 10 | 10 | 10 | 10 | 10 | 10 |
| P-1-6 | 23.7 | 23.7 | 23.7 | 23.7 | 23.7 | 23.7 | 23.7 | 23.7 | 23.7 | 23.7 |
| P-2-81 | 22.78 | | | | | | | | | |
| P-2-86 | | 22.78 | | | | | | | | |
| P-2-92 | | | 22.78 | | | | | | | |
| P-2-98 | | | | 22.78 | | | | | | |
| P-2-105 | | | | | 22.78 | | | | | |
| P-2-112 | | | | | | 22.78 | | | | |
| P-2-119 | | | | | | | 22.78 | | | |
| P-2-123 | | | | | | | | 22.78 | | |
| P-2-128 | | | | | | | | | 22.78 | |
| P-2-133 | | | | | | | | | | 22.78 |
| P-3-63 | 22.02 | 22.02 | 22.02 | | | | | | | |
| P-3-64 | | | | 22.02 | 22.02 | 22.02 | | | | |
| P-3-67 | | | | | | | 22.02 | 22.02 | 22.02 | |
| P-3-68 | | | | | | | | | | 22.02 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-31 | P-32 | P-33 | P-34 | P-35 | P-36 | P-37 | P-38 | P-39 | P-40 |
|---|---|---|---|---|---|---|---|---|---|---|
| Black colorant | 10 | 10 | 10 | 10 | 10 | 10 | 10 | 10 | 10 | 10 |
| P-1-6 | 23.7 | 24.04 | 24.04 | 24.04 | 24.04 | 24.04 | 24.04 | 24.04 | 24.04 | 24.04 |
| P-2-19 | | 20 | | | | | | | | |
| P-2-18 | | | 20 | | | | | | | |
| P-2-10 | | | | 20 | | | | | | |
| P-2-16 | | | | | 20 | | | | | |
| P-2-29 | | | | | | 20 | | | | |
| P-2-30 | | | | | | | 20 | | | |
| P-2-31 | | | | | | | | 20 | | |
| P-2-32 | | | | | | | | | 20 | |
| P-2-33 | | | | | | | | | | 20 |
| P-2-138 | 22.78 | | | | | | | | | |
| P-3-2 | | 24.46 | 24.46 | | | | | | | |
| P-3-6 | | | | 24.46 | 24.46 | | | | | |
| P-3-7 | | | | | | 24.46 | 24.46 | | | |
| P-3-24 | | | | | | | | 24.46 | 24.46 | 24.46 |
| P-3-68 | 22.02 | | | | | | | | | |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-41 | P-42 | P-43 | P-44 | P-45 | P-46 | P-47 | P-48 | P-49 | P-50 |
|---|---|---|---|---|---|---|---|---|---|---|
| Black colorant | 10 | 10 | 10 | 10 | 10 | 10 | 10 | 10 | 10 | 10 |
| P-1-6 | 24.04 | 24.04 | 24.04 | 24.04 | 24.04 | 24.04 | 24.04 | 24.04 | 24.04 | 24.04 |
| P-2-34 | 20 | | | | | | | | | |
| P-2-35 | | 20 | | | | | | | | |
| P-2-37 | | | 20 | | | | | | | |
| P-2-39 | | | | 20 | | | | | | |
| P-2-43 | | | | | 20 | | | | | |
| P-2-48 | | | | | | 20 | | | | |
| P-2-52 | | | | | | | 20 | | | |
| P-2-58 | | | | | | | | 20 | | |
| P-2-63 | | | | | | | | | 20 | |
| P-2-69 | | | | | | | | | | 20 |
| P-3-37 | 24.46 | 24.46 | 24.46 | | | | | | | |
| P-3-44 | | | | 24.46 | 24.46 | | | | | |
| P-3-58 | | | | | | 24.46 | 24.46 | 24.46 | | |
| P-3-59 | | | | | | | | | 24.46 | 24.46 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-51 | P-52 | P-53 | P-54 | P-55 | P-56 | P-57 | P-58 | P-59 | P-60 |
|---|---|---|---|---|---|---|---|---|---|---|
| Black colorant | 10 | 10 | 10 | 10 | 10 | 10 | 10 | 10 | 10 | 10 |
| P-1-6 | 24.04 | 24.04 | 24.04 | 24.04 | 24.04 | 24.04 | 24.04 | 24.04 | 24.04 | 24.04 |
| P-2-75 | 20 | | | | | | | | | |
| P-2-81 | | 20 | | | | | | | | |
| P-2-86 | | | 20 | | | | | | | |
| P-2-92 | | | | 20 | | | | | | |
| P-2-98 | | | | | 20 | | | | | |
| P-2-105 | | | | | | 20 | | | | |
| P-2-112 | | | | | | | 20 | | | |
| P-2-119 | | | | | | | | 20 | | |
| P-2-123 | | | | | | | | | 20 | |
| P-2-128 | | | | | | | | | | 20 |
| P-3-59 | 24.46 | | | | | | | | | |
| P-3-63 | | 24.46 | 24.46 | 24.46 | | | | | | |
| P-3-64 | | | | | 24.46 | 24.46 | 24.46 | | | |
| P-3-67 | | | | | | | | 24.46 | 24.46 | 24.46 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-61 | P-62 | P-63 | P-64 | P-65 | P-66 | P-67 | P-68 | P-69 | P-70 |
|---|---|---|---|---|---|---|---|---|---|---|
| Black colorant | 10 | 10 | 10 | 10 | 10 | 10 | 10 | 10 | 10 | 10 |
| P-1-6 | 24.04 | 24.04 | 24.00 | 24.00 | 24.00 | 24.00 | 24.00 | 24.00 | 24.00 | 24.00 |
| P-2-19 | | | 21.50 | | | | | | | |
| P-2-18 | | | | 21.50 | | | | | | |
| P-2-10 | | | | | 21.50 | | | | | |
| P-2-16 | | | | | | 21.50 | | | | |
| P-2-29 | | | | | | | 21.50 | | | |
| P-2-30 | | | | | | | | 21.50 | | |
| P-2-31 | | | | | | | | | 21.50 | |
| P-2-32 | | | | | | | | | | 21.50 |
| P-2-133 | 20 | | | | | | | | | |
| P-2-138 | | 20 | | | | | | | | |
| P-3-2 | | | 23 | 23 | | | | | | |
| P-3-6 | | | | | 23 | 23 | | | | |
| P-3-7 | | | | | | | 23 | 23 | | |
| P-3-24 | | | | | | | | | 23 | 23 |
| P-3-68 | 24.46 | 24.46 | | | | | | | | |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-71 | P-72 | P-73 | P-74 | P-75 | P-76 | P-77 | P-78 | P-79 | P-80 |
|---|---|---|---|---|---|---|---|---|---|---|
| Black colorant | 10 | 10 | 10 | 10 | 10 | 10 | 10 | 10 | 10 | 10 |
| P-1-6 | 24.00 | 24.00 | 24.00 | 24.00 | 24.00 | 24.00 | 24.00 | 24.00 | 24.00 | 24.00 |
| P-2-33 | 21.50 | | | | | | | | | |
| P-2-34 | | 21.50 | | | | | | | | |
| P-2-35 | | | 21.50 | | | | | | | |
| P-2-37 | | | | 21.50 | | | | | | |
| P-2-39 | | | | | 21.50 | | | | | |
| P-2-43 | | | | | | 21.50 | | | | |
| P-2-48 | | | | | | | 21.50 | | | |
| P-2-52 | | | | | | | | 21.50 | | |
| P-2-58 | | | | | | | | | 21.50 | |
| P-2-63 | | | | | | | | | | 21.50 |
| P-3-24 | 23 | | | | | | | | | |
| P-3-37 | | 23 | 23 | 23 | | | | | | |
| P-3-44 | | | | | 23 | 23 | | | | |
| P-3-58 | | | | | | | 23 | 23 | 23 | |
| P-3-59 | | | | | | | | | | 23 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-81 | P-82 | P-83 | P-84 | P-85 | P-86 | P-87 | P-88 | P-89 | P-90 |
|---|---|---|---|---|---|---|---|---|---|---|
| Black colorant | 10 | 10 | 10 | 10 | 10 | 10 | 10 | 10 | 10 | 10 |
| P-1-6 | 24.00 | 24.00 | 24.00 | 24.00 | 24.00 | 24.00 | 24.00 | 24.00 | 24.00 | 24.00 |
| P-2-69 | 21.50 | | | | | | | | | |
| P-2-75 | | 21.50 | | | | | | | | |
| P-2-81 | | | 21.50 | | | | | | | |
| P-2-86 | | | | 21.50 | | | | | | |
| P-2-92 | | | | | 21.50 | | | | | |
| P-2-98 | | | | | | 21.50 | | | | |
| P-2-105 | | | | | | | 21.50 | | | |
| P-2-112 | | | | | | | | 21.50 | | |
| P-2-119 | | | | | | | | | 21.50 | |
| P-2-123 | | | | | | | | | | 21.50 |
| P-3-59 | 23 | 23 | | | | | | | | |
| P-3-63 | | | 23 | 23 | 23 | | | | | |
| P-3-64 | | | | | | 23 | 23 | 23 | | |
| P-3-67 | | | | | | | | | 23 | 23 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-91 | P-92 | P-93 | P-94 | P-95 | P-96 | P-97 | P-98 | P-99 | P-100 |
|---|---|---|---|---|---|---|---|---|---|---|
| Black colorant | 10 | 10 | 10 | 10 | 10 | 10 | 10 | 10 | 10 | 10 |
| P-1-6 | 24.00 | 24.00 | 24.00 | 25 | 25 | 25 | 25 | 25 | 25 | 25 |
| P-2-19 | | | | 21.8 | | | | | | |
| P-2-18 | | | | | 21.8 | | | | | |
| P-2-10 | | | | | | 21.8 | | | | |
| P-2-16 | | | | | | | 21.8 | | | |
| P-2-29 | | | | | | | | 21.8 | | |
| P-2-30 | | | | | | | | | 21.8 | |
| P-2-31 | | | | | | | | | | 21.8 |
| P-2-128 | 21.50 | | | | | | | | | |
| P-2-133 | | 21.50 | | | | | | | | |
| P-2-138 | | | 21.50 | | | | | | | |
| P-3-2 | | | | 21.7 | | | | | | |
| P-3-6 | | | | | 21.7 | 21.7 | 21.7 | | | |
| P-3-7 | | | | | | | | 21.7 | 21.7 | |
| P-3-24 | | | | | | | | | | 21.7 |
| P-3-67 | 23 | | | | | | | | | |
| P-3-68 | | 23 | 23 | | | | | | | |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-101 | P-102 | P-103 | P-104 | P-105 | P-106 | P-107 | P-108 | P-109 | P-110 |
|---|---|---|---|---|---|---|---|---|---|---|
| Black colorant | 10 | 10 | 10 | 10 | 10 | 10 | 10 | 10 | 10 | 10 |
| P-1-6 | 25 | 25 | 25 | 25 | 25 | 25 | 25 | 25 | 25.8 | 25.8 |
| P-2-32 | 21.8 | | | | | | | | | |
| P-2-33 | | 21.8 | | | | | | | | |
| P-2-34 | | | 21.8 | | | | | | | |
| P-2-35 | | | | 21.8 | | | | | | |
| P-2-37 | | | | | 21.8 | | | | | |
| P-2-39 | | | | | | 21.8 | | | | |
| P-2-43 | | | | | | | 21.8 | | | |
| P-2-48 | | | | | | | | 21.8 | | |
| P-2-52 | | | | | | | | | 18.2 | |
| P-2-58 | | | | | | | | | | 18.2 |
| P-3-24 | 21.7 | 21.7 | | | | | | | | |
| P-3-37 | | | 21.7 | 21.7 | 21.7 | | | | | |
| P-3-44 | | | | | | 21.7 | 21.7 | | | |
| P-3-58 | | | | | | | | 21.7 | 24.5 | 24.5 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |
| | P-111 | P-112 | P-113 | P-114 | P-115 | P-116 | P-117 | P-118 | P-119 | P-120 |
| Black colorant | 10 | 10 | 10 | 10 | 10 | 10 | 10 | 10 | 10 | 10 |
| P-1-6 | 25.8 | 25.8 | 25.8 | 25.8 | 25.8 | 25.8 | 25.8 | 25.8 | 25.8 | 25.8 |
| P-2-63 | 18.2 | | | | | | | | | |
| P-2-69 | | 18.2 | | | | | | | | |
| P-2-75 | | | 18.2 | | | | | | | |
| P-2-81 | | | | 18.2 | | | | | | |
| P-2-86 | | | | | 18.2 | | | | | |
| P-2-92 | | | | | | 18.2 | | | | |
| P-2-98 | | | | | | | 18.2 | | | |
| P-2-105 | | | | | | | | 18.2 | | |
| P-2-112 | | | | | | | | | 18.2 | |
| P-2-119 | | | | | | | | | | 18.2 |
| P-3-59 | 24.5 | 24.5 | 24.5 | | | | | | | |
| P-3-63 | | | | 24.5 | 24.5 | 24.5 | | | | |
| P-3-64 | | | | | | | 24.5 | 24.5 | 24.5 | |
| P-3-67 | | | | | | | | | | 24.5 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-121 | P-122 | P-123 | P-124 | P-125 | P-126 | P-127 | P-128 | P-129 | P-130 |
|---|---|---|---|---|---|---|---|---|---|---|
| Black colorant | 10 | 10 | 10 | 10 | 10 | 10 | 10 | 10 | 10 | 10 |
| P-1-6 | 25.8 | 25.8 | 25.8 | 25.8 | 26.6 | 26.6 | 26.6 | 26.6 | 26.6 | 26.6 |
| P-2-19 | | | | | 20.2 | | | | | |
| P-2-18 | | | | | | 20.2 | | | | |
| P-2-10 | | | | | | | 20.2 | | | |
| P-2-16 | | | | | | | | 20.2 | | |
| P-2-29 | | | | | | | | | 20.2 | |
| P-2-30 | | | | | | | | | | 20.2 |
| P-2-123 | 18.2 | | | | | | | | | |
| P-2-128 | | 18.2 | | | | | | | | |
| P-2-133 | | | 18.2 | | | | | | | |
| P-2-138 | | | | 18.2 | | | | | | |
| P-3-2 | | | | | 21.7 | 21.7 | | | | |
| P-3-6 | | | | | | | 21.7 | 21.7 | | |
| P-3-7 | | | | | | | | | 21.7 | 21.7 |
| P-3-67 | 24.5 | 24.5 | | | | | | | | |
| P-3-68 | | | 24.5 | 24.5 | | | | | | |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-131 | P-132 | P-133 | P-134 | P-135 | P-136 | P-137 | P-138 | P-139 | P-140 |
|---|---|---|---|---|---|---|---|---|---|---|
| Black colorant | 10 | 10 | 10 | 10 | 10 | 10 | 10 | 10 | 10 | 10 |
| P-1-6 | 26.6 | 26.6 | 26.6 | 26.6 | 26.6 | 26.6 | 26.6 | 26.6 | 26.6 | 24.5 |
| P-2-31 | 20.2 | | | | | | | | | |
| P-2-32 | | 20.2 | | | | | | | | |
| P-2-33 | | | 20.2 | | | | | | | |
| P-2-34 | | | | 20.2 | | | | | | |
| P-2-35 | | | | | 20.2 | | | | | |
| P-2-37 | | | | | | 20.2 | | | | |
| P-2-39 | | | | | | | 20.2 | | | |
| P-2-43 | | | | | | | | 20.2 | | |
| P-2-48 | | | | | | | | | 20.2 | |
| P-2-52 | | | | | | | | | | 23.8 |
| P-3-24 | 21.7 | 21.7 | 21.7 | | | | | | | |
| P-3-37 | | | | 21.7 | 21.7 | 21.7 | | | | |
| P-3-44 | | | | | | | 21.7 | 21.7 | | |
| P-3-58 | | | | | | | | | 21.7 | 20.2 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-141 | P-142 | P-143 | P-144 | P-145 | P-146 | P-147 | P-148 | P-149 | P-150 |
|---|---|---|---|---|---|---|---|---|---|---|
| Black colorant | 10 | 10 | 10 | 10 | 10 | 10 | 10 | 10 | 10 | 10 |
| P-1-6 | 24.5 | 24.5 | 24.5 | 24.5 | 24.5 | 24.5 | 24.5 | 23.1 | 23.1 | 23.1 |
| P-2-58 | 23.8 | | | | | | | | | |
| P-2-63 | | 23.8 | | | | | | | | |
| P-2-69 | | | 23.8 | | | | | | | |
| P-2-75 | | | | 23.8 | | | | | | |
| P-2-81 | | | | | 23.8 | | | | | |
| P-2-86 | | | | | | 23.8 | | | | |
| P-2-92 | | | | | | | 23.8 | | | |
| P-2-98 | | | | | | | | 25.4 | | |
| P-2-105 | | | | | | | | | 25.4 | |
| P-2-112 | | | | | | | | | | 25.4 |
| P-3-58 | 20.2 | | | | | | | | | |
| P-3-59 | | 20.2 | 20.2 | 20.2 | | | | | | |
| P-3-63 | | | | | 20.2 | 20.2 | 20.2 | | | |
| P-3-64 | | | | | | | | 20 | 20 | 20 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-151 | P-152 | P-153 | P-154 | P-155 | P-156 | P-157 | P-158 | P-159 | P-160 |
|---|---|---|---|---|---|---|---|---|---|---|
| Black colorant | 10 | 10 | 10 | 10 | 10 | 10 | 10 | 10 | 10 | 10 |
| P-1-6 | 23.1 | 23.1 | 23.1 | 23.1 | 23.1 | | | | | |
| P-1-12 | | | | | | 24.04 | 24.04 | | | |
| P-1-18 | | | | | | | | 24.04 | 24.04 | |
| P-1-24 | | | | | | | | | | 24.04 |
| P-2-30 | | | | | | 20 | | 20 | | 20 |
| P-2-119 | 25.4 | | | | | | 20 | | 20 | |
| P-2-123 | | 25.4 | | | | | | | | |
| P-2-128 | | | 25.4 | | | | | | | |
| P-2-133 | | | | 25.4 | | | | | | |
| P-2-138 | | | | | 25.4 | | | | | |
| P-3-2 | | | | | | 24.46 | 24.46 | 24.46 | 24.46 | 24.46 |
| P-3-67 | 20 | 20 | 20 | | | | | | | |
| P-3-68 | | | | 20 | 20 | | | | | |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-161 | P-162 | P-163 | P-164 | P-165 | P-166 | P-167 | P-168 | P-169 | P-170 |
|---|---|---|---|---|---|---|---|---|---|---|
| Black colorant | 10 | 10 | 10 | 10 | 10 | 10 | 10 | 10 | 10 | 10 |
| P-1-12 | | | | | | 24.04 | 24.04 | | | |
| P-1-18 | | | | | | | | 24.04 | 24.04 | |
| P-1-24 | 24.04 | | | | | | | | | 24.04 |
| P-1-33 | | 24.04 | 24.04 | | | | | | | |
| P-1-35 | | | | 24.04 | 24.04 | | | | | |
| P-2-30 | 20 | 20 | | 20 | | 20 | | 20 | | |
| P-2-39 | | | 20 | | 20 | | 20 | | 20 | 20 |
| P-3-24 | 24.46 | 24.46 | 24.46 | 24.46 | 24.46 | | | | | |
| P-3-37 | | | | | | | | | | |
| P-3-44 | | | | | | 24.46 | 24.46 | 24.46 | 24.46 | 24.46 |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-171 | P-172 | P-173 | P-174 | P-175 | P-176 | P-177 | P-178 | P-179 | P-180 |
|---|---|---|---|---|---|---|---|---|---|---|
| Black colorant | 10 | 10 | 10 | 10 | 10 | 10 | 10 | 10 | 10 | 10 |
| P-1-18 | | | | | | | | | | 24.04 |
| P-1-24 | 24.04 | | | | | | | 24.04 | 24.04 | |
| P-1-33 | | 24.04 | 24.04 | | | | | | | |
| P-1-35 | | | | 24.04 | 24.04 | 24.04 | 24.04 | | | |
| P-2-19 | | | | | | | | | | |
| P-2-39 | | 20 | | 20 | 20 | | | | | 20 |
| P-2-58 | 20 | | 20 | | | 20 | 20 | | | |
| P-2-112 | | | | | | | | 20 | 20 | |
| P-3-24 | | | | 24.46 | | 24.46 | | 24.46 | | 24.46 |
| P-3-63 | 24.46 | 24.46 | 24.46 | | 24.46 | | 24.46 | | 24.46 | |
| Initiator TPO | 5 | 5 | 5 | 5 | 5 | 5 | 5 | 5 | 5 | 5 |
| Initiator NIT | 15 | 15 | 15 | 15 | 15 | 15 | 15 | 15 | 15 | 15 |
| Adhesion promoter KBM-403 (SHINETUS Corp.) | 1.5 | 1.5 | 1.5 | 1.5 | 1.5 | 1.5 | 1.5 | 1.5 | 1.5 | 1.5 |

| | P-181 | P-182 | P-183 | P-184 | | | | | | |
|---|---|---|---|---|---|---|---|---|---|---|
| Black colorant | 10 | 10 | 10 | 10 | | | | | | |
| P-1-18 | 24.04 | | 33.5 | 33.5 | | | | | | |
| P-2-19 | 20 | 30 | | 35 | | | | | | |
| P-3-2 | | 38.5 | | | | | | | | |
| P-3-24 | | | 35 | | | | | | | |
| P-3-63 | 24.46 | | | | | | | | | |
| Initiator TPO | 5 | 5 | 5 | 5 | | | | | | |
| Initiator NIT | 15 | 15 | 15 | 15 | | | | | | |
| Adhesion promoter KBM-403 (SHINETUS Corp.) | 1.5 | 1.5 | 1.5 | 1.5 | | | | | | |

### 3. Preparation of Protective Layer

### (1) Substrate preparation step

A 100 x 100 mm bare glass substrate was prepared, and cleaning of the substrate was performed by conducting UV ozone treatment and plasma treatment.

### (2) Ink composition application step

The compositions P-1 to P-184 prepared in Table 1 were supplied to a KM 1024 inkjet printer head of KONICA MINOLTA, and the ink compositions were discharged such that a film application thickness was 1 to 100 µm.

### (3) Exposure step

The ink composition applied to the substrate was subjected to a UV curing process using a UV-LED light lamp of Phoseon Technology at a wavelength of 250 to 400 nm under conditions of a distance between the lamp and an ink coating surface of about 10 cm and an integrated light amount of about 3 J/cm² to prepare a protective layer.

### 4. Evaluation of Adhesion to Substrate

Adhesion of the protective layer prepared in the above-described protective layer preparation process was measured through cross-cut evaluation in accordance with the ASTM D3359 standard. A crosshatch pattern was made on the coating film surface at 1.5 mm intervals in both horizontal and vertical directions using an 11-blade cutter, and then an adhesive tape was attached to the grid surface and peeled off. The degree of peeling of the coating surface was measured and evaluated according to the following criteria, and the results are summarized in Table 2.

It is preferable that the adhesion be 4B or 5B, and the results are summarized in Table 2.

### <Cross-cut Evaluation Criteria (ASTM D3359)>

5B: Peeled cross-cut area of 0%
4B: Peeled cross-cut area within 5%
3B: Peeled cross-cut area within 5 to 15%
2B: Peeled cross-cut area within 15 to 35%
1B: Peeled cross-cut area within 35 to 65%
0B: Peeled cross-cut area of 65% or more

### 5. Evaluation of Hardness

The hardness of the protective layer was evaluated using a pencil hardness test method (KS M ISO 15184 test standard). A pencil for measuring hardness was selected, the pencil was held upright and abraded against sandpaper to make it flat, and then the pencil was fixed using a pencil hardness tester. After fixing the protective layer prepared in the process 2 on a stage, the pencil to be tested was fixed at an angle of 45 degrees, the test was performed under a load of 750 g at a speed of 100 mm/min, and upon visual inspection of the specimen surface, the measurement was repeated with pencils of increasing hardness until scratch damage was observed on the surface.

Accordingly, the hardness of each protective layer was evaluated and summarized in Table 2.

### <Hardness Evaluation Criteria>

The hardness is preferably 1H or higher, according to the scale: (Soft) B < HB < 1H < 2H (Hard).

**[Table 2]**

| | **Composition** | **Adhesion** | **Hardness** | | **Composition** | **Adhesion** | **Hardness** |
|---|---|---|---|---|---|---|---|
| Comparative Example 1 | P-182 | 0B | 1H | Example 90 | P-90 | 5B | 1H |
| Comparative | P-183 | 4B | HB | Example 91 | P-91 | 5B | 2H |
| Example 2 | | | | | | | |
| Comparative Example 3 | P-184 | 5B | B | Example 92 | P-92 | 5B | 2H |
| Example 1 | P-1 | 5B | 1H | Example 93 | P-93 | 5B | 2H |
| Example 2 | P-2 | 5B | 1H | Example 94 | P-94 | 5B | 2H |
| Example 3 | P-3 | 5B | 2H | Example 95 | P-95 | 5B | 2H |
| Example 4 | P-4 | 5B | 1H | Example 96 | P-96 | 5B | 2H |
| Example 5 | P-5 | 5B | 1H | Example 97 | P-97 | 5B | 1H |
| Example 6 | P-6 | 5B | 1H | Example 98 | P-98 | 5B | 2H |
| Example 7 | P-7 | 5B | 2H | Example 99 | P-99 | 5B | 2H |
| Example 8 | P-8 | 5B | 2H | Example 100 | P-100 | 5B | 1H |
| Example 9 | P-9 | 5B | 2H | Example 101 | P-101 | 5B | 2H |
| Example 10 | P-10 | 5B | 1H | Example 102 | P-102 | 5B | 2H |
| Example 11 | P-11 | 5B | 2H | Example 103 | P-103 | 5B | 2H |
| Example 12 | P-12 | 5B | 2H | Example 104 | P-104 | 5B | 2H |
| Example 13 | P-13 | 5B | 1H | Example 105 | P-105 | 5B | 1H |
| Example 14 | P-14 | 5B | 1H | Example 106 | P-106 | 5B | 2H |
| Example 15 | P-15 | 5B | 2H | Example 107 | P-107 | 5B | 2H |
| Example 16 | P-16 | 5B | 2H | Example 108 | P-108 | 5B | 2H |
| Example 17 | P-17 | 5B | 2H | Example 109 | P-109 | 5B | 2H |
| Example 18 | P-18 | 5B | 1H | Example 110 | P-110 | 5B | 1H |
| Example 19 | P-19 | 5B | 2H | Example 111 | P-111 | 5B | 2H |
| Example 20 | P-20 | 5B | 1H | Example 112 | P-112 | 5B | 2H |
| Example 21 | P-21 | 5B | 1H | Example 113 | P-113 | 5B | 2H |
| Example 22 | P-22 | 5B | 1H | Example 114 | P-114 | 5B | 2H |
| Example 23 | P-23 | 5B | 1H | Example 115 | P-115 | 5B | 1H |
| Example 24 | P-24 | 5B | 1H | Example 116 | P-116 | 5B | 2H |
| Example 25 | P-25 | 5B | 2H | Example 117 | P-117 | 5B | 2H |
| Example 26 | P-26 | 5B | 1H | Example 118 | P-118 | 5B | 2H |
| Example 27 | P-27 | 5B | 1H | Example 119 | P-119 | 5B | 2H |
| Example 28 | P-28 | 5B | 2H | Example 120 | P-120 | 5B | 1H |
| Example 29 | P-29 | 5B | 1H | Example 121 | P-121 | 5B | 2H |
| Example 30 | P-30 | 5B | 2H | Example 122 | P-122 | 5B | 2H |
| Example 31 | P-31 | 5B | 1H | Example 123 | P-123 | 5B | 2H |
| Example 32 | P-32 | 5B | 2H | Example 124 | P-124 | 5B | 2H |
| Example 33 | P-33 | 5B | 2H | Example 125 | P-125 | 5B | 1H |
| Example 34 | P-34 | 5B | 2H | Example 126 | P-126 | 5B | 2H |
| Example 35 | P-35 | 5B | 2H | Example 127 | P-127 | 5B | 1H |
| Example 36 | P-36 | 5B | 1H | Example 128 | P-128 | 5B | 2H |
| Example 37 | P-37 | 5B | 2H | Example 129 | P-129 | 5B | 2H |
| Example 38 | P-38 | 5B | 2H | Example 130 | P-130 | 5B | 2H |
| Example 39 | P-39 | 5B | 1H | Example 131 | P-131 | 5B | 2H |
| Example 40 | P-40 | 5B | 1H | Example 132 | P-132 | 5B | 1H |
| Example 41 | P-41 | 5B | 1H | Example 133 | P-133 | 5B | 2H |
| Example 42 | P-42 | 5B | 2H | Example 134 | P-134 | 5B | 2H |
| Example 43 | P-43 | 5B | 2H | Example 135 | P-135 | 5B | 2H |
| Example 44 | P-44 | 5B | 1H | Example 136 | P-136 | 5B | 1H |
| Example 45 | P-45 | 5B | 2H | Example 137 | P-137 | 5B | 2H |
| Example 46 | P-46 | 5B | 2H | Example 138 | P-138 | 5B | 2H |
| Example 47 | P-47 | 5B | 2H | Example 139 | P-139 | 5B | 2H |
| Example 48 | P-48 | 5B | 2H | Example 140 | P-140 | 5B | 2H |
| Example 49 | P-49 | 5B | 2H | Example 141 | P-141 | 5B | 1H |
| Example 50 | P-50 | 5B | 2H | Example 142 | P-142 | 5B | 2H |
| Example 51 | P-51 | 5B | 1H | Example 143 | P-143 | 5B | 2H |
| Example 52 | P-52 | 5B | 2H | Example 144 | P-144 | 5B | 2H |
| Example 53 | P-53 | 5B | 2H | Example 145 | P-145 | 5B | 2H |
| Example 54 | P-54 | 5B | 1H | Example 146 | P-146 | 5B | 2H |
| Example 55 | P-55 | 5B | 2H | Example 147 | P-147 | 5B | 2H |
| Example 56 | P-56 | 5B | 2H | Example 148 | P-148 | 5B | 1H |
| Example 57 | P-57 | 5B | 2H | Example 149 | P-149 | 5B | 2H |
| Example 58 | P-58 | 5B | 2H | Example 150 | P-150 | 5B | 2H |
| Example 59 | P-59 | 5B | 1H | Example 151 | P-151 | 5B | 2H |
| Example 60 | P-60 | 5B | 2H | Example 152 | P-152 | 5B | 1H |
| Example 61 | P-61 | 5B | 2H | Example 153 | P-153 | 5B | 2H |
| Example 62 | P-62 | 5B | 2H | Example 154 | P-154 | 5B | 2H |
| Example 63 | P-63 | 5B | 2H | Example 155 | P-155 | 5B | 2H |
| Example 64 | P-64 | 5B | 1H | Example 156 | P-156 | 5B | 2H |
| Example 65 | P-65 | 5B | 2H | Example 157 | P-157 | 5B | 1H |
| Example 66 | P-66 | 5B | 2H | Example 158 | P-158 | 5B | 2H |
| Example 67 | P-67 | 5B | 2H | Example 159 | P-159 | 5B | 2H |
| Example 68 | P-68 | 5B | 2H | Example 160 | P-160 | 5B | 2H |
| Example 69 | P-69 | 5B | 1H | Example 161 | P-161 | 5B | 2H |
| Example 70 | P-70 | 5B | 2H | Example 162 | P-162 | 4B | 1H |
| Example 71 | P-71 | 5B | 2H | Example 163 | P-163 | 4B | 2H |
| Example 72 | P-72 | 5B | 2H | Example 164 | P-164 | 4B | 2H |
| Example 73 | P-73 | 5B | 2H | Example 165 | P-165 | 4B | 2H |
| Example 74 | P-74 | 5B | 1H | Example 166 | P-166 | 5B | 1H |
| Example 75 | P-75 | 5B | 2H | Example 167 | P-167 | 5B | 2H |
| Example 76 | P-76 | 5B | 2H | Example 168 | P-168 | 5B | 2H |
| Example 77 | P-77 | 5B | 2H | Example 169 | P-169 | 5B | 2H |
| Example 78 | P-78 | 5B | 2H | Example 170 | P-170 | 5B | 2H |
| Example 79 | P-79 | 5B | 1H | Example 171 | P-171 | 5B | 1H |
| Example 80 | P-80 | 5B | 2H | Example 172 | P-172 | 4B | 2H |
| Example 81 | P-81 | 5B | 1H | Example 173 | P-173 | 4B | 2H |
| Example 82 | P-82 | 5B | 2H | Example 174 | P-174 | 4B | 2H |
| Example 83 | P-83 | 5B | 2H | Example 175 | P-175 | 4B | 2H |
| Example 84 | P-84 | 5B | 2H | Example 176 | P-176 | 4B | 1H |
| Example 85 | P-85 | 5B | 2H | Example 177 | P-177 | 4B | 2H |
| Example 86 | P-86 | 5B | 1H | Example 178 | P-178 | 5B | 2H |
| Example 87 | P-87 | 5B | 2H | Example 179 | P-179 | 5B | 2H |
| Example 88 | P-88 | 5B | 2H | Example 180 | P-180 | 5B | 1H |
| Example 89 | P-89 | 5B | 2H | Example 181 | P-181 | 5B | 2H |

The compositions of Examples 1 to 181 comprise all of the first monomer comprising an acrylate group, the second monomer comprising an oxygen-containing cyclic group, and the third monomer comprising an oxygen-containing cyclic group, and thus exhibit high adhesion and hardness as a protective layer.

In particular, in all Examples, the adhesion recorded 4B to 5B, which are the highest grades, and this is considered to be because the acrylate group, which is included in the first monomer, serves to significantly improve bonding strength between a panel and the protective layer.

In addition, in the Examples, the hardness was shown as 1H or 2H depending on the configuration of the composition, and this is considered to be because the second monomer and the third monomer comprising an oxygen-containing cyclic group contribute to strengthening the hardness of the composition.

In particular, in Examples such as Example 7 and Example 9, the hardness was measured as 2H, and this is considered to be because the ratio or combination of the second and third monomers in the corresponding composition was optimized to maximize the hardness improvement effect.

On the other hand, in Comparative Examples, as a specific monomer among the first monomer, the second monomer, and the third monomer was excluded, performance degradation in adhesion and hardness was markedly observed.

Comparative Example 1 did not comprise the first monomer, and the adhesion was measured as 0B, which is the lowest level. This is considered to be because the acrylate group plays a key role in forming bonding strength between the protective layer and the panel.

The acrylate group provides high adhesion and, in particular, may allow the protective layer to be stably attached to the substrate through strong intermolecular interactions. In addition, flexible characteristics of the acrylate group may increase initial adhesion of the protective layer and help maintain bonding strength even against external impact.

Comparative Example 2 did not comprise the second monomer comprising an oxygen-containing cyclic group, specifically an epoxy group, and the hardness was lowered to HB compared to the Examples. This is considered to be because the epoxy group plays a major role in strengthening the strength of the protective layer and providing resistance to external impact by forming a high crosslinking density. In the absence of the epoxy group, molecular bonding inside the protective layer may be weakened, making it vulnerable to physical damage.

Comparative Example 3 did not comprise the third monomer comprising an oxygen-containing cyclic group, specifically an oxetane group, and the hardness was measured as B, which is a low level compared to the Examples. This is considered to be because oxetane group plays an important role in forming a polymer network through a rapid polymerization reaction and improving surface hardness and durability of the protective layer based on a low shrinkage rate and high reactivity. In the absence of the oxetane group, it may become difficult to form a uniform structure of the protective layer, and thus hardness and durability may be significantly degraded.

In addition, it is considered that durability against external impact and scratches could be strengthened because a high crosslinking density and a uniform polymer network were formed by interaction between the epoxy group and the oxetane group among oxygen-containing cyclic groups.

The reason why high adhesion and hardness were exhibited in the Examples compared to the Comparative Examples is that the acrylate group and the oxygen-containing cyclic groups contributed to adhesion and hardness, respectively, and acted complementarily, and it is considered that performance degradation occurred in the Comparative Examples as one of these monomers was excluded.

As shown in the experimental results of the Examples, the embodiments of the present disclosure may simultaneously improve adhesion and hardness of a protective layer comprising a composition by providing the composition comprising the first monomer, the second monomer, and the third monomer.

The present disclosure is not limited to the embodiments, but may be manufactured in various different forms.

The above description is merely an illustrative explanation of the present disclosure, and those skilled in the art to which the present disclosure pertains will be able to make various modifications without departing from the essential characteristics of the present disclosure.

Therefore, the embodiments disclosed in the present disclosure are for illustrative purposes rather than limiting the present disclosure, and the spirit and scope of the present disclosure are not limited by these embodiments. The scope of protection of the present disclosure should be interpreted by the claims, and all technologies within the equivalent scope thereof should be interpreted as being included in the scope of rights of the present disclosure.

## Claims

1. A composition comprising:
a colorant;
a first monomer comprising an acrylate group;
a second monomer comprising an oxygen-containing cyclic group; and
a third monomer comprising an oxygen-containing cyclic group.

2. The composition of claim 1,
wherein the second monomer comprises an epoxy group, and the third monomer comprises an oxetane group.

3. The composition of claim 1,
wherein the first monomer is a compound represented by Formula 1 below: 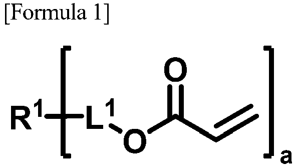
wherein in Formula 1,
R¹ is selected from the group consisting of hydrogen; deuterium; a C₁-C₃₀ alkyl group; a C₂-C₃₀ alkenyl group; a C₂-C₃₀ alkynyl group; a C₃-C₃₀ cycloalkyl group; a C₁-C₃₀ ether group; a C₁-C₃₀ ketone group; a C₁-C₃₀ ester group; a C₁-C₃₀ alkoxy group; a C₆-C₃₀ aryl group; a C₂-C₃₀ heterocyclic group comprising at least one heteroatom selected from the group consisting of oxygen (O), nitrogen (N), sulfur (S), silicon (Si), and phosphorus (P); a C₆-C₃₀ aryloxy group; a hydroxy group; and combinations thereof,
L¹ is selected from the group consisting of a single bond; a C₁-C₃₀ alkylene group; a C₂-C₃₀ alkenylene group; a C₂-C₃₀ alkynylene group; a C₃-C₃₀ cycloalkylene group; a C₁-C₃₀ ether group; a C₁-C₃₀ ketone group; a C₁-C₃₀ ester group; a C₁-C₃₀ alkoxylene group; a C₆-C₃₀ arylene group; a C₂-C₃₀ heterocyclic group comprising at least one heteroatom selected from the group consisting of O, N, S, Si, and P; a C₆-C₃₀ aryloxy group; and combinations thereof,
in R¹ and L¹ of Formula 1, the alkyl group; alkenyl group; alkynyl group; cycloalkyl group; ether group; ketone group; ester group; alkoxy group; aryl group; heterocyclic group; and aryloxy group may each independently be further substituted with one or more substituents selected from the group consisting of deuterium, a halogen group, a hydroxy group, a nitrile group, a nitro group, a carbonyl group, an ether group, an ester group, a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group comprising at least one heteroatom selected from the group consisting of O, N, S, Si, and P, and
a is an integer from 1 to 4.

4. The composition of claim 1,
wherein the first monomer is at least one of compounds represented by Formulas P-1-1 to P-1-36 below:

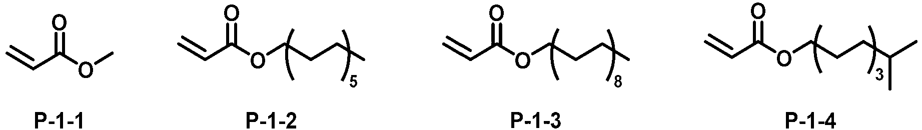

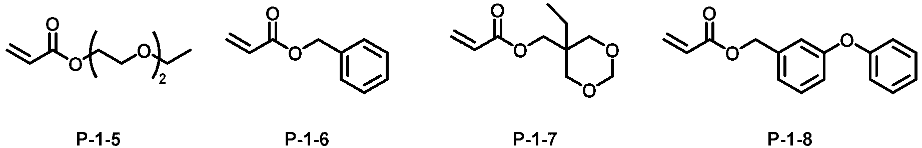

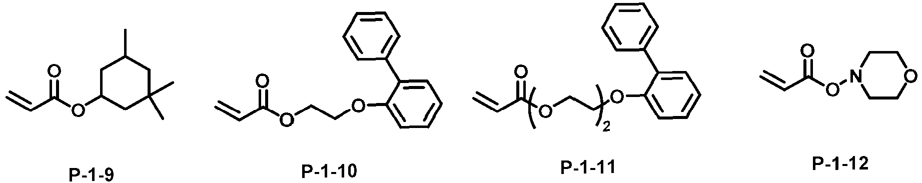

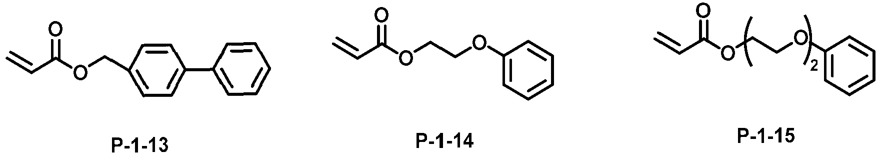

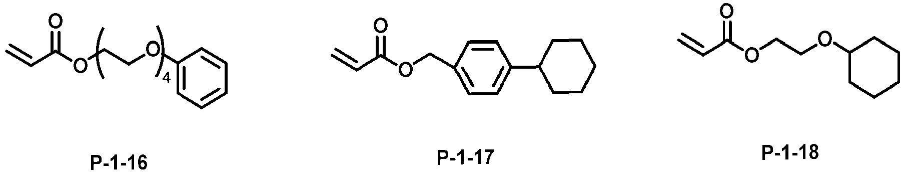

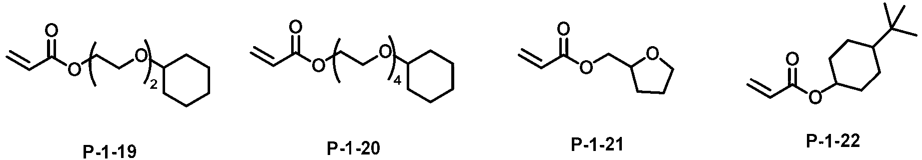

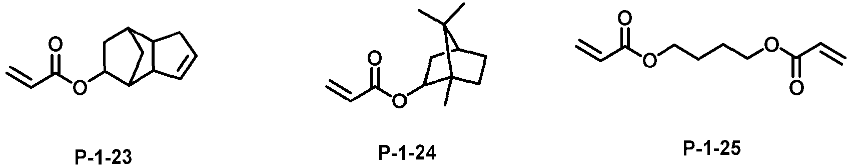

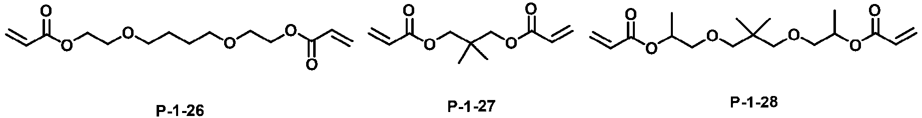

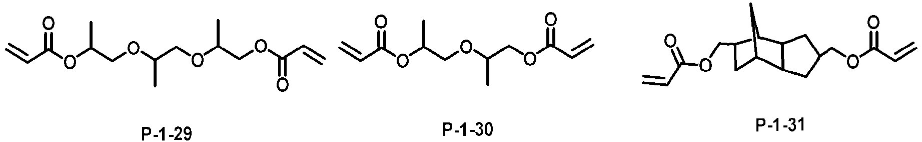

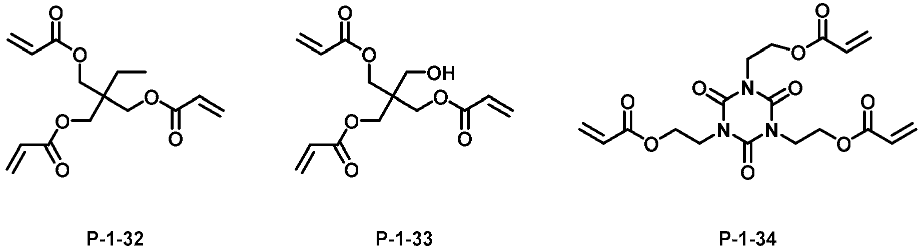

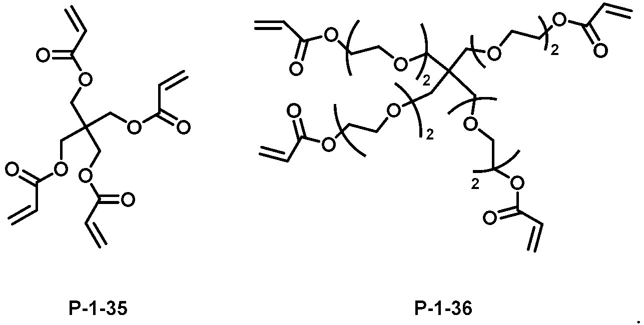

5. The composition of claim 1,
wherein the second monomer is a compound represented by Formula 2 below: 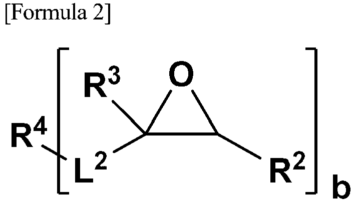
wherein in Formula 2,
R² and R³ are each independently selected from the group consisting of hydrogen; deuterium; a C₁-C₃₀ carbonyl group; a C₁-C₃₀ ether group; a C₁-C₃₀ ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₁-C₃₀ alkylamine group; a C₆-C₃₀ aryl group; a C₂-C₃₀ heterocyclic group comprising at least one heteroatom selected from the group consisting of oxygen (O), nitrogen (N), sulfur (S), silicon (Si), and phosphorus (P); a C₆-C₃₀ aryloxy group; a C₆-C₃₀ arylamine group; a hydroxy group; and combinations thereof,
R⁴ is selected from the group consisting of hydrogen; deuterium; a C₁-C₃₀ carbonyl group; a C₁-C₃₀ ether group; a C₁-C₃₀ ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₁-C₃₀ alkylamine group; a C₆-C₃₀ aryl group; a C₂-C₃₀ heterocyclic group comprising at least one heteroatom selected from the group consisting of O, N, S, Si, and P; a C₆-C₃₀ aryloxy group; a C₆-C₃₀ arylamine group; a hydroxy group; and combinations thereof,
L² is selected from the group consisting of a single bond; a C₁-C₃₀ carbonyl group; a C₁-C₃₀ ether group; a C₁-C₃₀ ester group; a C₁-C₃₀ alkylene group; a C₂-C₃₀ alkenylene group; a C₂-C₃₀ alkynylene group; a C₃-C₃₀ cycloalkylene group; a C₃-C₃₀ cycloalkenylene group; a C₁-C₃₀ alkoxylene group; a C₁-C₃₀ alkylamine group; a C₆-C₃₀ arylene group; a C₂-C₃₀ heterocyclic group comprising at least one heteroatom selected from the group consisting of O, N, S, Si, and P; a C₆-C₃₀ aryloxy group; a C₆-C₃₀ arylamine group; and combinations thereof,
atoms constituting R² and L² may be bonded to each other to form a ring,
in R² to R⁴ and L², the alkyl group, alkenyl group, alkynyl group, cycloalkyl group, alkoxy group, alkylamine group, aryl group, heterocyclic group, aryloxy group, arylamine group, alkylene group, alkenylene group, alkynylene group, cycloalkylene group, cycloalkenylene group, alkoxylene group, and arylene group may each independently be further substituted with one or more substituents selected from the group consisting of deuterium, a halogen group, a hydroxy group, a nitrile group, a nitro group, a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group, and the substituted substituent may be further substituted with one or more substituents selected from the substituents, and
b is an integer from 1 to 4.

6. The composition of claim 1,
wherein the second monomer is at least one of compounds represented by Formulas P-2-1 to P-2-140 below:

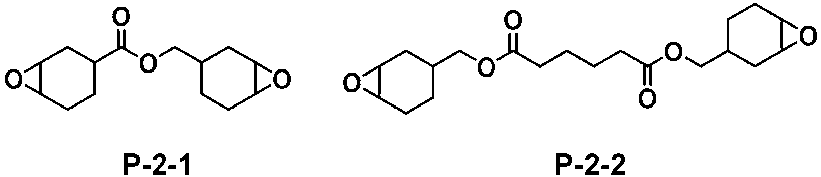

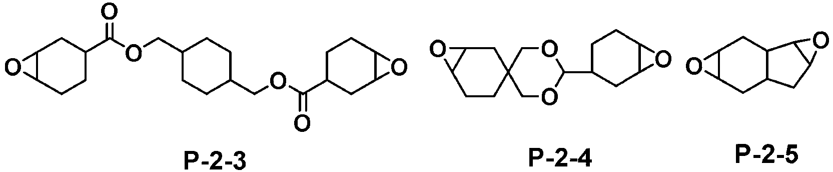

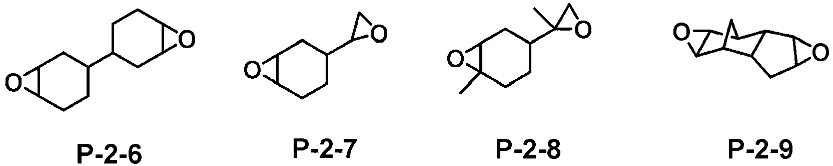

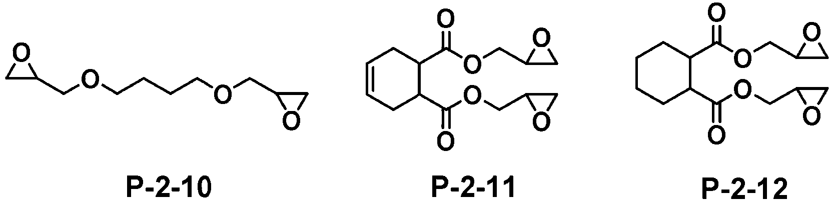

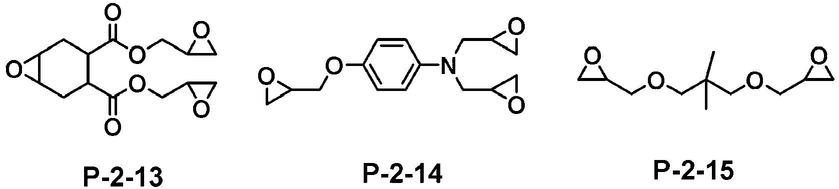

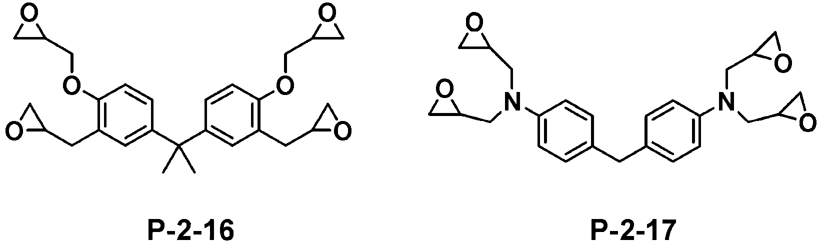

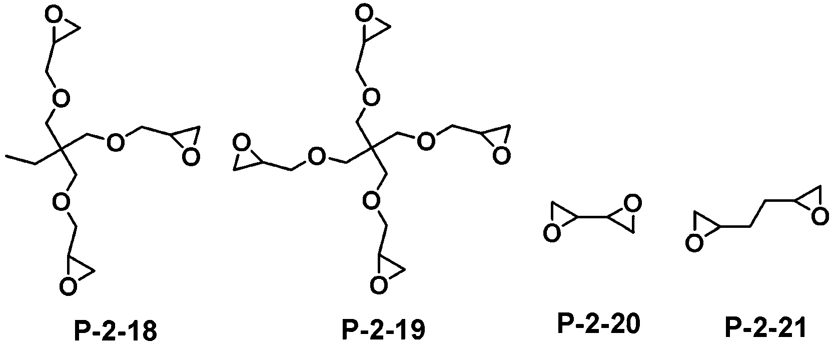

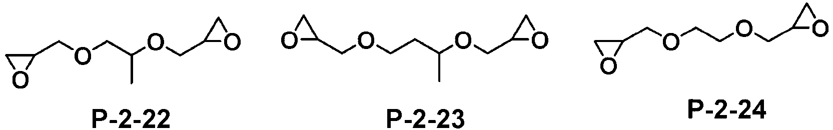

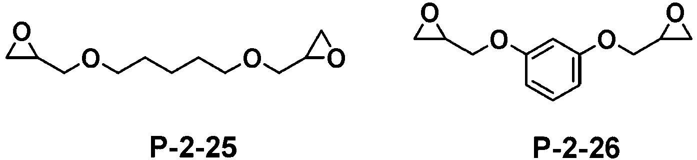

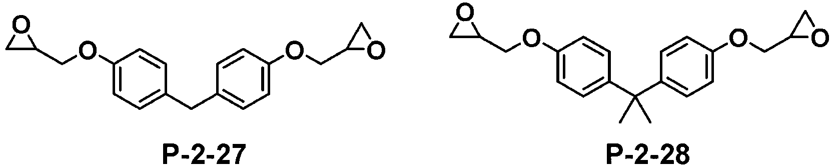

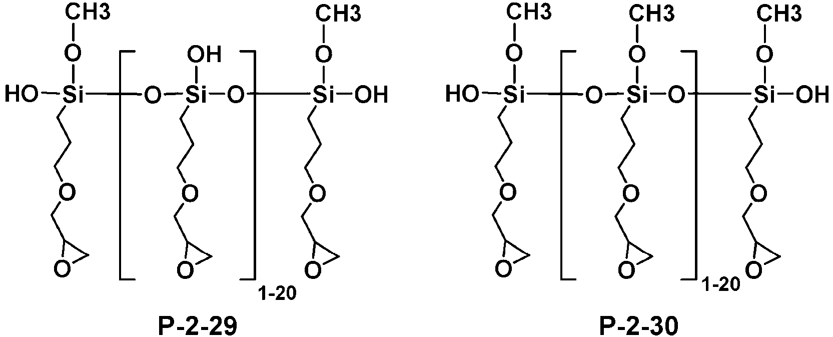

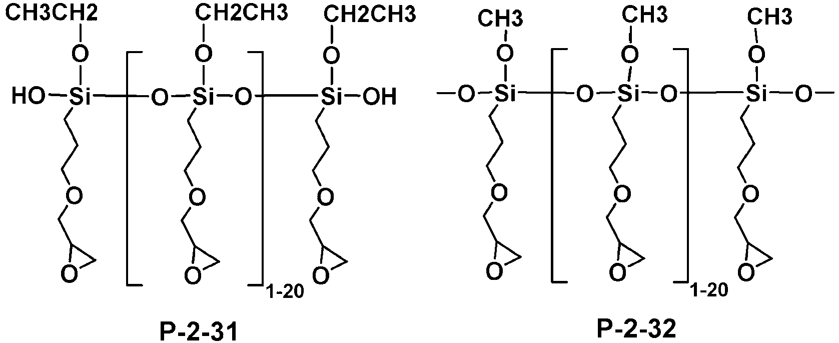

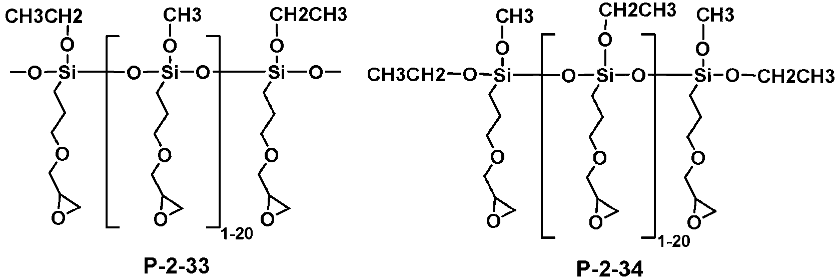

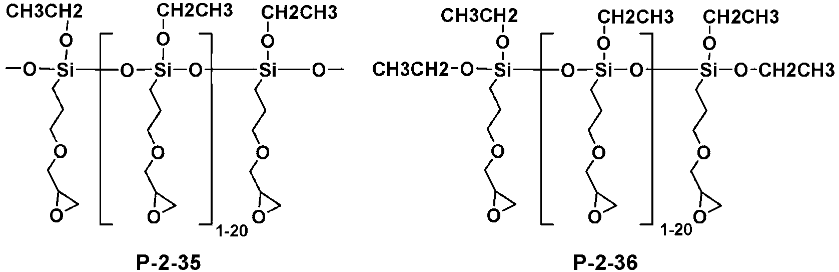

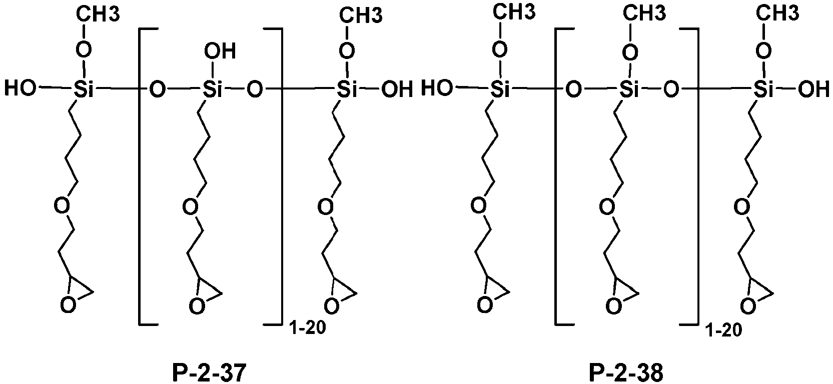

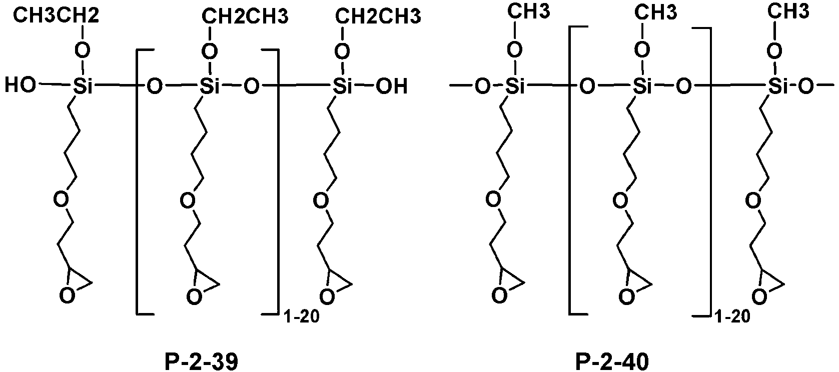

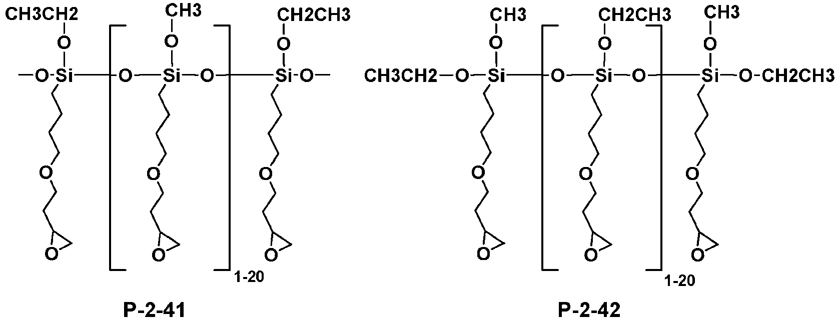

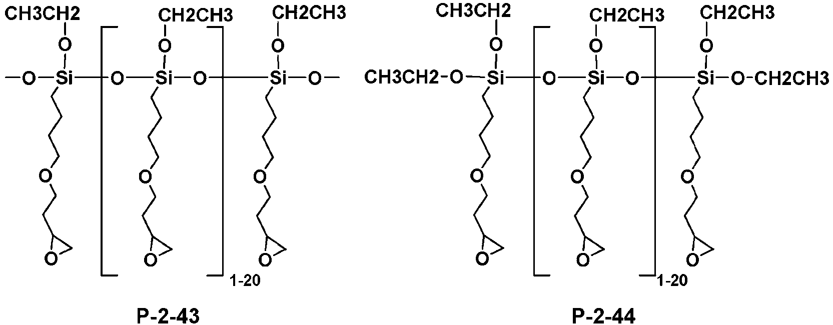

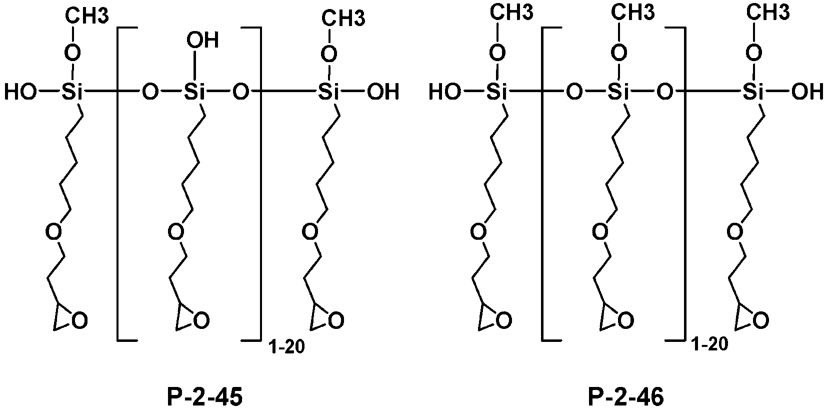

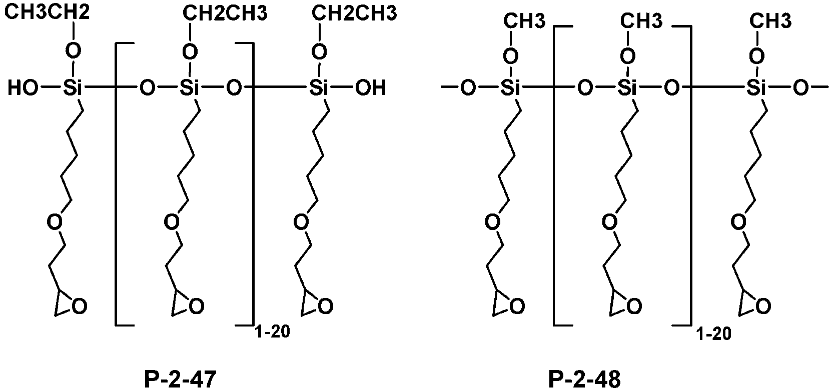

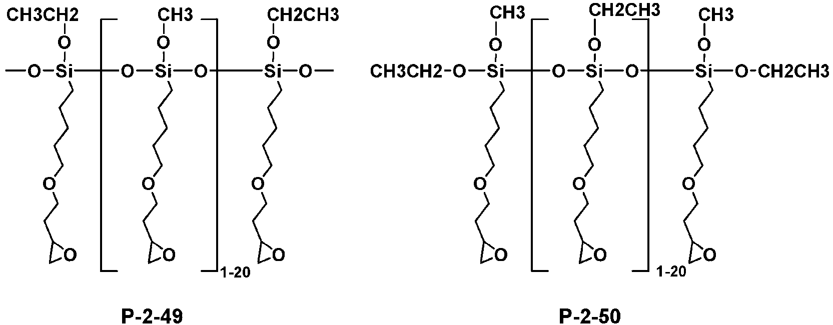

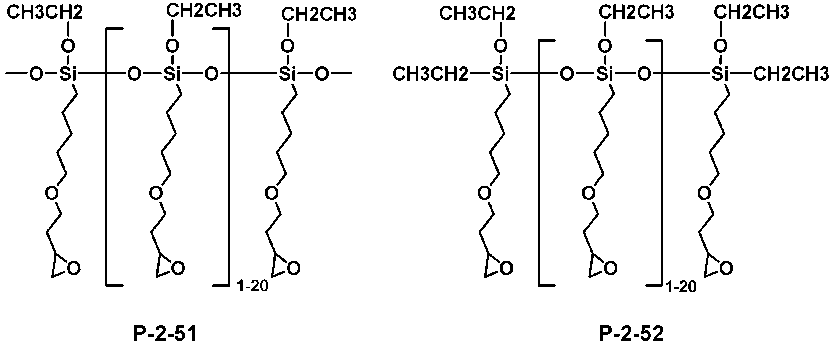

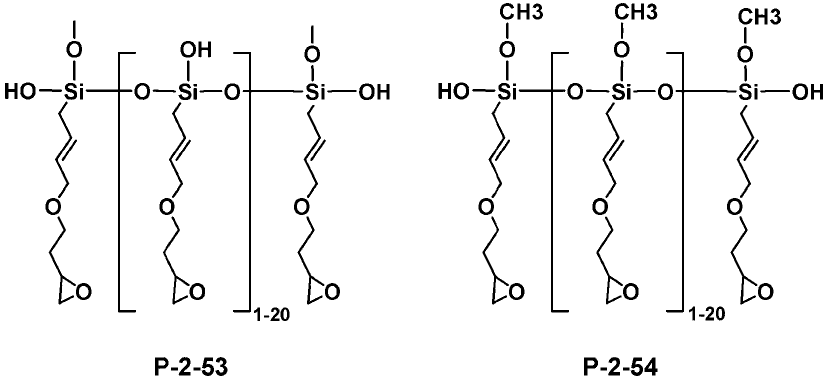

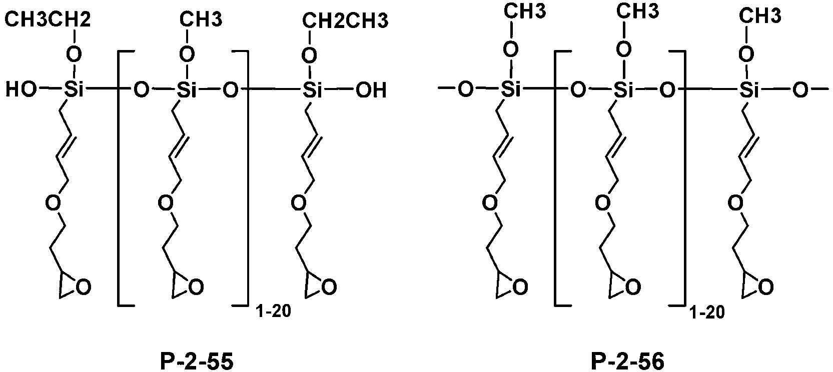

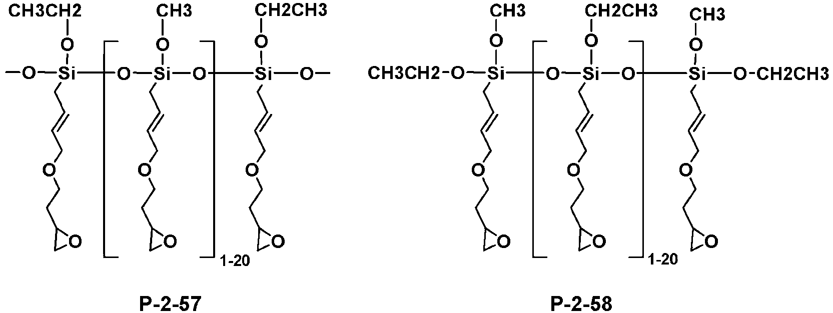

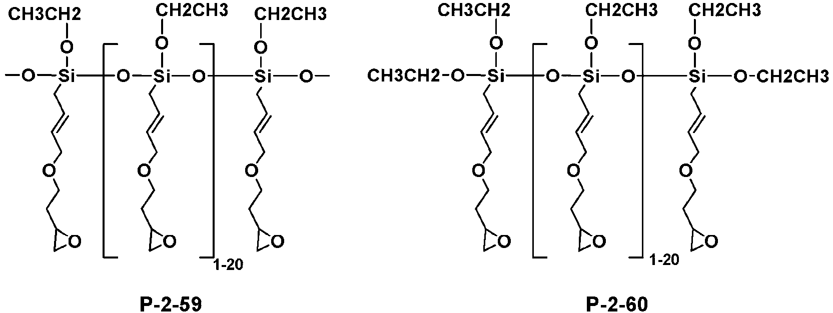

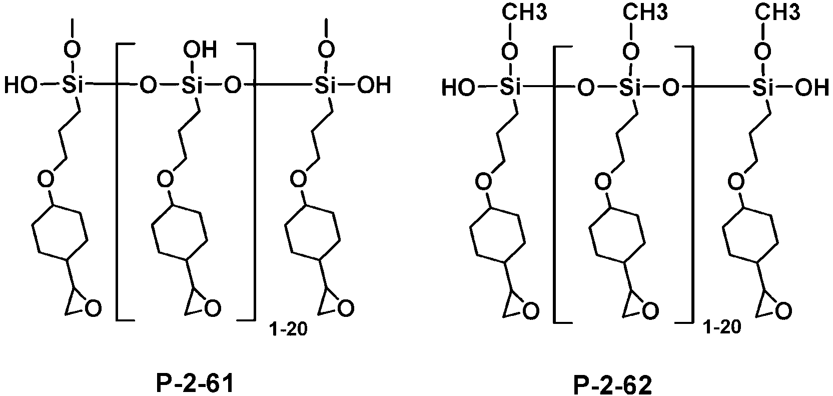

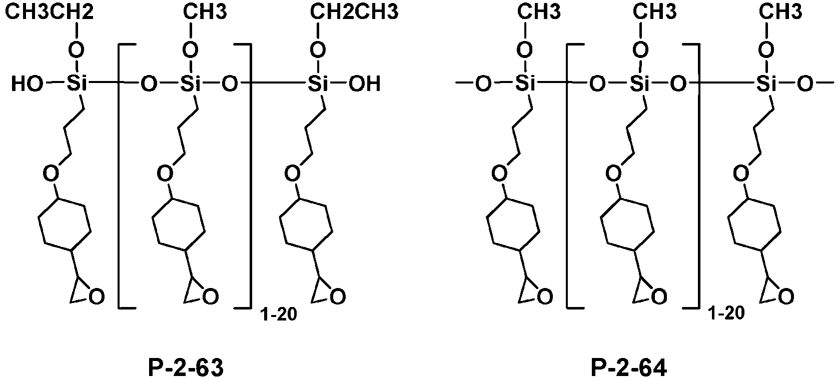

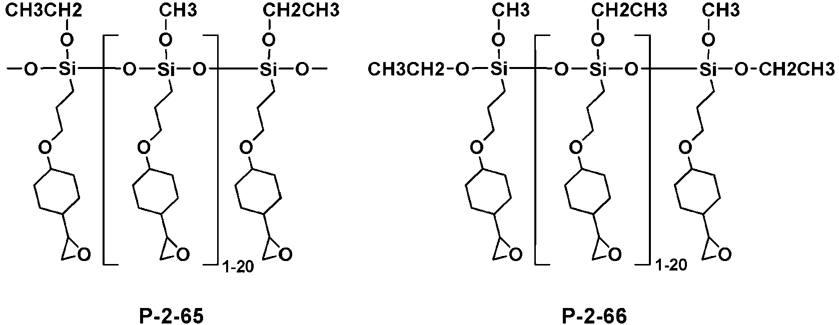

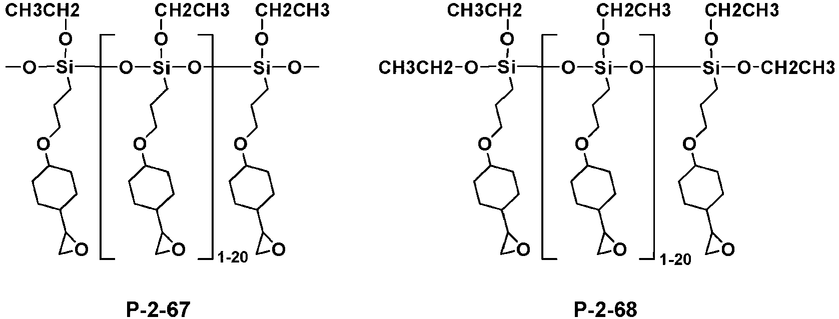

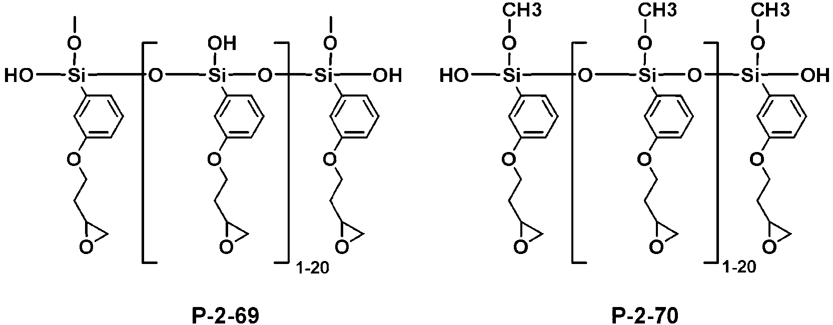

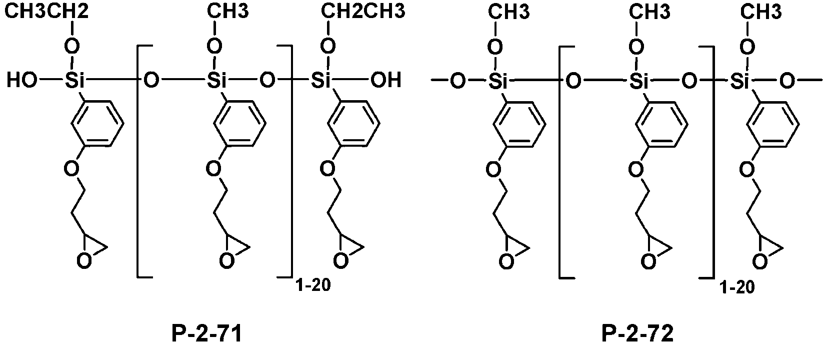

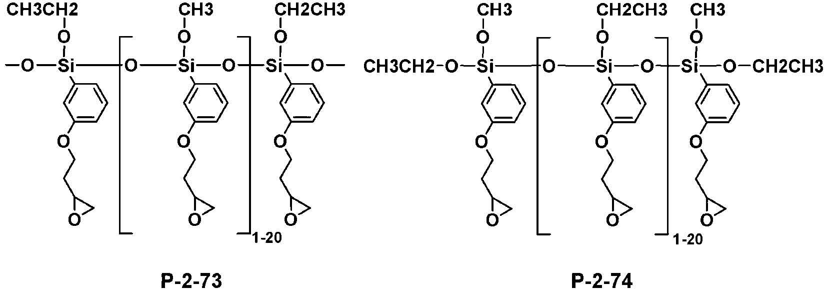

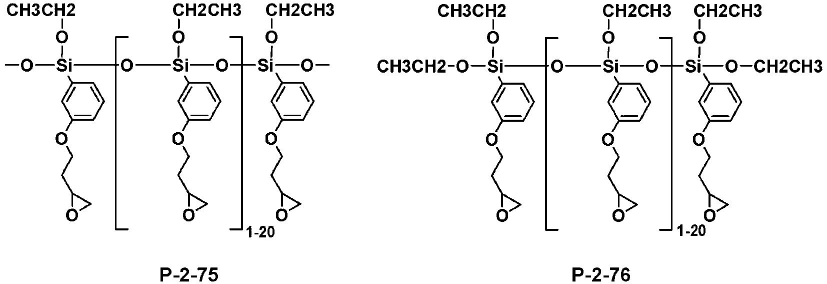

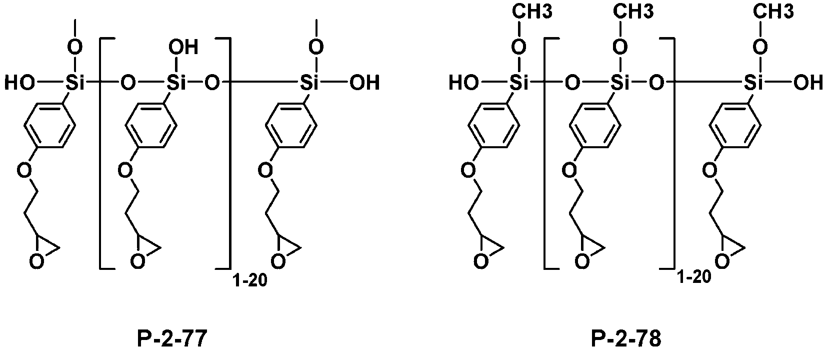

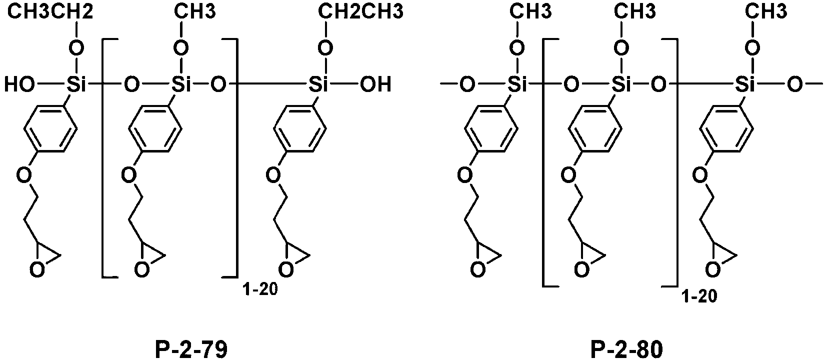

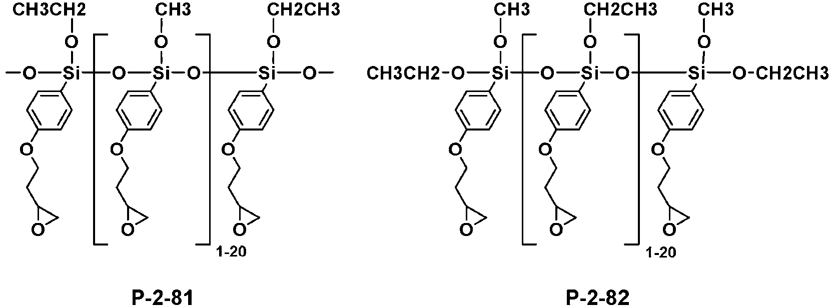

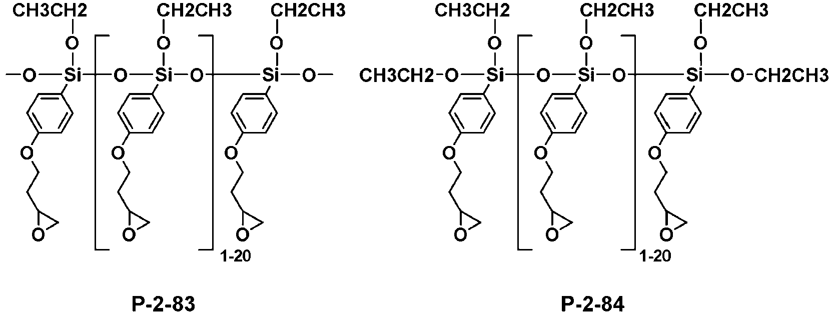

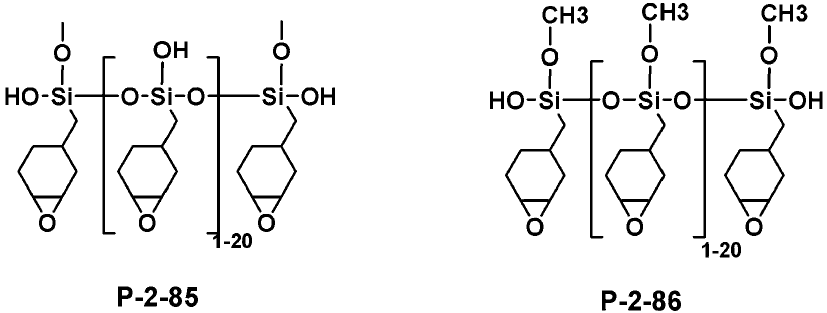

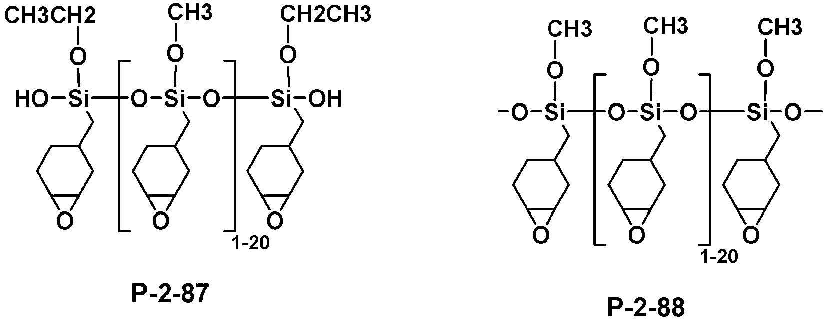

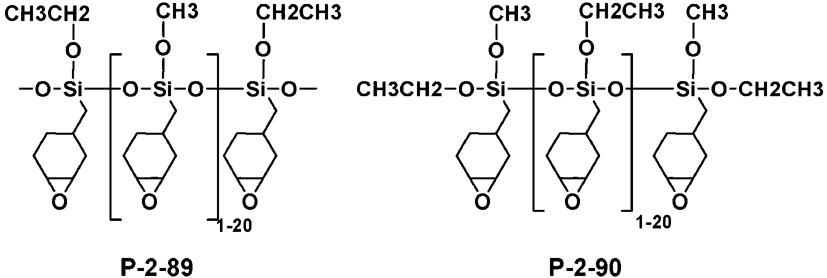

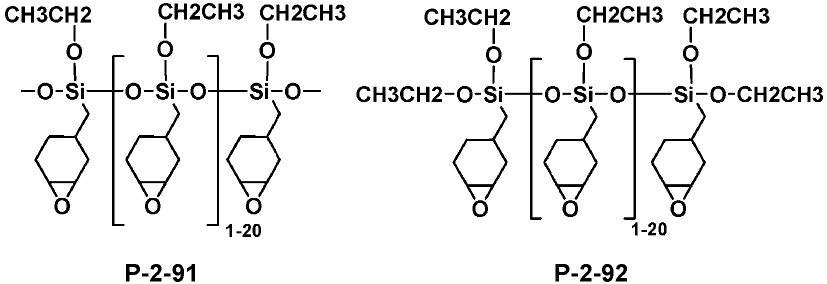

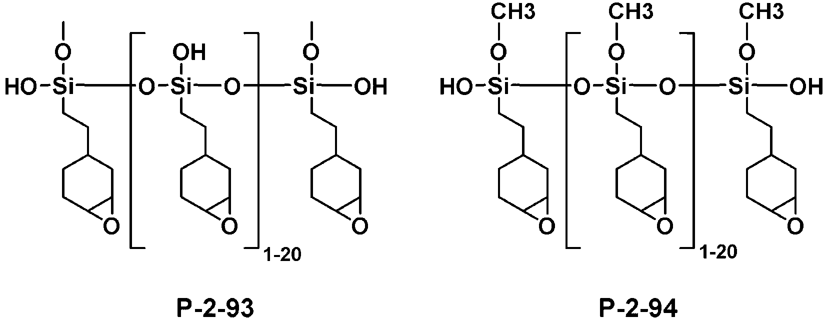

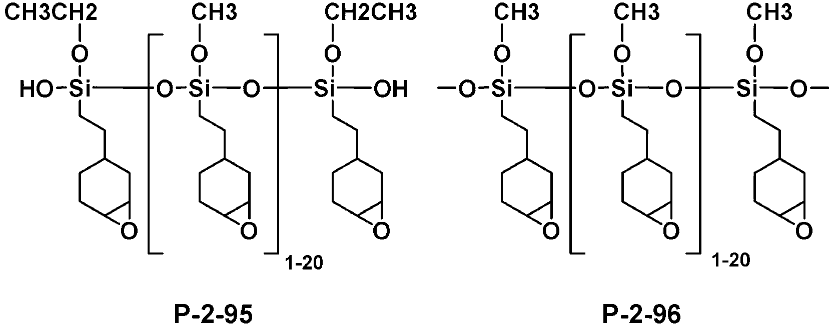

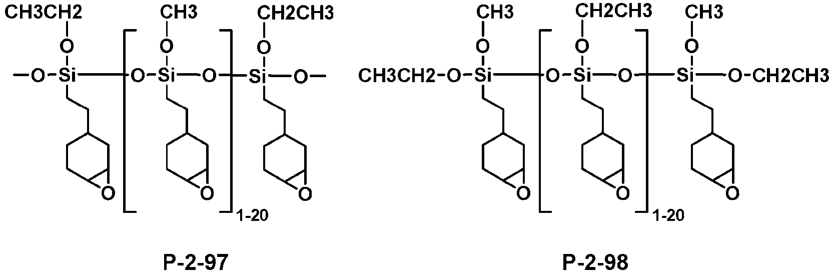

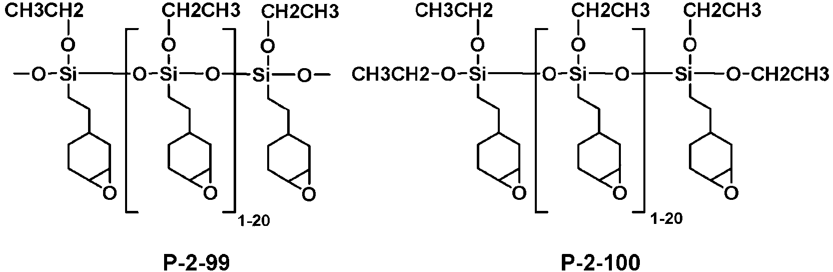

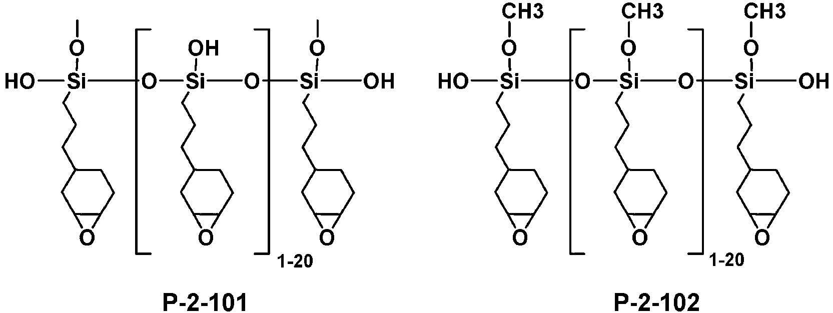

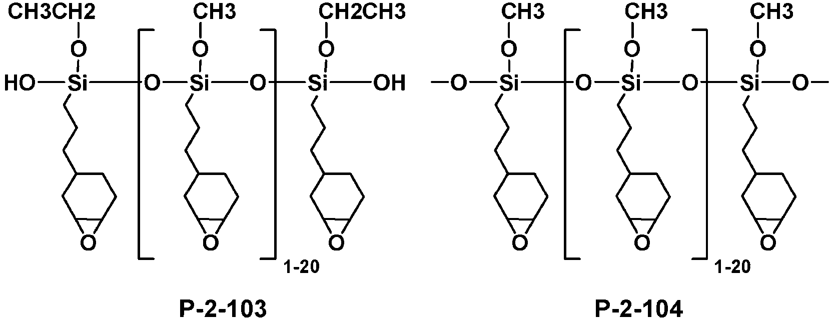

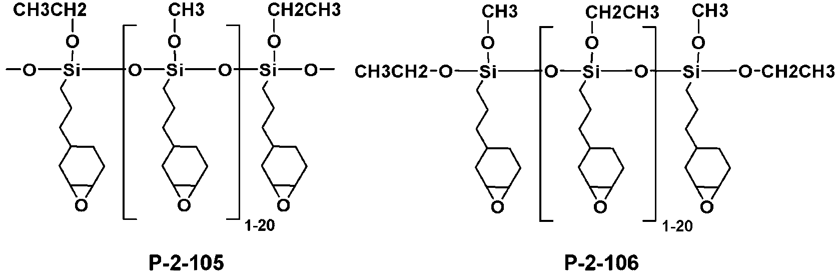

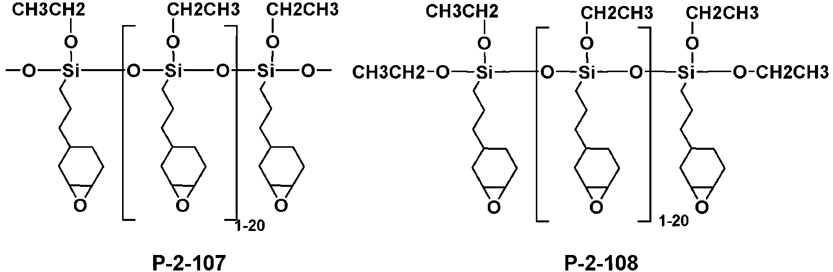

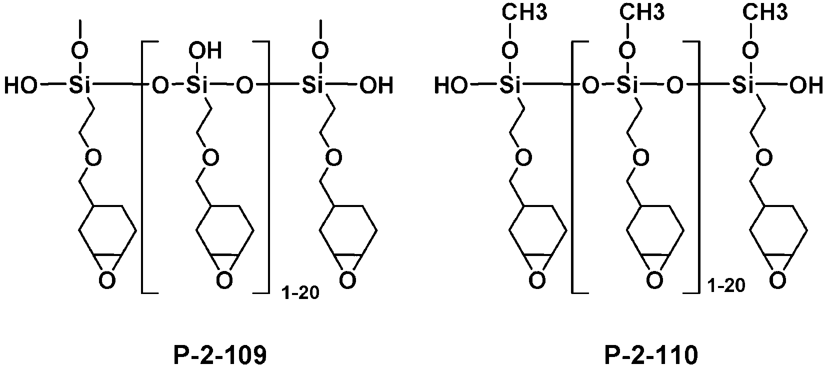

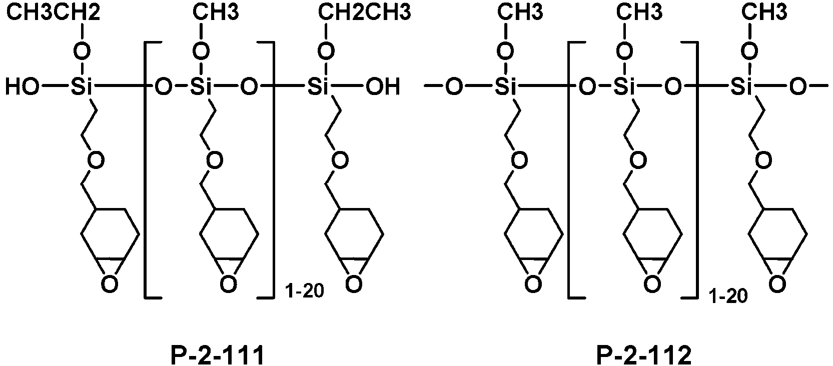

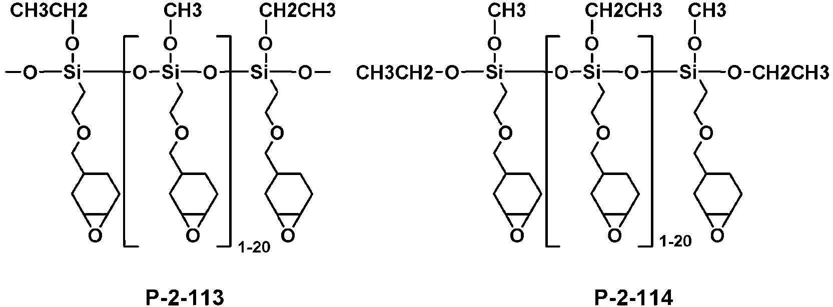

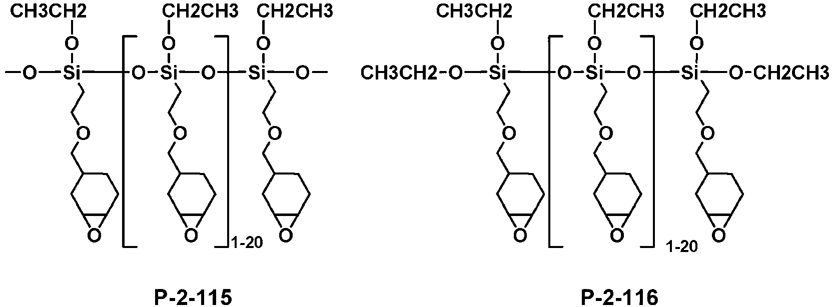

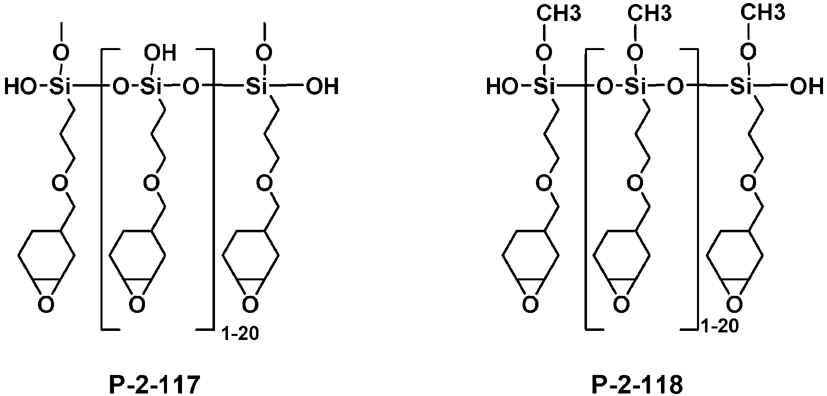

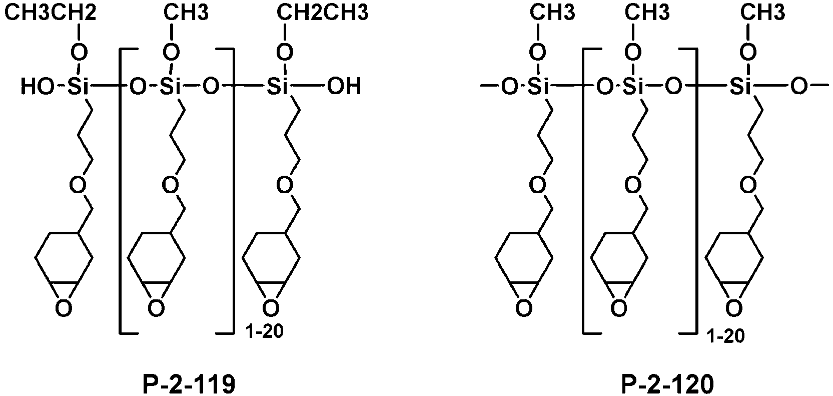

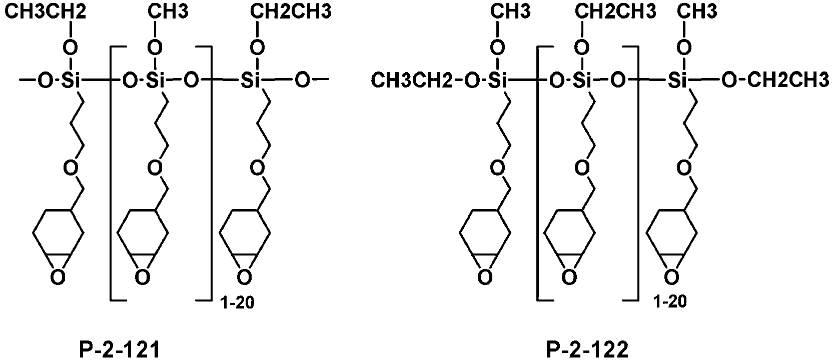

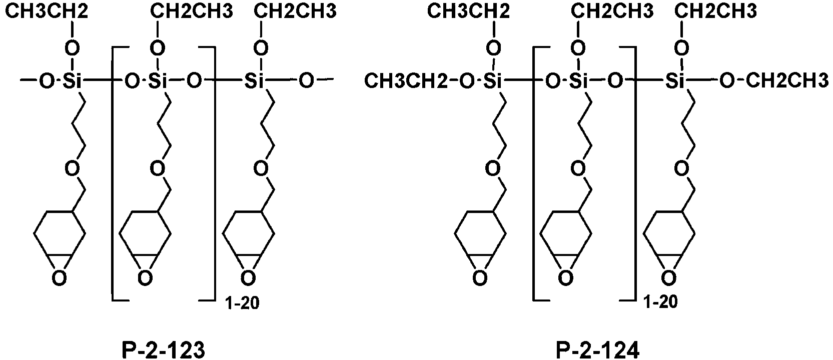

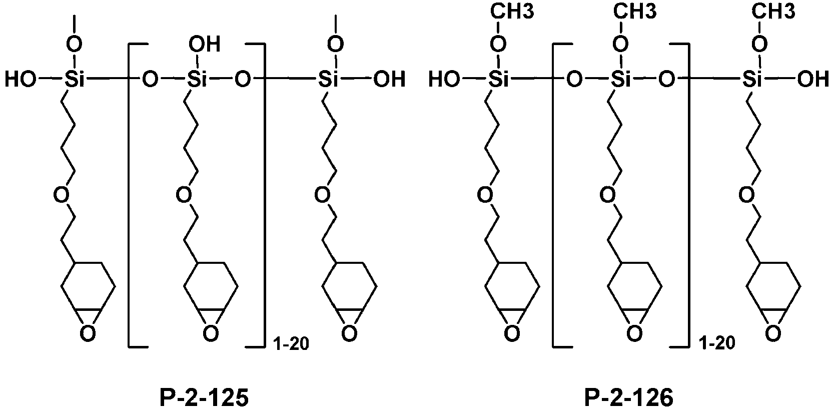

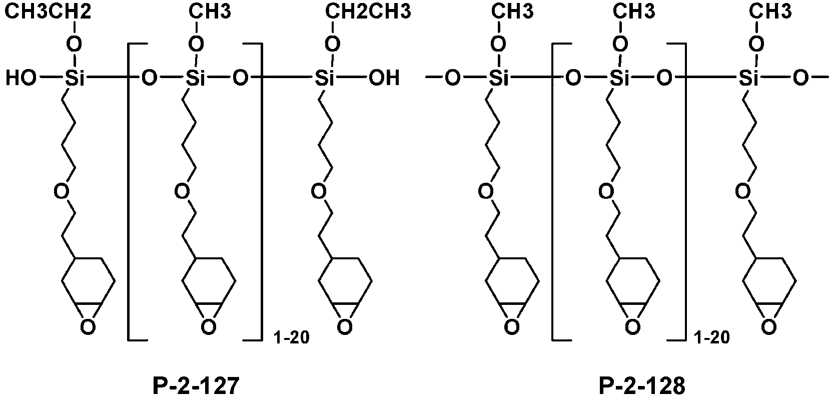

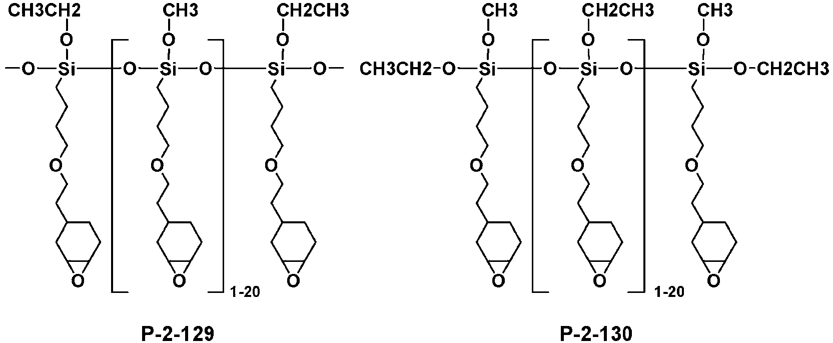

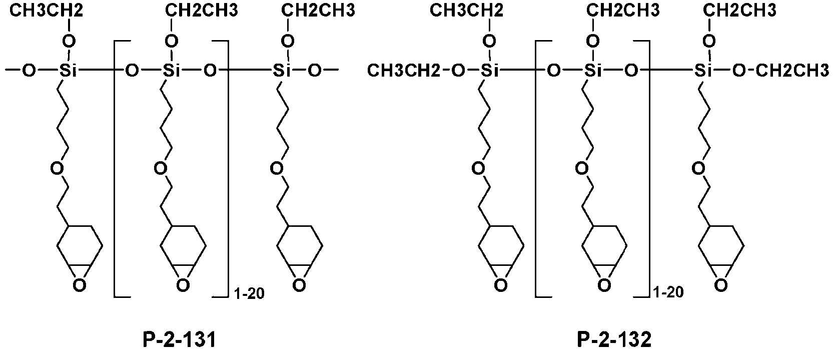

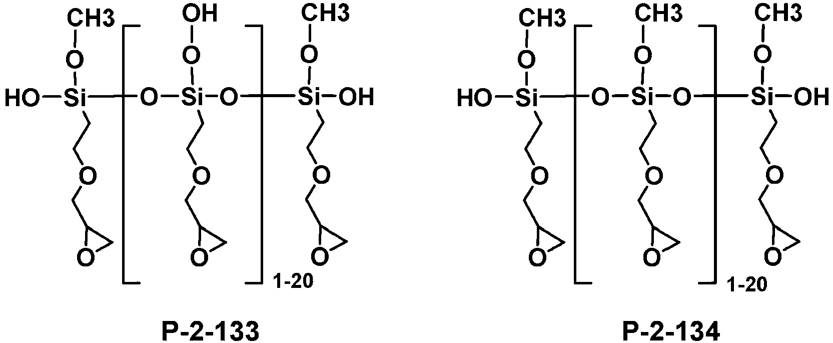

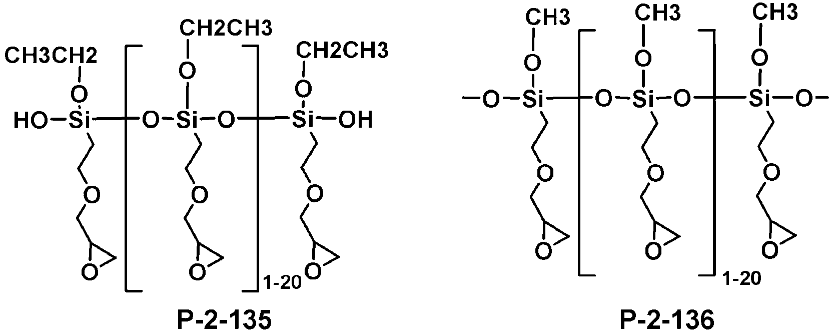

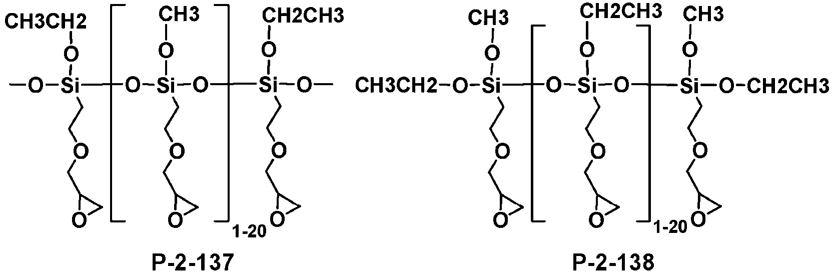

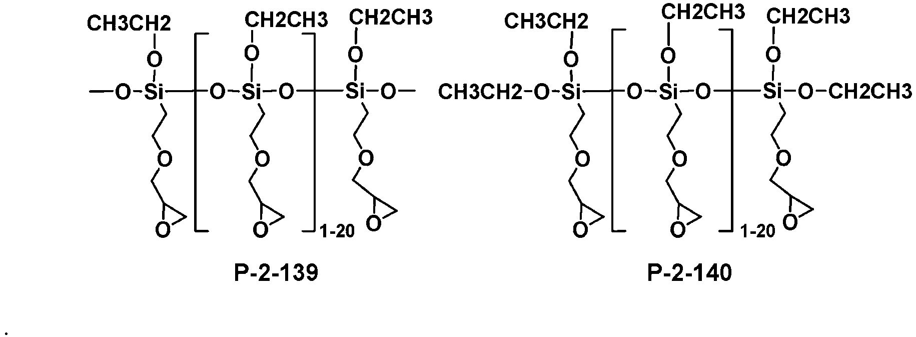

7. The composition of claim 1,
wherein the third monomer is a compound represented by Formula 3 below: 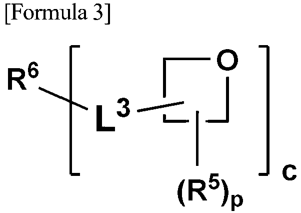
wherein in Formula 3,
R⁵ and R⁶ are each independently selected from the group consisting of hydrogen; deuterium; a nitrile group; a C₁-C₃₀ carbonyl group; a C₁-C₃₀ ether group; a C₁-C₃₀ ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₆-C₃₀ aryl group; a C₂-C₃₀ heterocyclic group comprising at least one heteroatom selected from the group consisting of oxygen (O), nitrogen (N), sulfur (S), silicon (Si), and phosphorus (P); a C₆-C₃₀ aryloxy group; a C₁-C₃₀ alkylamine group; a C₁-C₃₀ arylamine group; a hydroxy group; a C₁-C₃₀ acrylate group; -N(R')(R"); and combinations thereof,
L³ is selected from the group consisting of a single bond; a C₁-C₃₀ carbonyl group; a C₁-C₃₀ ether group; a C₁-C₃₀ ester group; a C₁-C₃₀ alkylene group; a C₂-C₃₀ alkenylene group; a C₂-C₃₀ alkynylene group; a C₃-C₃₀ cycloalkylene group; a C₃-C₃₀ cycloalkenylene group; a C₁-C₃₀ alkoxylene group; a C₁-C₃₀ amine group; a C₆-C₃₀ arylene group; a C₂-C₃₀ heterocyclic group comprising at least one heteroatom selected from the group consisting of O, N, S, Si, and P; a C₆-C₃₀ aryloxy group; a C₆-C₃₀ arylamine group; and combinations thereof,
R' and R" are each independently selected from the group consisting of hydrogen; deuterium; a hydroxy group; an acrylate group; a carbonyl group; an ether group; an ester group; a C₁-C₃₀ alkyl group; a C₂-C₃₀ alkenyl group; a C₂-C₃₀ alkynyl group; a C₃-C₃₀ cycloalkyl group; a C₁-C₃₀ alkoxy group; a C₁-C₃₀ alkylamine group; a C₆-C₃₀ aryl group; a C₂-C₃₀ heterocyclic group comprising at least one heteroatom selected from the group consisting of O, N, S, Si, and P; a C₆-C₃₀ aryloxy group; a C₆-C₃₀ arylamine group; and combinations thereof,
in R⁵, R⁶, R', R", and L³, the alkyl group, alkenyl group, alkynyl group, cycloalkyl group, alkoxy group, alkylamine group, aryl group, heterocyclic group, aryloxy group, arylamine group, alkylene group, alkenylene group, alkynylene group, cycloalkylene group, cycloalkenylene group, alkoxylene group, and arylene group may each independently be substituted with one or more substituents selected from the group consisting of deuterium, a halogen group, a hydroxy group, a nitrile group, a nitro group, a C₁-C₃₀ alkyl group, a C₁-C₃₀ alkoxy group, a C₁-C₃₀ alkylamine group, a C₁-C₃₀ alkylsilyl group, a C₁-C₃₀ alkylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryloxy group, a C₆-C₃₀ arylamine group, -N(R')(R") (where R' and R" are as defined above), a C₆-C₃₀ arylsilyl group, a C₆-C₃₀ arylthiophene group, a C₆-C₃₀ aryl group substituted with deuterium, a C₇-C₃₀ arylalkyl group, a C₈-C₃₀ arylalkenyl group, a silane group, a siloxane group, a boron group, a thiol group, a germanium group, and a C₂-C₃₀ heterocyclic group, and the substituted substituent may be further substituted with one or more substituents selected from the substituents,
c is an integer from 1 to 4,
p is an integer from 0 to 5, and
when p is 2 or more, each R⁵ may be the same as or different from the others.

8. The composition of claim 7,
wherein the third monomer is a compound represented by any one of Formula 3-1 and Formula 3-2 below: 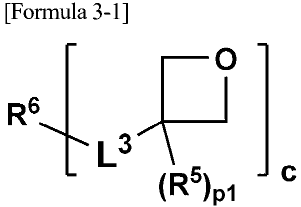 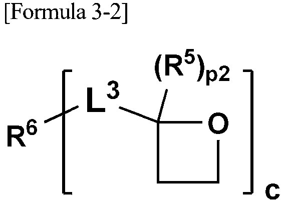
wherein in Formula 3-1 and Formula 3-2, c, R⁵, R⁶, and L³ are as defined in Formula 3, and
p1 and p2 are each independently of 0 or 1.

9. The composition of claim 1,
wherein the third monomer is at least one of compounds represented by Formulas P-3-1 to P-3-68 below:

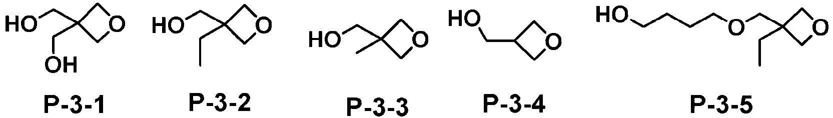

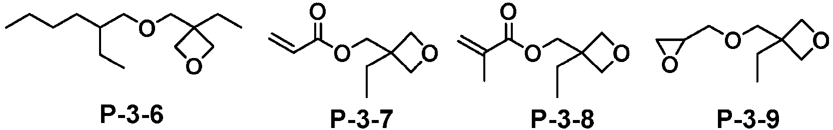

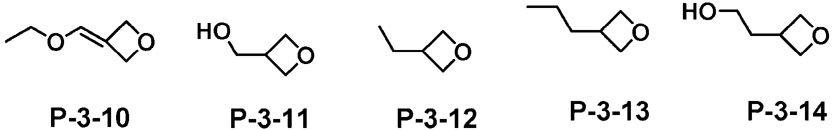

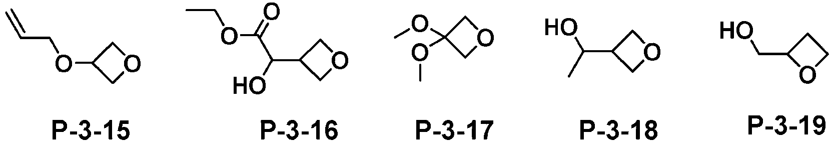

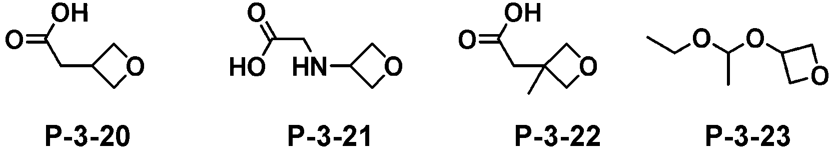

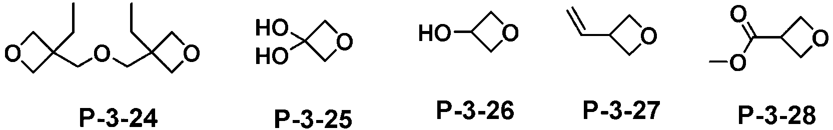

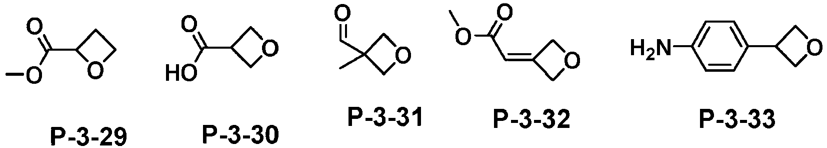

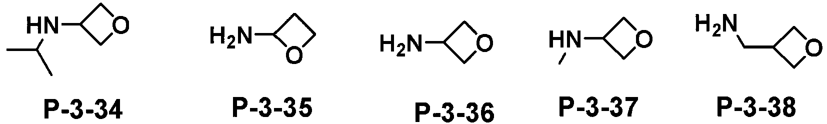

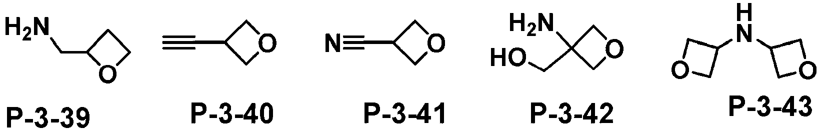

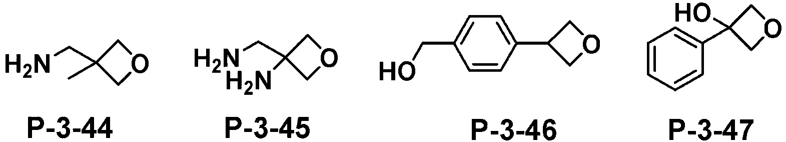

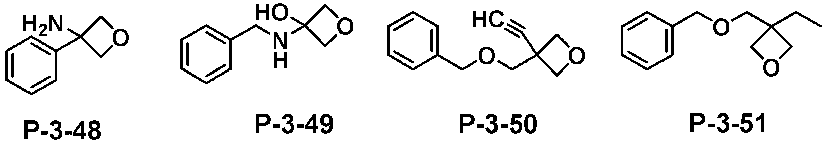

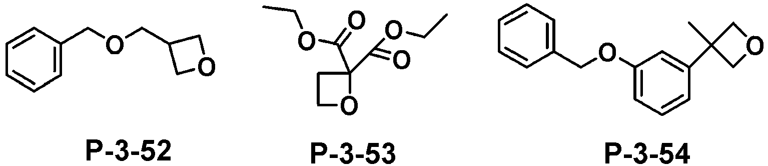

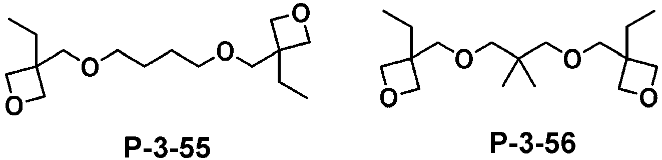

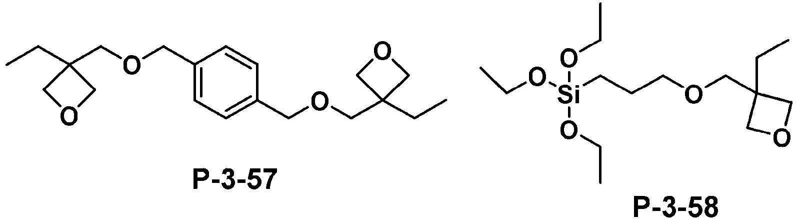

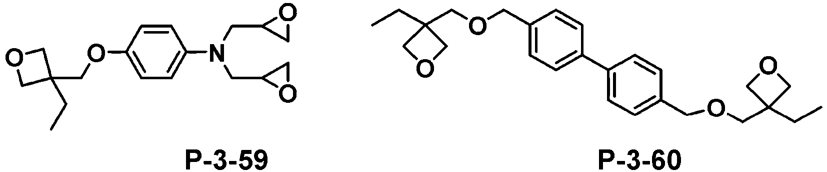

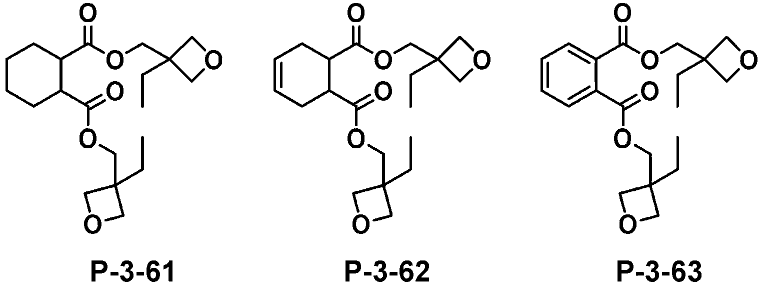

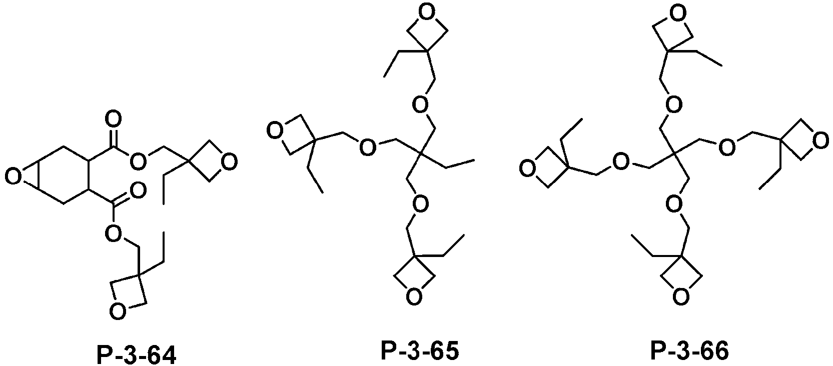

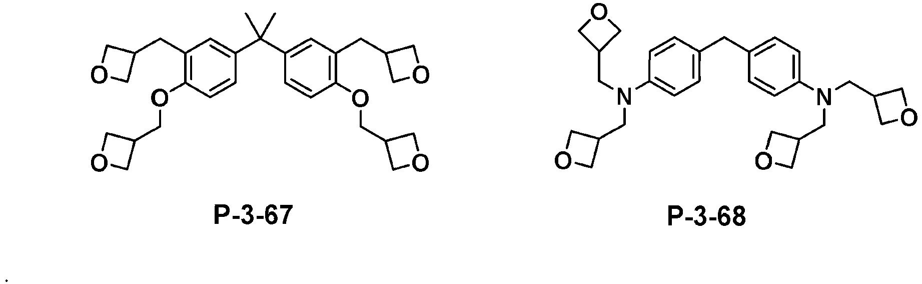

10. The composition of claim 1, wherein the colorant comprises a black pigment.

11. The composition of claim 1, further comprising an initiator.

12. The composition of claim 11, wherein the initiator is selected from the group consisting of a radical initiator; a cationic initiator; and combinations thereof.

13. A protective layer comprising the composition of claim 1.

14. A display device comprising:
a substrate;
a pixel array layer on the substrate; and
a protective layer disposed under the substrate, the protective layer comprising the composition of claim 1.

15. The display device of claim 14, wherein the protective layer is disposed to contact the substrate.
